# EUROPEAN PATENT APPLICATION

(11) **EP 4 704 539 A1**
(43) Date of publication of application: **04.03.2026**
(21) Application number: 24196557.3
(22) Date of filing: 27.08.2024
(51) Int. Cl.: H10N 10/17, H10N 10/817, H10N 10/01

(54) **THERMOELECTRIC ELEMENTS, THERMOELECTRIC MODULES, AND METHODS FOR MANUFACTURING THEREOF**

(71) Applicant: Iosad, Nikolay, 65232 Taunusstein (DE)
(72) Inventor: Iosad, Nikolay, 65232 Taunusstein (DE)

(57) **Abstract**

A thermoelectric element, comprising: a first metal foil electrode and a second metal foil electrode separated by a first gap constituted by facing each other first sidewalls of the first and second metal foil electrodes; and a first thermoelectric film, wherein the first thermoelectric film has a first interface with a first side of the first metal foil electrode and a second interface with a first side of the second metal foil electrode and/or a third interface with the first sidewall of the first metal foil electrode and a fourth interface with the first sidewall of the second metal foil electrode, wherein the first and the second interfaces are planar interfaces disposed in a first flat plane.

## Description

### Field of invention

The present invention refers to thermoelectric elements and methods of their manufacturing. These elements employ single layers of thermoelectric materials, p-n junctions, or p-i-n junctions. The invention further refers to thermoelectric modules employing the thermoelectric elements and methods of manufacturing such thermoelectric modules. The thermoelectric elements and modules can be used for generating electricity or for heat transfer.

### Background

The thermoelectric effect was already discovered and described by Peltier and Seebeck in the 19^{th} century. It was found that a relationship exists between the heat currents and electrical currents flowing through combinations of different metals, alloys or semiconductors (also referred to hereinafter as "thermoelectric materials"). On the one hand, a heat flow can create an electrical potential between the hotter and colder end of the thermoelectric material, and this can be exploited in the form of a current flow through a closed electrical circuit (Seebeck effect, thermoelectric generator). On the other hand, the application of an electrical potential to such material leads not only to a current flow but also to a heat flow, i.e. one electrical contact face becomes hotter and the other becomes cooler (Peltier effect, Peltier cooler).

Thermoelectric elements employ as usual thermoelectric legs boded to electrodes. Each of these legs is made of a thermoelectric material having a p-type or n-type conductivity. The legs are made of thermoelectric pellets or layers. Electrodes are bonded to opposite sides of a thermoelectric pellet, whereas one side of a structured thermoelectric layer is in contact with metal electrodes on a substrate and the substrate itself. The pellet-based thermoelectric elements are usually manufactured as follows: first pellets of thermoelectric materials of different conductivity types are prepared, afterwards opposite sides of the pellets are metallised for facilitating soldering or brazing, and after metallisation the pellets are affixed to metal electrodes by soldering or brazing. The layer-based thermoelectric elements are usually manufactured as follows: first a metallisation layer is deposited and structured on a dielectric substrate to form metal electrodes, afterwards a first thermoelectric layer of a first conductivity type (e.g., p-type) is deposited and structured on the substrate to form thermoelectric legs of the first conductivity type, and after the deposition and structuring of the first thermoelectric layer a second thermoelectric layer of a second conductivity type (e.g., n-type) is deposited and structured on the dielectric substrate to form thermoelectric legs of the second conductivity type.

Thermoelectric elements can also be implemented using p-n junctions. Such a thermoelectric element with a p-n junction is known from EP 1 287 566 B1. In this thermoelectric element a higher efficiency is achieved in comparison with conventional thermoelectric elements. In the thermoelectric element disclosed in EP 1 287 566 B1 the p-n junction is formed essentially over the entire extension of the n and p layer, whereby a temperature gradient is applied along the p-n junction interface. This results in a temperature difference along this elongated p-n junction between two ends of the p-n layer stack. The thermoelectric element is selectively contacted at the n and p layers. This can be done either by alloying the contacts and the associated p-n junctions or by directly contacting the n- and p-layer. To connect several thermoelectric elements to form a generator, they are connected in series by cross-connected lines. Thermally, the individual thermoelectric elements of the generator are connected in parallel.

### Summary

Layer-based thermoelectric legs have lower cross-sections for heat transport in comparison with pellet-based thermoelectric legs. As a result, thermoelectric generators employing such legs can be effective when harvesting electricity from low-density heat sources which can have large areas. In turn Peltier coolers employing such legs can be used for cooling large surfaces. Put another way: thermoelectric elements employing pellet-based thermoelectric legs may require heat concentrators when used for these purposes.

Based on these considerations, the technical objective of the invention is to develop a thermoelectric element and a method of manufacturing thereof, wherein the thermoelectric element is manufacturable using industrialised processes in an inexpensive way. The thermoelectric element is suitable for series connection in a thermoelectric electricity generator and/or a heat transfer module. The technical objective of the invention is further to develop such a generator and a heat transfer module and methods of manufacturing thereof.

The proposed solution is described herein using the following terms having the meanings formulated below:
- The term "film" encompasses condensed matter restricted in one dimension. The term "layer" encompasses any conceptual space restricted in one dimension, within or at a surface of a film. A film may be a single layer or comprise or consist of a stack of layers. The layers of the stack are formed in different processes. At least two of these processes may employ different techniques (e.g., physical vapour deposition (PVD) and chemical vapour deposition (CVD)) or the same techniques (e.g., PVD or CVD). The same or different source materials (e.g., CVD precursors or sputtering targets) can be used in processes employing the same technique for forming different layers. Techniques for forming the layers enable manufacturing of layers having lateral dimensions (e.g., lateral dimensions in an interval of 1- 100 cm) substantially bigger than their thickness (e.g., thickness in an interval of 0.1 - 1000 µm, or in a narrower interval 0.1 - 100 µm, or in an even narrower interval 1-10 µm). In case of subtractive technologies lateral film dimensions may be constrained by a characteristic of a tool for forming a film, e.g. dimensions of a deposition chamber of a PVD or CVD deposition tool. A film formed in this way (e.g. blanket PVD or CVD deposition) is structured (e.g. by patterning technologies) to define its lateral dimensions. In case of additive technologies (e.g., printing) lateral dimensions of a film can be determined in a course of its formation. The film may comprise a bulk layer and an interface layer being in direct contact with one side of the bulk layer. The film may comprise another interface layer being in direct contact with another side of bulk layer, wherein the side and the other side are opposite sides of the bulk layer. A respective stack of layers may be used instead of any of the interface and the bulk layers. Interface layers may serve a purpose of optimisation of interfaces between films or between a film and a metal foil. Thermoelectric films can be rigid or flexible. It is important to note, that rigid and flexible films can be made from almost any thermoelectric material by selecting an appropriate thickness of a thermoelectric film. The specific appropriate film thickness depends on the thermoelectric material of the film. Nevertheless, some general reference values can be given which do not necessarily apply to all materials mentioned herein. A film having a thickness less than 100 µm, preferably less than 50 µm, is flexible, whereas a film having a thickness more than 500 µm, preferably more than 750 µm, is rigid. As an illustrative example, consider the problem of Si wafer bending in semiconductor manufacturing. A rigid Si wafer can be bent after thinning, when intrinsic stress in layers deposited on the Si wafer is high. The typical thickness of rigid Si wafers is in the range of 500 - 750 µm, whereas the typical thickness of flexible Si wafers after thinning (back grinding) is in the rage 50 - 75 µm.
- The term "planar film" specifies that opposite sides of the planar film are planar surfaces that entirely lie in respective parallel flat planes, wherein a thickness of the planar film is determined as a distance between these planes. A flexible film is considered planar when it has a planar shape in an unbended state. The same definition applies mutatis mutandis to planarity of a rigid or flexible layer.
- The term "planar interface" specifies that the interface between layers, or films, or a layer and a film lies in a flat plane. The interface constituted by flexible films, or flexible layers, or a flexible film and a flexible layer is considered planar when it is planar in an unbended state.
- The term "film-based thermoelectric element" encompasses thermoelectric elements which thermoelectric legs are made out films of thermoelectric materials. The films can be formed by subtractive and/or additive technologies.
- The term "substrate-free" encompasses thermoelectric elements having thermoelectric legs made of structured thermoelectric films, wherein these thermoelectric elements do not have any substrates, in particular dielectric substrates, for supporting the thermoelectric legs, as is customary for thermoelectric elements having thermoelectric legs made of structured thermoelectric films.
- The term "metal foil" encompasses a flexible sheet of a metal or metal alloy. The metal foil may be coated on one of or both of its sides. Sidewalls of the metal foil may be coated as well. These coatings are directly deposited on the respective sides of the metal foil. The coating comprises or consists of one or more of the following layers: an adhesion layer, a diffusion barrier layer, a work function setting layer, an interface layer for reduction of a thermal and/or an electrical resistance between a metal foil electrode and a thermoelectric film. In case the coating comprises or consists of more than one layer, these layers are stacked on top of each other. Metal foils used herein are preferably at least 10 µm thick. On the other hand, they are preferably thinner than 100 µm, more preferably thinner than 50 µm. Although films and foils used in thermoelectric elements described herein may have similar shapes the terms "thermoelectric film" and "metal foil" specify differences specific for films and foils such as methods and materials used for manufacturing of these films and foils. For instance, metal foils made by rolling may have and films formed by PVD deposition may have different grain textures and structures.
- The term "contamination-free interface" encompasses an interface which has a negligible concentration of foreign atoms (e.g., less than 0.1 at%, preferably less than 0.01 at%, more preferably less than 0, 001 at%) at the interface which do not belong to the materials of layers, or films, or a layer and a film constituting the interface. The concentration of atoms may be defined in a volume which borders are positioned parallel to the interface, on both sides of it, and at short distances from it. For instance, one border of the volume can be at a distance of 3 nm, preferably 2 nm, from the interface in one direction whereas another border of the volume can be at a distance of 3 nm, preferably 2 nm, from the interface in an opposite direction. Contamination-free interfaces can be made by performing consecutive depositions of different materials, layers, films, etc. without breaking vacuum, and/or exposing surfaces of deposited materials, layers, films, etc. to a contaminating and/or oxidizing environment. Contamination free interfaces between thermoelectric materials and metal or metal alloy electrodes are of particular importance for the thermoelectric elements because the contamination free interfaces contribute to manufacturing of high-quality interfaces between the thermoelectric materials and the metal or metal alloy electrodes. These high-quality interfaces have low electrical resistance and provide the appropriate work function for electrical transport between a thermoelectric material and a metal or metal alloy electrode. The latter requirement is of particular importance for the heat transfer applications (e.g., Peltier coolers).
- The terms "first", "second", "third", and "fourth" are used herein merely for the purpose of differentiating between structural components or their portions. They can be formed simultaneously or in any sequence compatible with the methods of manufacturing described herein. For instance, a first structural component and a second structural component can be manufactured simultaneously, or the first structural component can be manufactured before or after the second structural component.

The solution is based on an idea of using metal foil electrodes, that contact a thermoelectric film. One of the metal foil electrodes is arranged for a thermal coupling to a heat sink and another one is arranged for a thermal coupling to a heat source. A voltage generated by this thermoelectric element, when heat flows from the heat source to the heat sink via the thermoelectric film, is tapped from the metal foil electrodes. The thermoelectric element operates as a Peltier element when an electrical current passes between the metal foil electrodes via the thermoelectric film. Implementation of such a topology of the thermoelectric element does not include a dielectric substrate, which is used in state-of-the-art thermoelectric elements for supporting metal electrode layers and thermoelectric legs made of thermoelectric films. The absence of the substrate simplifies the design and manufacturing of thermoelectric elements because there is no need to consider the substrate as a structural element in a manufacturing process and/or there is no need to consider a difference between a thermal expansion coefficient (TEC) of a material of the substrate and TECs of materials of the thermoelectric leg and metal electrodes. Utilisation of the flexible metal foil for the metal foil electrodes facilitates integration of multiple thermoelectric elements over big areas, because a thermal expansion caused by heating is compensated by the flexibility the metal foil electrodes. Metal foil electrodes can be also used for electrical serial connection of thermoelectric elements, to manufacture thermoelectric generators or Peltier coolers.

The topology of the thermoelectric element employing only one thermoelectric leg of a specific conductivity type can be extended for manufacturing of thermoelectric elements employing p-n junctions. A topology of a thermoelectric element employing a p-n junction can be described as a combination of two thermoelectric elements each employing only one thermoelectric leg, wherein these thermoelectric legs have different conductivity types and contact each other, resulting in a p-n junction. Such a topology of the thermoelectric element employing the p-n junction allows utilization, without substantial modification, of manufacturing steps used for manufacturing of thermoelectric elements having only one thermoelectric leg of a specific conductivity type for manufacturing of thermoelectric elements employing p-n junctions. Put another way: a thermoelectric element employing a p-n junction and a method of manufacturing thereof can be seen as an extension of a thermoelectric element employing only one thermoelectric leg of a specific conductivity type and a method of its manufacturing. The metal foil electrodes are used for thermal coupling of the thermoelectric element employing the p-n junction to a heat source and a heat sink and for tapping voltage generated by the thermoelectric element when the latter is in operation. The metal foil electrodes are also used for electrical connection of the thermoelectric elements employing p-n junctions in series, to manufacture a thermoelectric module.

### Brief description of the drawings

Fig. 1 illustrates a thermoelectric element and its cross-section.
Fig. 2 illustrates a thermoelectric element and its cross-section.
Figs. 3 -6 illustrate cross-sections of central portions of metal foil electrodes.
Fig. 7 illustrates a thermoelectric module.
Figs. 8 and 9 illustrate cross-sections of the thermoelectric module depicted in Fig. 7.
Fig. 10 illustrates a thermoelectric module.
Figs. 11 and 12 illustrate cross-sections of the other thermoelectric module depicted in Fig. 10.
Figs. 13 - 19 illustrate steps of methods for manufacturing thermoelectric elements.
Figs. 20 - 23 illustrate tools for forming thermoelectric films.
Fig. 24 illustrates a thermoelectric element and its cross-section.
Fig. 25 illustrates a thermoelectric element and its cross-section.
Fig. 26 illustrates a thermoelectric element and its cross-section.
Fig. 27 illustrates a thermoelectric element and its cross-section.
Fig. 28 illustrates a cross-section of a thermoelectric module.
Fig. 29 illustrates a thermoelectric element and its cross-section.
Figs. 30 and 31 illustrate cross-sections of the thermoelectric module depicted in Fig. 29.
Figs. 32 - 34 illustrate steps of methods for manufacturing thermoelectric elements.

Axis directions X, Y, Z are the same in all Figures.

### Description

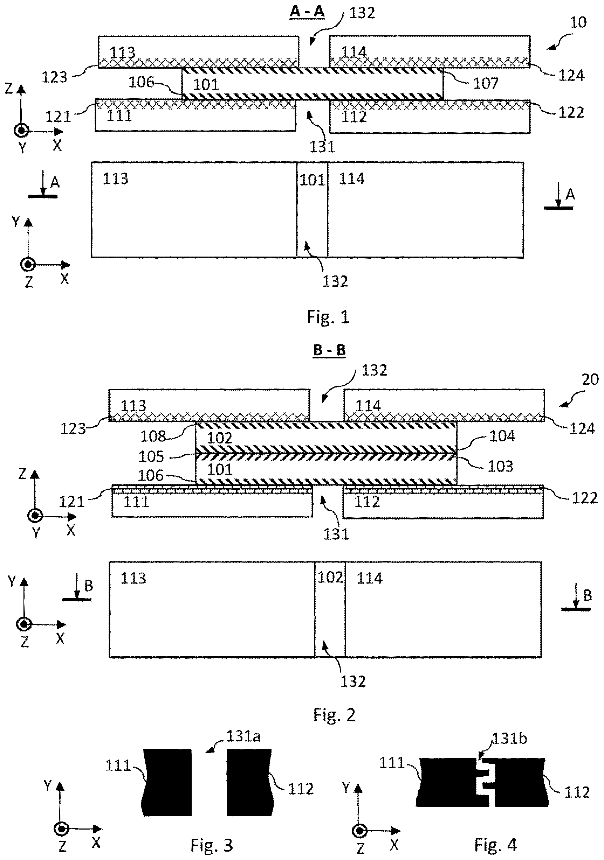

Like-numbered elements in Figs. 1- 34 are either equivalent elements or elements that perform the same function. Elements that have been discussed previously will not necessarily be discussed in later figures if the function is equivalent. The thermoelectric elements disclosed herein can be rigid or flexible. The flexibility is achieved by using films and foils, which are thin enough for making a flexible thermoelectric element. In this respect the description refers to an unbended state of such a flexible thermoelectric element. Put another way, the terms "planar interface", "planar layer" and "planar film" do not exclude an option that these objects can be bended (are bendable) due to their physical properties.

Fig. 1 depicts a thermoelectric element 10 and its cross-section. The thermoelectric element 10 comprises a first metal foil electrode 111, a second metal foil electrode 112, and a first thermoelectric film 101. The thermoelectric element 10 may be characterised as a film-based thermoelectric element, not only because it comprises the first thermoelectric film 101, but also because the first and the second metal foil electrodes 111 and 112 and the first thermoelectric film 101 have similar shapes, i.e. the first metal foil electrodes 111 and 112 and the first thermoelectric film 101 have respective dimensions in X and Y directions bigger (e.g., 10 times bigger or even 100 times bigger) than respective dimensions (i.e., thickness) in Z direction. The first thermoelectric film 101, particularly its central portion bridging a first gap 131 between the first and the second metal foil electrodes 111 and 112, acts as a thermoelectric leg connecting the first and the second metal foil electrodes 111 and 112.

The central portion of the first thermoelectric film 101 does not necessarily arranged such that it is in the middle or centre of the thermoelectric film 101 or the thermoelectric element 10. The central portion refers rather to the function of the thermoelectric element 10, i.e., it refers to its "heart". The central portion is used for the heat flow between the first and the second metal foil electrodes 111 and 112 and the electricity generation. The rest of the first thermoelectric film, if present, may be used for making the thermoelectric element 10 more stable mechanically or may be a result of a specific manufacturing method. The same applies when the thermoelectric element 10 is used for heat transport. The heat is transported via the central portion between the first and the second metal foil electrodes 111 and 112. The central portion is also used for passing the electrical current between the first and the second metal foil electrodes 111 and 112.

The first thermoelectric film 101 has a first side and a second side being opposite to the first one. The first and the second metal foil electrodes 111 and 112 are in direct contact with the first side of the first thermoelectric film 101. An interface between the first metal foil electrode 111 and the first thermoelectric film 101 and an interface between the second metal foil electrode 112 and the first thermoelectric film 101 are planar and disposed in the same first flat plane, which is parallel to X-Y plane in Fig. 1. These interfaces may be merely the only contact areas between the first thermoelectric film 101 and the metal foil electrodes 111 and 112. The first and the second metal foil electrodes 111 and 112 are separated by the first gap 131, such that they have galvanic connection only via the first thermoelectric film 101. Opposing sides of the first gap 131 are constituted by facing each other sidewalls of the first and the second metal foil electrodes 111 and 112. A can be seen from Fig. 1 the first thermoelectric film 101 bridges the first gap 131 between the first and the second metal foil electrodes 111 and 112. The first thermoelectric film 101 or its central portion may be planar, or a surface of the central portion may have a planar surface. The second side of the first thermoelectric film comprises the surface of the central portion.

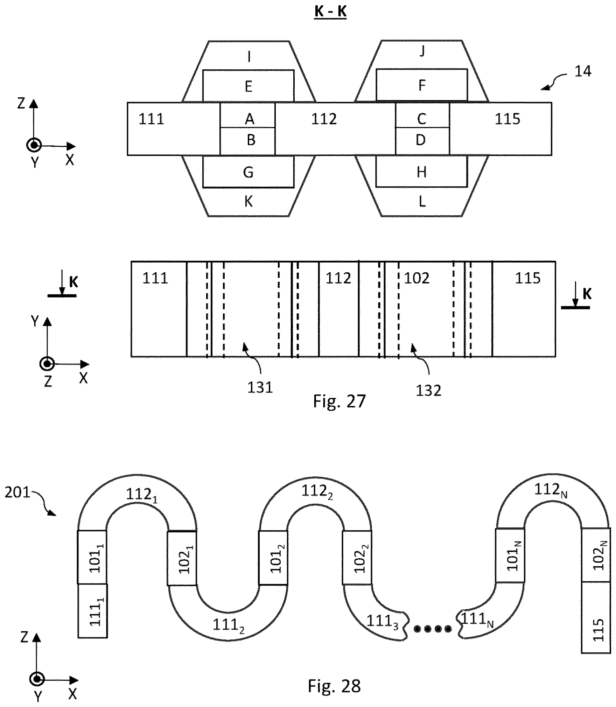

As discussed further the first thermoelectric film 101 may have not only the central portion birding the first gap 131 but a portion filling at least partially the first gap 131. In this case the first thermoelectric film 101 has an interface with the sidewall of the first metal foil electrode 111 and an interface with the sidewall of the second metal foil electrode 112. Such a configuration is depicted in Fig. 27, wherein the first thermoelectric film is comprised of elements A and E or elements A, B, and E. The first thermoelectric film 101 may have a further portion biding the first gap 131, which is arranged on other sides of the first and second metal foil electrodes 111 and 112, i.e. the first thermoelectric film may have an H-shaped form rotated 90 degrees in X-Y plane. In this case, the H-shaped first thermoelectric film 101 has interfaces with opposite sides of the first and the second metal foil electrodes 101 and 102. An example of such a configuration is depicted in Fig. 27, wherein the first thermoelectric film is comprised of elements A, B, E and G. As another variant, which is also elaborated further, the thermoelectric film 101 can only fill the gap 131, wherein the filling can be complete or partial. In this case the thermoelectric film has interfaces only with the first gap 131 constituting sidewalls of the metal foil electrodes 111 and 112. An example of such a configuration is depicted in Fig. 27, wherein the first thermoelectric film is comprised of elements A and/or B. As it will be elaborated further the surface of the second side of the first thermoelectric film 101 may be convex or concave depending on the manufacturing method and the topology of the thermoelectric element. The thermoelectric element 10 may have further a dielectric film which is arranged for mechanical reinforcement of the thermoelectric element and/or for passivation of the first thermoelectric film 101. Such a dielectric film has interfaces with the first and the second metal foil electrodes 111 and 112 and an interface with the first thermoelectric film 101. The dielectric film may be arranged in the first gap 131 or on the second side of the first thermoelectric film 101. Configurations of these optional dielectric films are elaborated further.

The first and the second metal foil electrodes 111 and 112 may have coatings 121 and 122 being in direct contact with the first thermoelectric film 101, i.e. at interfaces with the first thermoelectric film 101, e.g. at the first and the second interfaces, respectively. In turn, the first thermoelectric film 101 may have a first contact interface layer 106 on its first side, wherein the first contact interface layer 106 is in direct contact with the first and the second metal foil electrodes 111 and 112, i.e. at said interfaces, e.g. at the first and the second interfaces, respectively. The first contact interface layer 106 is in direct contact with the coatings 121 and 122, when these are used.

When the thermoelectric element 10 is used for electricity generation, one of the first and the second metal foil electrodes 111 and 112 is arranged for thermal coupling to a heat sink, whereas another one of the first and the second metal foil electrodes 111 and 112 is arranged for thermal coupling to a heat source. A voltage generated by the thermoelectric element 10, when the latter is in operation, is tapped from the first metal foil electrode 111 and the second metal foil electrode 112. In this regime heat flows from one of the metal foil electrodes 111 and 112 via the first thermoelectric film 101 to another one of the first and the second metal foil electrodes 111 and 112. When the thermoelectric element 10 is used for heat transfer (e.g., Peltier cooling), heat is transported from one of the first and the second metal foil electrodes 111 and 112 to another one of the first and the second metal foil electrodes 111 and 112, when electrical current passes between the first and the second metal foil electrodes 111 and 112 via the first thermoelectric film 101.

The simplicity of the construction of the thermoelectric element 10 allows to state that the thermoelectric element 10 can consist of three structural components such as the first thermoelectric film 101 and the first and the second metal foil electrodes 111 and 112. Properties of such a thermoelectric element 10 can be tuned by optimizing one or more of these three structural components 101, 111, and 112 without adding any further structural components. For instance, metal foils having specific coatings can be used for the first and the second metal foil electrodes 111 and 112. In addition, or as alternative, the shape of the first gap 131 can be optimized. The first thermoelectric film 101 can be formed in several steps for forming or depositing respective layers of the first thermoelectric film 101. On the other hand, utilization of only three structural components 101, 111, and 112 does not impose a limitation as such on the structure of the thermoelectric element 10. For instance, further metal foil electrodes (e.g., 113 and 114) can be used in the thermoelectric element 10. Those skilled in the art will readily understand, that utilization of only three structural components 101, 111, and 112 does not limit design optimization of the thermoelectric element 10 as such.

A thickness of the metal foil used for the first and the second metal foil electrodes 111 and 112 can be selected such a thermal conductivity of the first and the second metal foil electrodes 111 and 112 is at least 10 times higher, preferably at least 20 times higher, than a thermal conductivity of the thermoelectric leg. An optional requirement of sufficient flexibility of the first and the second metal foil electrodes 111 and 112 can be used for determining an upper limit for the thickness of metal foil used for the first and the second metal foil electrodes 111 and 112. In addition, the first thermoelectric film 101 can be formed and/or structured such that distal end portions of the first and the second metal foil electrodes 111 and 112 are devoid of the material of the first thermoelectric film 101, wherein the distal end portions are distal to the first gap 131 (Fig. 1). Alternatively distal portions of the first thermoelectric film 101 arranged on the distal end portions may be thinner, preferably at least 10 times, than the central portion of the first thermoelectric film 101 bridging the first gap 131. Thinning of the first thermoelectric film 101 at the distal end portions or its complete absence on the distal end portions may be of advantage, because these measures facilitate flexibility of the first and the second metal foil electrodes 111 and 112, particularly when the central portion of the first thermoelectric film 101 is rigid or not flexible enough. Utilisation of flexible metal foil electrodes reduces a mechanical load on the central portion of the first thermoelectric film 101. Excessive mechanical load of the central portion may increase a risk of fracture of the thermoelectric element 10, because the central portion may be thinner than 100 µm or even thinner than 50 µm, depending on the application. Such a mechanical load can be caused by processing tools in a course of assembly of the thermoelectric elements 10 in a thermoelectric module for electricity generation and/or heat transfer or by non-uniform thermal expansion when the thermoelectric element 10 is in operation. Thus, the criterium for the upper limit for the thickness of the metal foil used for the first and the second metal foil electrodes 111 and 112 can be formulated as follows: the metal foil must be thin enough to avoid fracture of the thermoelectric elements 10 during their assembly and operation.

The thermoelectric element 10 may further comprise a third metal foil electrode 113 and a fourth metal foil electrode 114, each being in direct contact with the second side of the first thermoelectric film 101 (Fig. 1). To emphasize that this thermoelectric element can be considered as substrate-free it can be characterised as consisting of the first metal electrode 111, the second metal electrode 112, the third metal electrode 113, the fourth metal electrode 114, and the first thermoelectric film 101. An interface between the third metal foil electrode 113 and the first thermoelectric film 101 and an interface between the fourth metal foil electrode 114 and the first thermoelectric film 101 are planar and disposed in the same second flat plane, which is parallel to the first flat plane and X-Y plane in Fig. 1. These interfaces may be merely the only contact areas between the first thermoelectric film 101 and the metal foil electrodes 113 and 114. As can be seen from Fig. 1 the first thermoelectric film bridges the second gap 132. In addition, the first thermoelectric film 101 may at least partially fill the second gap 132, i.e. it may have interfaces with gap constituting sidewalls of the first and the second metal electrodes 113 and 114. The third and the fourth metal foil electrodes 113 and 114 may have coatings 123 and 124 being in direct contact with the first thermoelectric film 101. In turn the first thermoelectric film 101 may comprise other first contact interface layer 107 on its second side. The other first contact interface layer 107 is in direct contact with the coatings 123 and 124, when these are used. The third and the fourth metal foil electrodes 113 and 114 are separated by a second gap 132, such that the third and the fourth metal foil electrodes 113 and 114 have galvanic connection only via the first thermoelectric film 101. Opposing sides of the second gap 132 are constituted by facing each other sidewalls of the third and the fourth metal foil electrodes 113 and 114. The first and the second gaps 131 and 132 are aligned relative to each other in X-Y plane as depicted in Fig. 1, such that the first gap 131 projects onto the second gap 132. In case of severe misalignment, e.g., when the second gap 132 fully projects on the first metal foil electrode 131, the first metal foil electrode 131 acts as an electrical shunt for a portion of the first thermoelectric film bridging the second gap 132. The relative alignment of the first and the second gaps 131 and 132 can be formulated in a more rigorous form as follows. A first area of the first gap 131 is defined by facing each other sidewalls of the first and the second metal foil electrodes 111 and 112 in the first flat plane. A second area of the second gap is defined by facing each other sidewalls of the third and the fourth metal foil electrodes 113 and 114 in the second flat plane. The first and the second areas comply with one of the following criteria: a) projection of the first area in the second flat plane coincides with the second area; b) at least 80%, preferably at least 90%, of the projection is inside the second area; c) at least 80%, preferably 90% of the second area is inside the projection. Criteria b) and c) are formulated in such a way that a manufacturing tolerance is considered. The relative alignment of the metal foil electrodes 111 - 114 can be formulated in a less rigorous form using a plane language. A first portion of the first thermoelectric film 101 is disposed between the first and the third metal foil electrodes. A second portion of the first thermoelectric film 101 is disposed between the second and the fourth metal foil electrodes 112 and 114. The central portion of the thermoelectric film 101 connects its first and second portions and bridges the first and the second gaps 131 and 132. The central portion may be planar in this implementation of the thermoelectric element 10 with four metal electrodes 111-114. The third metal foil electrode 113 projects onto the first metal foil electrode 111. The fourth metal foil electrode 114 projects onto the second metal foil electrode 112.

The third and the fourth metal foil electrodes 113 and 114 can be made of a metal foil which is selected in accordance with the criteria formulated for the metal foil used for the first and the second metal foil electrodes 111 and 112. Analogous to the first and the second metal foil electrodes 111 and 112, the first thermoelectric film 101 can be formed such that distal end portions of the third and the fourth metal foil electrodes 113 and 114 are devoid of the material of the first thermoelectric film 101, wherein the distal end portions are distal to the second gap 132 (Fig. 1). Alternatively, distal portions of the first thermoelectric film 101 arranged on the distal end portions of the third and the fourth metal foil electrodes 113 and 114 may be thinner, preferably at least 10 times, than the central portion of the first thermoelectric film 101 bridging the first and the second gaps 131 and 132 (Fig. 1).

A direct mechanical and/or electrical connection (e.g., by soldering or brazing) may be provided between the distal end portions of the first and the third metal foil electrodes 111 and 113 when they devoid of the material the first thermoelectric film 101. A direct mechanical and/or electrical connection (e.g., by soldering or brazing) may be provided between the distal end portions of the second and the fourth metal foil electrodes 112 and 114 when they devoid of the material the first thermoelectric film 101.

In the thermoelectric element 10 the first and the third metal foil electrodes 111 and 113 have the same function and the second and the fourth metal foil electrodes 112 and 114 have the same function as well. The same function means thermal and electrical coupling. For instance, the first and the third metal foil electrodes 111 and 113 can be arranged for thermal coupling to a heat sink and the second and the fourth metal foil electrodes 112 and 114 can be arranged for thermal coupling to a heat source, whereas a voltage generated by the thermoelectric element 10, when the latter is in operation, is tapped from at least one of the first and the third metal foil electrodes 111 and 113 and at least one of the second and the fourth metal foil electrodes 112 and 114. Utilization of the first metal foil electrode 111 in parallel with the third metal foil electrode 113 for thermal and/or electrical transport may facilitate thermal coupling of the first thermoelectric film 101 and/or reduce a resistance of an electrical contact to the first thermoelectric film 101. Utilization of the second metal foil electrode 112 in parallel with the fourth metal foil electrode 114 for thermal and/or electrical transport may result for the same improvements.

Fig. 2 depicts another thermoelectric element 20 and its cross-section. The thermoelectric element 20 depicted in Fig. 2 differs from the thermoelectric element 10 depicted in Fig. 1 in that, that it comprises a stack of two thermoelectric films 101 and 102 instead of only one thermoelectric film 101. In particular, the second side of the first thermoelectric film 101 is in direct contact with a first side of the second thermoelectric film 102 and a second side of the second thermoelectric film 102 is in direct contact with the third and the fourth metal foil electrodes 113 and 114, wherein the first and the second sides of the second thermoelectric film 102 are its opposite sides. The thermoelectric element 10 employs a single p-type or n-type thermoelectric leg constituted by the first thermoelectric film 101. In contrast, the thermoelectric element 20 employs a p-n or p-i-n junction constituted by the first and the second thermoelectric films 101 and 102, which have different conductivity types. The first side of the second thermoelectric film 102 and the second side of the first thermoelectric film 101 constitute an interface of the p-n or p-i-n junction, at which conductivity type changes from p-type to n-type. The topology of the thermoelectric element 20 can be seen as a stack of two thermoelectric elements 10 without the third and the fourth metal foil electrodes 113 and 114, wherein a free (i.e., devoid from metal foil electrodes) side of the thermoelectric film of one of the thermoelectric elements is in direct contact with a free side of the thermoelectric film of another one of the thermoelectric elements. To emphasize that the thermoelectric element 20 can be also considered as a substrate-free thermoelectric element it can be characterised as consisting of the first metal electrode 111, the second metal electrode 112, the third metal electrode 113, the fourth metal electrode 114, the first thermoelectric film 101, and the second thermoelectric film 102.

In each of the thermoelectric elements 10 and 20, the first and the second metal foil electrodes 111 and 112 are separated by the first gap 131 and the third and the fourth metal electrodes 113 and 114 are separated by the second gap 132. The metal foil electrodes 111-114 and the gaps 131 and 132 are positioned in the same way relative to each other in both thermoelectric elements 10 and 20. Analogously to the first thermoelectric element 10, any of the metal foil electrodes 111 - 114 of the second thermoelectric element 20 should have galvanic (electrical) connection with any other of the metal foil electrodes only via one and both thermoelectric films 101 and 102. For instance, an electrical resistance bewhen the first metal foil electrode 111 and the second metal electrode 112 in the thermoelectric element 20 is determined only by the properties of the first thermoelectric film 101 and the second thermoelectric film 102, i.e. the electrical resistance should be the same for the thermoelectric element 20 with four metal foil electrodes 111- 114 and for a hypothetical case when the third metal foil electrode 113 and the fourth metal electrode 114 are absent in the second thermoelectric element 20. In other words, the first gap 131 has to be aligned relative to the second gap 132 such that neither the third metal foil electrode 113 nor the fourth metal foil electrode 114 acts a shunt for an electrical current flowing from the first metal electrode 111 to the second metal foil electrode 112 when a voltage difference is applied between the first metal foil electrode 111 and the second metal foil electrode 112. In the thermoelectric elements 10 and 20 the interface between the first metal foil electrode 111 and the first thermoelectric film 101 at the first side of the first thermoelectric film 101 and the interface between the second metal foil electrode 112 and the first thermoelectric film 101 at the first side of the first thermoelectric film 101 are planar and disposed in the same first flat plane, which is parallel to X-Y plane in Fig. 1. In the thermoelectric element 10 the interface between the third metal foil electrode 111 and the first thermoelectric film 101 at the second side of the first thermoelectric film 101 and the interface between the fourth metal foil electrode 114 and the first thermoelectric film 101 at the second side of the first thermoelectric film 101 are planar and disposed in the same second flat plane, which is parallel to the first flat plane. In the thermoelectric element 20 the interface between the third metal foil electrode 111 and the second thermoelectric film 102 at the second side of the second thermoelectric film 102 and the interface between the fourth metal foil electrode 114 and the second thermoelectric film 102 at the second side of the second thermoelectric film 102 are planar and disposed in the same third flat plane, which is parallel to the first flat plane. The interface between the third metal foil electrode 111 and the second thermoelectric film 102 and the interface between the fourth metal foil electrode 114 and the second thermoelectric film 102 may be merely the only contact areas between the second thermoelectric film 102 and the third and the fourth metal foil electrodes 113 and 114.

The thermoelectric element 20 may have a dielectric film arranged for mechanical reinforcement of the thermoelectric element and/or for passivation of the first thermoelectric film 101. Such a dielectric film has an interface with the first thermoelectric film 101, an interface with the first metal foil electrode 111, and an interface with the second metal foil electrode 112. This dielectric film can at least partially fill the first gap 131. In addition, or as alternative, the thermoelectric element 20 may have another dielectric film arranged for mechanical reinforcement of the thermoelectric element and/or for passivation of the second thermoelectric film 102. Such a dielectric film has an interface with the second thermoelectric film 102, an interface with the third metal foil electrode 113, and an interface with the fourth metal foil electrode 114. This dielectric film may at least partially fill the second gap 132. Configurations of these optional dielectric films are elaborated further.

Analogous to the thermoelectric element 10 with four metal foil electrodes 111 - 114, the first thermoelectric layer 101 or its central portion bridging the gap 131 between the first and the second metal foil electrodes 111 and 112 may be planar and/or the second thermoelectric film 102 or its central portion bridging the gap 132 between the third and the fourth metal foil electrodes 113 and 114 may be planar in the thermoelectric element 20. The first thermoelectric film 101 or its central portion and the second thermoelectric film 102 or its central portion may have planar surfaces constituting the planar interface of the p-n or p-i-n junction. This interface is parallel to the fist and the third flat planes and disposed between these planes. The later criterium is more relaxed in comparison to the criterium referring to the planar films or their portions.

The metal foil electrodes 111 - 114 can be implemented in the same way in both thermoelectric elements 10 and 20. This formulation does not exclude an optional requirement related to utilization of different coatings of metal foil electrodes specific for respective conductivity types of thermoelectric films. For instance, all metal foil electrodes 111-114 in the thermoelectric element 10 may have first coatings 121-124 required for a thermoelectric film 101 having p-type conductivity, whereas second coatings 121 -124 are required when the thermoelectric element 10 employs a thermoelectric film 101 having n-type conductivity. In contrast the first and the second coatings are used in the thermoelectric element 20 employing the thermoelectric film 101 having p-type conductivity and the thermoelectric film 102 having n-type conductivity. The first coatings 121 and 122 are used for the first and the second metal foil electrodes 111 and 112, because they contact the thermoelectric film 101 having p-type conductivity, whereas the second coatings 123 and 124 are used for the third and the fourth metal foil electrodes 113 and 114, because they contact the thermoelectric film 102 having n-type conductivity.

For the same reasons as mentioned above the thermoelectric films 101 and 102 used in the thermoelectric element 20 can be formed and/or structured in the same way in the thermoelectric film 101 in the thermoelectric element 10. Distal end portions of the metal foil electrodes 111-114 can be devoid of the first and the second thermoelectric films 101 and 102. Alternatively distal portions of the first thermoelectric film 101 arranged on the distal end portions of the first and the second metal foil electrodes 111 and 112 may be thinner, preferably at least 10 times, than the central portion of the first thermoelectric film 101 bridging the first gap 131 (Fig. 2). In an analogous way distal portions of the second thermoelectric film 102 arranged on the distal end portions of the third and the fourth metal foil electrodes 113 and 114 may be thinner, preferably at least 10 times, than the central portion of the second thermoelectric film 102 bridging the second gap 132 (Fig. 2).

In the thermoelectric element 20, the first metal foil electrode 111 and/or the third metal foil electrode 113 are arranged for thermal coupling to a heat sink, whereas the second metal foil electrode 112 and/or the fourth metal foil electrode 114 are arranged for thermal coupling to a heat source. A voltage generated by the thermoelectric element 20, when in operation for electricity generation, is tapped from the first metal foil electrode 111 and the third metal foil electrode 113.

Thermoelectric materials of different conductivity types can have different electrical and/or thermal conductivities. As usual n-type thermoelectric materials have higher electrical conductivity and/or thermal conductivity than p-type thermoelectric materials. When required, such a disparity is compensated by adapting of cross-sections of thermoelectric legs in the thermoelectric elements 10 employing single thermoelectric films and by adapting thickness of the first and/or the second thermoelectric films 101 and 102 in the thermoelectric elements 20 employing p-n junctions. A cross-section of a thermoelectric leg in the thermoelectric element 10 can be adapted by varying a width (Y direction in Fig. 1) and/or a thickness (Z direction in Fig. 1) of the thermoelectric film or at least its central portion bridging the first gap 131 and the second gap 132, when the latter is present. Thermoelectric elements 10 employing a first material for thermoelectric legs have thicker and/or wider thermoelectric films than thermoelectric elements 10 employing a second material for thermoelectric legs, when the second material has higher electrical and/or thermal conductivity than the first material. In case of the thermoelectric elements 20 employing the p-n junctions constituted by the first and the second thermoelectric films 101 and 102, the first thermoelectric film 101 can be made thicker than the second thermoelectric film 102, when a material of the second thermoelectric film 102 has higher thermal and/or electrical conductivity than a material of the first thermoelectric film 101.

Thermoelectric materials used herein can be inorganic, organic, metal-organic materials, or mixtures of thereof.

Non-limiting examples of inorganic thermoelectric materials are the following. Bi₂Te₃-based thermoelectric materials (e.g., n-type Cu_{0.01}Bi₂Te_{2.7}Se_{0.35} or Bi₂Te_{2.7}Se_{0.3}; p-type BiₓSb₂₋ₓTe₃) and metal foil electrodes (e.g., structured copper foils coated (e.g., plated) by nickel or cobalt) can be used in thermoelectric elements operating in a temperature rage below 400 degrees Celsius, preferably below 300 degrees Celsius. Wrought aluminium alloys including one or more of alloying elements such as copper, magnesium, manganese, silicon, tin, or zinc can be used instead of copper in a temperature range below 300 degrees Celsius, preferably below 200 degrees Celsius. Preferred coatings of metal foil electrodes for Bi₂Te₃-based thermoelectric materials of n-type are (Bi₂Te_{2.7}Se_{0.3})_{0.99}(Sbl₃)_{0.01}, NiSe₂, Co, NiFeInS, Sb, Fe_{0.85}Cr_{0.15}, TiN or Ti. Preferred coating for metal foil electrodes for Bi₂Te₃-based thermoelectric materials of p-type is Ni, however the preferred coatings for Bi₂Te₃-based thermoelectric materials of n-type are also usable for p-type. CoSb₃-based skutterudite thermoelectric materials (e.g., n-type Ba_{0.08}La_{0.05}Yb_{0.04}Co₄Sb₁₂ and p-type Ce_{0.45}Nd_{0.45}Fe_{3.5}Co_{0.5}Sb₁₂), cold side metal foil electrodes (e.g., structured copper foil coated by Ti, Ga-Sn alloy, Ag-Cu-Zn alloy, or Mo Mo, Cr-Fe-Co alloy or Cr-Fe-Ni alloy), and hot side metal foil electrodes (e.g., structured molybdenum foils or structured Mo-Cu alloy or Co-Si alloy foils coated by Ti, Ga-Sn alloy, Ag-Cu-Zn alloy, Mo, Cr-Fe-Co alloy or Cr-Fe-Ni alloy) can be used in thermoelectric elements operating in a temperature range from 20 to 700 degrees Celsius, preferably from 70 to 550 degrees Celsius. Half-Heusler (HH) alloy-based thermoelectric materials (e.g., n-type X_{IV}NiSn; p-type X_{IV}CoSb, XvFeSb, ZrCoBi, where X_{IV} one or more of Ti, Zr, or Hf, and Xv one or more V, Nb, Ta), cold side metal foil electrodes (e.g., structured copper foils coated by Mo), and hot side metal foil electrodes (e.g., structured molybdenum or Mo-Fe alloy foils or structured Mo-Cu alloy or Co-Si alloy foils coated by Mo or Ti) can be used in thermoelectric elements operating in a temperature range from 200 to 1000 degrees Celsius, preferably from 300 to 900 degrees Celsius. SiGe-based thermoelectric materials and metal foil electrodes (e.g., structured foils of molybdenum or tungsten coated as an option by graphite) can be used in thermoelectric elements operating in a temperature range above 600 degrees Celsius, preferably above 750 degrees Celsius.

Non-limiting examples of organic, hybrid organic-inorganic, organic-inorganic mixture thermoelectric materials are the following: poly(3,4-ethylenedioxy thiophene) polystyrene sulfonate (PEDOT:PSS), PEDOT or PEDOT:PSS based blends and composites of p-type and n-type, polyaniline (PANI), PEDOT-based nanocomposites comprising single/multi-wall carbon nanotubes, graphene, or carbon black, poly(3,4-ethylenedioxythiophene).

Non-limiting examples of metal-organic thermoelectric materials are n and p-type polymers containing 1,1,2,2-ethenetetrathiolate (ett) linking bridge: poly[Ax(M-ett)] (A = tetradecyltrimethyl ammonium, tetrabutyl ammonium, Na⁺, K⁺, Ni²⁺, Cu²⁺, M = Ni, Cu).

Non-limiting examples of organic-inorganic mixture thermoelectric materials and nanocomposite polymer thermoelectric materials are PEDOT-based nanocomposites with inorganic loadings like GeOz nanoparticles, MoS₂ nanosheets, or BN nanosheets, PEDOT:PSS mixed with Bi₂Te₃ particles .

Non-limiting examples of thermoelectric inorganicsemiconductivenanomaterial/polymercomposite materials are Te/PEDOT:PSS, PbTe/PEDOT, Bi₂Te₃/PEDOT:PSS, SnSe/PEDOT, Sb₂Te₃/PEDOT, Bi₂Te₃/PEDOT, Ag₂Se/PVP, TiS₂/[(HA)_{0.08}(H₂O)_{0.22}(DMSO)_{0.03}], TiS₂/[(TBA)_{0.013}(HA)_{0.019}].

Non-limiting examples of thermoelectric carbonnanotubes/conductivepolymercomposite materials are DWCNT/graphene/PEDOT:PSS/PANI, SWCNT/PEI, SWCNT/PEI/DETA, SWCNT/(PEDOT:PSS), DWCNT/(PEDOT:PSS)/TCPP, SWCNTF/(PEDOT:PSS)/PVA, SWCNTF/(PEDOT:PSS), SWCNT/PANI, SWCNT/CPE-Na, DWCNT:TCPP/PVAc, SWCNT/PS, MWCNT/P3HT, MWCNT/PEDOT, MWCNT/(PEDOT:PSS)/TCPP, MWCNT/PPy, wherein DWCNT means double-walled carbon nanotube, SWCNT means single walled carbon nanotube, PEI means polyethylenimine, DETA means diethylenetriamine, TCPP means Tetrakis (4-carboxyphenyl) porphyrin, PVA means polyvinyl alcohol, CPE means conjugated polyelectrolyte, TCPP means meso-tetra(4-carboxyphenyl) porphine, PVAc means Poly(vinyl acetate), PS means polystyrene, P3HT means Poly(3-hexylthiophene-2,5-diyl), PPY means polypyrrol.

A metal foil coating comprising a top layer of fluorine doped tin oxide (FTO) can be employed for producing ohmic contact to p-type PEDOT:PSS based thermoelectric materials, whereas a metal foil coating comprising a copper layer can be employed for producing ohmic contact to n-type PEDOT:PSS based thermoelectric materials.

As mentioned above, the metal foil electrodes 111-114 may have coatings 121 - 124, respectively, as illustrated in Figs. 1 and 2 depicting the cross-sections of the thermoelectric elements 10 and 20. A specific coating of a metal foil electrode can be selected in accordance with a material of a thermoelectric film contacting the metal foil electrode and/or operational temperature regime such as hot side of cold side of the thermoelectric element. Composition of one or more coatings 121, 122, 123, 124 of the metal foil electrodes 111- 114 is not limited to a single layer. For instance, the one or more coatings 121, 122, 123 or 124 may have several functionalities and each functionality may be provided by one or more layers of the coating. One layer of the one or more coatings 121, 122, 123, or 124 may act as a diffusion barrier (e.g., TiN), which prevents diffusion of atoms of one or more underlaying materials of a metal foil or its coating into an adjacent thermoelectric film and/or diffusion of atoms of the adjacent thermoelectric film into the metal foil electrode. Such a diffusion barrier material layer may be in direct contact with a thermoelectric film at an interface between the thermoelectric film and a metal foil electrode. Another layer of the one or more coatings 121, 122, 123, or 124 may on contrary function as a source of one or more chemical elements (e.g., dopants) for drive-in diffusion into an adjacent thermoelectric film. Yet another layer of the one or more coatings 121, 122, 123, or 124 may promote alloying between a metal foil electrode and an adjacent thermoelectric film, e.g., brazing alloys for alloying HH alloy-based thermoelectric film with a metal foil electrode. Yet another layer of the one or more coatings 121, 122, 123, or 124 may work as work function setting material for an electrical contact between a metal foil electrode and a thermoelectric film (e.g., Mo or Ti work function material for a thermoelectric film based on a p-type HH alloy, platinum-antimony or gold-antimony alloy for a thermoelectric film based on Bi₂Te₃). The work function setting layer is preferably positioned in direct contact with a thermoelectric film at an interface between the thermoelectric film and a metal foil electrode, wherein a diffusion barrier layer may be used between the work function layer and a material of a metal foil used for a metal foil electrode. The work function stetting is of particular importance for Peltier cooling thermoelectric elements. Yet another layer of the one or more coatings 121, 122, 123, or 124 may be an adhesion layer for facilitating adhesion between a thermoelectric film and a metal foil electrode. Such a layer can be implemented using adhesion-enhancing materials such as titanium. Another option might be using an adhesion layer having a similar, a substantially similar, or the same chemical composition as a thermoelectric film. For instance, an adhesion layer can be deposited using a sputtering target having a similar, a substantially similar, or the same chemical composition as a powder of a thermoelectric material compacted on the adhesion layer to form a thermoelectric film. A criterion for a similarity of chemical compositions can be formulated as follows: a material of one component (e.g., film, layer, sputtering target, powder) and another material of another component (e.g., film, layer, sputtering target, powder) are similar when they comprise at least one common chemical element and an atomic concentration of this common element in the material differs from an atomic concentration of this common element in the other material less than 10%, preferably less than 5%. It is preferred that these materials have only one differing chemical element and atomic concentrations of each common chemical elements in these materials differ less than 10%, preferably less than 5%. It is more preferred, that these materials consist of the same chemical elements and atomic concentrations of each chemical element in these materials differ less than 10%, preferably less than 5%. The choice of a specific layer or a specific stack of layers of the one or more coatings 121, 122, 123, or 124 depends on a material of a thermoelectric film adjoining the one or more coatings 121, 122, 123, or 124, an operational temperature of a thermoelectric element, and an application type (generation of electricity or Peltier cooling). Yet another functionality of the one or more coatings 121, 122, 123, or 124 can be a reduction of thermal contact resistance between a thermoelectric film 101 or 102 and a metal foil electrode 111, 112, 113 or 114 adjoining this thermoelectric film 101 or 102. The thermal contact resistance can originate from a Kapitza resistance, which may be mitigated by so called phonon bridge layer having a spectral density of states that eases the transfer of phonons from one side of the interface to the other.

The thermoelectric film (e.g., 101, 102) used in the thermoelectric element (e.g., 10, 20) may comprise several layers having different chemical compositions. The "classical" formalism used in semiconductor devices, based on the dopant concentration in high quality semiconductor layers, may be quite difficult to apply to thermoelectric materials because the doping efficiency in these materials is quite low. Unlike high quality Si crystals having a few dopant atoms per million of Si atoms thermoelectric materials have 1 dopant atom per 1000 or even 100 atoms of the material. In this respect it may be more practical to characterise thermoelectric films and their layers by bulk properties of materials used for their manufacturing. The bulk properties of a specific material comprise its chemical composition and charge carrier concentration, which can be measured from Hall effect. For instance, Se and Sb used for tuning electrical and/or thermal conductivity of Bi₂Te₃-based thermoelectric materials are denoted in chemical compositions of n-type and p-type Bi₂Te₃-based thermoelectric materials. Such an approach is more universal since it is applicable for a broad spectrum of thermoelectric materials. This does not necessarily mean that the "classical" formalism used in semiconductor devices employing high quality semiconductor layers is useless for characterisation of the thermoelectric films. It may be appropriate for characterisation of SiGe-based thermoelectric films. Such films can be deposited using CVD techniques, which are very well developed in the semiconductor industry.

The thermoelectric film (e.g., 101 or 102) of the thermoelectric element (e.g., 10, 20) may comprise a bulk layer and an interface layer (e.g., 103, 104, 106, 107, 108) being in direct contact with one of the opposite sides of the bulk layer. The thermoelectric film may further comprise another interface layer being in direct contact with another one of the opposite sides of the bulk layer. The opposite sides of the bulk layer are preferably parallel to X-Y plane. The bulk layer is preferably a planar layer. The bulk layer is preferably 10 times thicker than the interface layer of the same thermoelectric film. The same is valid for the other interface layer, if two interface layers are used in the thermoelectric film. A contact interface layer (e.g., 106, 107, 108) being in direct contact with a bilk layer and a metal foil electrode (e.g., 111, 112, 113, 114) may serve a purpose of optimisation of a contact interface between the metal foil electrode and a thermoelectric film comprising the interface layer and a bulk layer, whereas a junction interface layer (e.g., 103, 104) being in direct contact with a thermoelectric film of a p-n or p-i-n junction and a bulk layer of another thermoelectric film of the p-n or p-i-n junction may serve a purpose of optimisation of junction interfaces (e.g., 105) between these thermoelectric films constituting the p-n or p-in junction. For the sake of consistent narrative: if a thermoelectric film (e.g., 101 or 102) does not have a contact interface layer then its bulk layer is in direct contact with the metal foil electrodes (e.g., a 111 and 112, or 113 and 114); if a thermoelectric film (e.g., 101 or 102) does not have a junction interface layer then its bulk layer is in direct contact with another thermoelectric film (e.g., 102 or 101).

In particular, the first and/or the second thermoelectric films 101 and/or 102 may have contact interface layers 106, 107, 108 being in direct contact with the respective metal foil electrodes 111 - 114 (Figs. 1 and 2). Such a contact interface layer may serve a purpose of facilitating of an electrical and/or thermal contact and/or adhesion between the thermoelectric film and the metal foil electrode and/or creating contamination-free and/or low defect density interfaces between the thermoelectric film and the metal foil electrode. For instance, the contact interface layer 106, 107, 108 can be formed on a metal foil of the respective metal electrode 101- 104 using one process (e.g., PVD or CVD) whereas the subsequent bulk layer can be formed using another process (e.g., powder compaction). In addition, the contact interface layer can be formed on the precleaned surface of the metal foil or immediately after forming a coating of the metal foil (e.g., PVD or CVD) such that the precleaned and/or coated metal foil is not exposed to contaminating and/or oxidizing environment. Such an approach can be implemented by depositing of subsequent layers by PVD and/or CVD without breaking vacuum. The bulk and the contact interface layer of the same thermoelectric film have the same conductivity type. These layers may also be made of the same materials or at least using the same source materials (e.g., a material of a sputtering target for sputter-deposition the contact interface layer and a material of powder for pressure-compaction of the bulk layer). Alternatively, the contact interface layer can be made of a material having higher charge carrier concentration than a material of the bulk layer adjoining the contact interface layer. A stack of layers having different chemical compositions may be used instead of the single contact interface layer (e.g., 106, 107, 108). Such an implementation may be of advantage when a gradual change of thermoelectric film properties (e.g., charge carrier concentration) is required in a direction perpendicular to the contact interface (Z direction or an opposite direction in Figs. 1 and 2). For instance, the chemical compositions can be selected such, that a charge carrier concentration increases across the contact interface layer in a direction from the bulk layer of the first or second thermoelectric film 101or 102 to the respective metal foil electrode 111 -114. The contact interface layer is preferably at least 10 times thinner than the thermoelectric film comprising this contact interface layer.

In the thermoelectric elements 10 and 20 the first thermoelectric film 101 may have the first contact interface layer 106 covering its entire first side as depicted in Figs. 1 and 2. Alternatively, one contact interface layer may be used at the interface between the first metal foil electrode 111 and the first thermoelectric film 101 and another contact interface layer may be used at the interface between the second metal foil electrode 112 and the first thermoelectric film 101. This variant is not depicted in Figs. 1 and 2 however it can be readily understood on the basis of Fig. 1 or 2 under assumption, that a portion of the first contact interface layer 106 is absent in the central portion of the first thermoelectric film 101 bridging the gap 131 between the first and the second metal foil electrodes 111 and 112. The first thermoelectric film 101 can be structured in this way by making (e.g., by etching or micro-machining) a trench therein, wherein the first gap 131 defines the borders of the trench. The trench may be made deeper than the thickness of the first contact interface layer 106.

In the thermoelectric element 10 the first thermoelectric film 101 may have another first contact interface layer 107 covering its entire second side as depicted in Fig. 1. Alternatively, one contact interface layer may be used at the interface between the third metal foil electrode 113 and the first thermoelectric film 101 and another contact interface layer may be used at the interface between the fourth metal foil electrode 114 and the first thermoelectric film 101. Such a topology can be achieved by structuring the first thermoelectric film 101 from another side to form a trench therein in a similar way as described above.

In the thermoelectric element 20 the second thermoelectric film 102 may have a second contact interface layer 108 covering its entire second side as depicted in Fig. 2. Alternatively, one contact interface layer may be used at the interface between the third metal foil electrode 113 and the second thermoelectric film 102 and another contact interface layer may be used at the interface between the fourth metal foil electrode 114 and the second thermoelectric film 102. The separate contact interface layers for individual metal foil electrodes 111- 114 can be manufactured by extending the first and/or the second gaps 131 and/or 132 into the first and/or the second thermoelectric films respectively to make a trench or trenches which contours are defined by the respective gap or gaps 131 and/or 132.

In the thermoelectric element 20 the first thermoelectric film 101 may comprise a first junction interface layer 103 between the second thermoelectric film 102 and the bulk layer of the first thermoelectric film 101. The first junction interface layer103 is made of a thermoelectric material having a lower charge carrier concentration than a thermoelectric material used for the bulk layer of the first thermoelectric film 101. These materials have the same conductivity type and belong to the same group of thermoelectric materials, e.g. a group of Bi₂Te₃-based thermoelectric materials. Preferably these materials have similar chemical composition, e.g., their chemical compositions differ by only one or two chemical elements, more preferably by only one chemical element. For instance, a bulk layer of a thermoelectric film can be made of Cu_{0.01}Bi₂Te_{2.7}Se_{0.35} or Bi₂Te_{2.7}Se_{0.3}, whereas a junction interface layer of the thermoelectric film can be made of Bi₂Te₃. Even more preferably these materials are made of the same chemical elements and differ from each other by quantities (e.g., at. %) of these chemical elements. A stack of layers having different chemical compositions may be used instead of the first junction interface layer 103. Such an implementation may be of advantage when a gradual change of thermoelectric film properties (e.g., charge carrier concentration) is required in a direction perpendicular to the junction interface 105 (Z direction Fig. 2). For instance, the chemical compositions can be selected such, that a charge carrier concentration decreases across the first junction interface layer in a direction from the bulk layer of the first thermoelectric film 101 to the second thermoelectric film 102. Preferably, the first junction interface layer 103 or the stack of layers used instead of the first thermoelectric film 101 are at least three times thinner than the first thermoelectric film 101.

The second thermoelectric film 102 may comprise a second junction interface layer 104 between the first thermoelectric film 101 and the bulk layer of the second thermoelectric film 102. Analogously to the first junction interface layer 103 the second junction interface layer 104 is made of a thermoelectric material having a lower charge carrier concentration than a thermoelectric material used for the bulk layer of the second thermoelectric film 102. These materials have the same conductivity type and belong to the same group of thermoelectric materials, e.g. a group of Bi₂Te₃-based thermoelectric materials. Preferably these materials have similar chemical composition, e.g., their chemical compositions differ by only two chemical elements, more preferably by only one chemical element. Even more preferably these materials are made of the same chemical elements and differ from each other by quantities of these chemical elements. A stack of layers having different chemical compositions may be used instead of the second junction interface layer 104. Such an implementation may be of advantage when a gradual change of thermoelectric film properties (e.g., charge carrier concentration) is required in a direction perpendicular to the junction interface 105 (the direction opposite to Z direction Fig. 2). For instance, the chemical compositions can be selected such, that a charge carrier concentration decreased across the second junction interface layer 104 in a direction from the bulk layer of the second thermoelectric film 102 to the first thermoelectric film 101. Preferably, the second junction interface layer 104 or the stack of layers used instead of the second junction interface layer 104 are at least three times thinner than the second thermoelectric film 102.

Utilisation of the one or both junction interface layers 103 and 104 enables optimisation of the p-n interface 105, as mentioned above, but also implementation of a p-in junction, when the one or both junction interface layers 103 and 104 are made of thermoelectric materials having sufficiently low charge carrier concentration. The low charge carrier concentration is preferably less than 10²³ m⁻³, more preferably less than 10²² m⁻³ more preferably less than 10²¹ m⁻³. Utilisation of one or both contact interface layers 106 and 108 enables optimisation of p-n junction in particular implementation of junctions like n⁺n-pp⁺, n⁺n-p, and n-pp⁺. Utilization of the second junction interface layer 104 and the second contact interface layer 108 enables optimisation of the p-n junction such that its p- or n- portion constituted by the second thermoelectric film 102 has at least three layers and each next layer in Z direction is made of a thermoelectric material having higher charge carrier concentration than a thermoelectric material used for the previous layer. The first thermoelectric film 101 can be implemented in a similar way as the second thermoelectric film 102. Utilization of the first junction interface layer 105 and the first contact interface layer 106 enables optimisation of the p-n junction such that its n- or p- portion constituted by the first thermoelectric film 101 has at least three layers and each next layer in Z direction is made of a thermoelectric material having lower charge carrier concentration than a thermoelectric material used for the previous layer. As alternative or in addition, the properties of the first and/or the second thermoelectric films 101 and/or 102, in particular charge the carrier concentration in Z direction, may be further optimised by using stacks of layers instead of the respective bulk layers, wherein each layer of the stack is formed in a respective process and/or using respective material.

Moreover, utilisation of the junction interface layers 103 and 104 may serve a purpose of creating a contamination-free and/or low defect density interface 105 between the first and the second thermoelectric films 101 and 102. The junction interface layers 103 and 104 can be consecutively deposited without exposing a surface of one of the junction interface layers after its deposition to a contaminating environment before another one of the junction interface layers is deposited.

The layer-wise approach described above does not exclude implementation of thermoelectric films or layers having dopant concentration gradients or gradients of chemical elements altering a chemical composition such that a charge carrier density increases of decreases in a direction of the gradient. For instance, the entire thermoelectric film 101 or its junction interface layer 103 at the interface 105 can have a dopant concentration gradient in a negative Z direction, i.e., an increase in dopant concentration in a direction from the interface 105 towards the first side of the thermoelectric film 105. As alternative or in addition, the entire thermoelectric film 102 or its interface layer 103 at the interface 105 can have a dopant concentration gradient in a positive Z direction, i.e. an increase in dopant concentration in a direction from the interface 105 towards the second side of the thermoelectric film 102. Such thermoelectric films or layers can be manufactured by chemical vapor deposition (CVD) of a SiGe-based thermoelectric layer, wherein dopant precursors like phosphine or diborane are tuned during the deposition process such that the dopant concentration increases or increases throughout the layer growth. Such an approach may be of advantage for making p-n or p-i-n junctions with required interface properties. Another option for implementation the dopant concentration gradients or the gradients of the chemical elements in the first and/or the second thermoelectric films 101 and 102 is utilization of one or more coatings 121 - 124 comprising layers which act as sources of drive-in chemical element or elements which upon thermally activated diffusion are incorporated in the adjacent thermoelectric film 101 or 102 and thereby form the contact interface layers 106, 107 or 108 or alter their composition, when they were formed before the drive-in diffusion. Those skilled in the art will readily understand, that the option related to the CVD deposition and the option related to the drive-in diffusion option are compatible with each other and with other methods of forming films and layers described herein.

The thermoelectric elements 10 and 20 comprise two types of "building blocks" such as metal foil electrodes (e.g., 111, 112, 113, or 114) and thermoelectric films. The concept of the metal foil electrodes having a preferable thickness of at least 10 µm and the concept of the thermoelectric films having a preferable thickness of at least 10 µm have one important similarity. The metal foil electrodes and thermoelectric films have thick bulk portions preferably at least 10 µm thick, such as bulk layers of the thermoelectric films and metal foils of the metal foil electrodes, and thin portions such as coatings of the metal foils and the interface layers of the thermoelectric film. In contrast to the bulk portions, the coatings and the interface layers are preferably thinner than 1µm. The interface layers 106 - 108 and the coatings 121 - 124 or at least their layers adjoining each other can be deposited by one or more appropriate deposition techniques like PVD or CVD, which are very well industrialised for deposition of high-quality layers of a broad spectrum of materials. Moreover, PVD and CVD technologies enable in-situ deposition of several layers, i.e. without breaking vacuum and/or exposing individual layers to a contaminating environment (e.g., air). This is of advantage for making high-quality interfaces between adjacent layers. PVD (in particular, sputter deposition) and CVD may provide high throughput and cost-effective operation when deposition of layers thinner than 1 µm is required. PVD and CVD are rarely used when deposition of layers, particularly thermoelectric layers, thicker than 10 µm is required. This deficiency is bridged by using thick metal or metal alloy foils as ingots for metal foil electrodes. Manufacturing of these foils is also very well industrialized. The bulk layers of the thermoelectric films are formed herein by powder compaction. Thickness of the bulk layer formed by powder compaction may be at least 10µm, preferably at least 25 µm, more preferably at least 50 µm. Details of this process are discussed further.

The first and the second gaps 131 and 132 can be a slit having various shapes such as a rectangular slit, a meander-shaped slit, a sawtooth-shaped slit (triangular tooth-shaped slit), or a wave-shaped slit (e.g., a sinusoidal or cycloidal wave-shaped slit). The last three arrangements of the slit provide for an unfolded length of a slit being bigger than the width of the thermoelectric element 10 or 20 in Y direction (Figs. 1 and 2). This may be of advantage, when an internal electrical resistance of the thermoelectric element must be reduced. Regardless of a specific shape of the slit it is preferred, that it has a constant width throughout its length. This criterium may be formulated in a more rigorous way. Contours of the sidewalls of the metal foil electrodes 111 and 112 or 113 and 114 facing each other and constituting the first or the second gap 131 or 132, respectively, are congruent. Regardless of a specific shape of the slit, the width of the slit is preferably less than 1 mm.

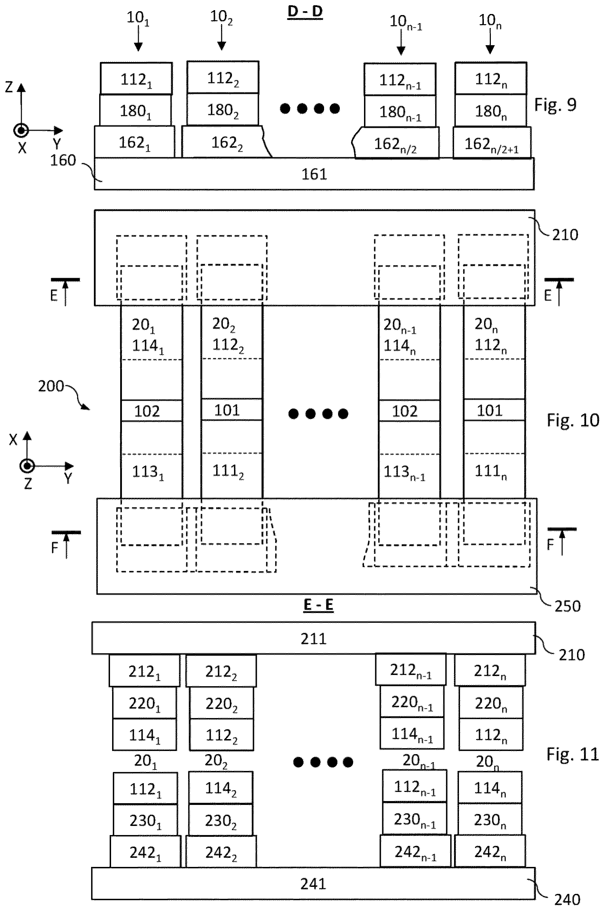

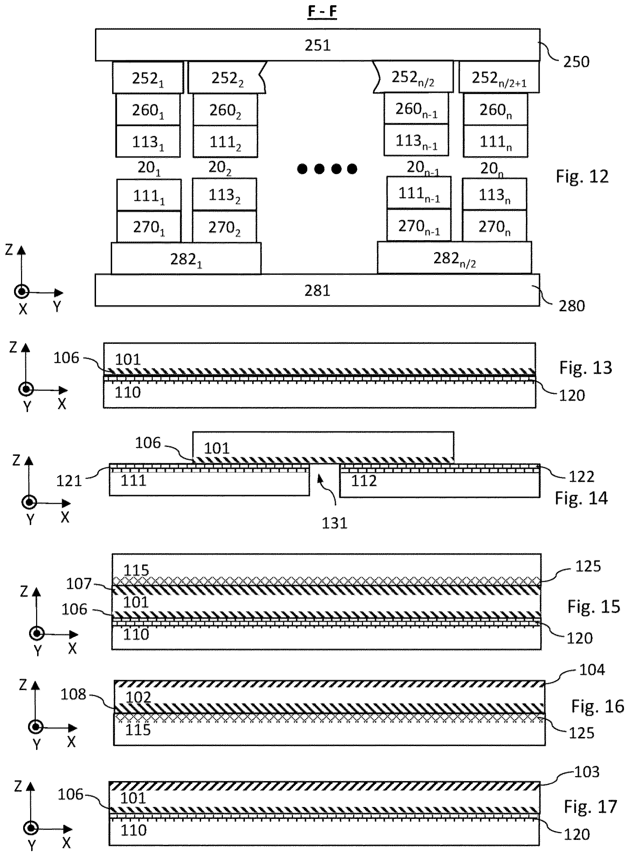

Figs. 3-6 depict example configurations 131a-d of the first gap 131 in the thermoelectric elements 10 and 20. In particular, Figs. 3 - 6 illustrate central fragments of the first and the second metal foil electrodes 111 and 112 being coloured black, wherein the other structural components are omitted merely for illustrative purposes. Fig. 3 illustrates the first gap 131 having a shape of the rectangular slit 131a. Fig. 10 illustrates the first gap 131 having a shape of the meander-shaped slit 131b. Fig. 11 illustrates the first gap131 having a shape of the sawtooth-shaped slit 131c. Fig. 12 illustrates the first gap having a shape of wave-shaped slit 131d. The same applies mutatis mutandis for the second gap 132.

For ease of reference, the thermoelectric elements 10 comprising the first thermoelectric films 101 having p-type conductivity are referred to as p-type thermoelectric elements 10 and the thermoelectric elements 10 comprising the first thermoelectric films 101 having n-type conductivity are referred to as n-type thermoelectric elements 10. The p-type and the n-type thermoelectric elements 10 can be arranged electrically in series in a thermoelectric module such that a series of the first thermoelectric films 101, which alternate in conductivity type, is formed. As a result, a voltage generated by the series of the alternating p-type and n-type thermoelectric elements 10 is a sum of voltages generated by the individual p-type and n-type thermoelectric elements 10. The serial electrical connection of the p-type and the n-type thermoelectric elements 10 is implemented using their first and second metal foil electrodes 111 and 112. One possibility for implementation of the serial electrical connection between the thermoelectric elements 10 is manufacturing the metal foil electrodes being directly electrically connected in the series as single pieces of a metal foil as depicted in Fig. 28, which is elaborated further in greater detail. The first metal foil electrodes 111 of the p-type and the n-type thermoelectric elements 10 can be arranged for thermal coupling to a heat sink. The second metal foil electrodes 112 of the p-type and the n-type thermoelectric elements 10 can be arranged for thermal coupling to a heat source. For instance, a p-type thermoelectric element 10 has its first metal foil electrode 111 electrically connected to a first metal foil electrode 111 of an n-type thermoelectric element 10 being in series immediately before said p-type thermoelectric element 10, and its second metal foil electrode 112 electrically connected to a second metal foil electrode 112 of another n-type thermoelectric element 10 being in series immediately after said p-type thermoelectric element 10, wherein said first metal foil electrodes 111 are arranged for thermal coupling to a heat sink and said second metal foil electrodes 112 are arranged for thermal coupling to a heat source. The electrical connections between pairs of the first metal foil electrodes 111 and pairs of the second metal foil electrodes 112 are implemented using only metallic conductors. A voltage generated by the thermoelectric module, when the first metal foil electrodes 111 are coupled to a heat sink and the second metal foil electrodes are coupled to a heat source 112, can be tapped from a metal foil electrode 111 or 112 of a first in series thermoelectric element 10 and a metal foil electrode 112 or 111 of a thermoelectric element 10 being the last in series, wherein said metal foil electrodes used for the voltage tapping are not used for direct electrical connection to metal foil electrodes of other thermoelectric elements 10 in the series of thermoelectric elements 10. The thermoelectric module is manufactured by electrically connecting the first metal foil electrodes and the second metal foil electrodes of the p-type and n-type thermoelectric elements 10 such that an alternating series of the first thermoelectric films having n-type conductivity and the first thermoelectric films having p-type conductivity is formed.

The thermoelectric elements 10 employing single first thermoelectric films 101 and the thermoelectric module employing these thermoelectric elements 10 can be used for heat transfer (e.g., as Peltier coolers) from a heat source (e.g., an object to be cooled) to a heat sink. In this case metal foil electrodes used for tapping the generated thermoelectric voltage are used for connecting a current source to pass a current through the thermoelectric element 10 or the series of the thermoelectric elements 10. The first metal foil electrodes 111 of the p-type and the n-type thermoelectric elements 10 are arranged for thermal coupling to a heat sink and the second metal foil electrodes 112 of the p-type and the n-type thermoelectric elements are arranged for thermal coupling to a heat source (e.g., an object to be cooled).

As mentioned above, the p-type and the n-type thermoelectric elements 10 may comprise the third and the fourth metal foil electrodes 113 and 114. The third metal foil electrodes 113 can be used in parallel with the first metal electrodes 111 for thermal coupling and/or electrical connection of the thermoelectric elements 10 and the fourth metal foil electrodes 114 can be used in parallel with the second metal electrodes 112 for thermal coupling and/or electrical connection of the thermoelectric elements 10 in the thermoelectric module for facilitating electrical and/or heat transport for both applications, i.e. electricity generation and heat transfer. Electrical connections between pairs of the third metal foil electrodes 113 and between pairs of fourth metal foil electrodes 114 of adjacent in series thermoelectric elements 10 can be implemented by manufacturing these pairs of metal foil electrodes out of single pieces of a metal foil in an analogous way as directly connected pairs of the first metal foil electrodes 111 and directly connected pairs of the second metal foil electrodes 112.

The thermoelectric elements 20 can be arranged electrically in series in a thermoelectric module such that a series of p-n or p-i-n junctions is formed, wherein the thermoelectric films of different conductivity types are alternated in the series of p-n or p-i-n junctions. As a result, a voltage generated by the series of p-n or p-i-n junctions is a sum of voltages generated by the individual thermoelectric elements. The serial electrical connection of the thermoelectric elements is implemented using the first and the third metal foil electrodes arranged 111 and 113 for thermal coupling to a heat sink. As a result, an alternating series of the first and the second thermoelectric films 101 and 102 is formed.

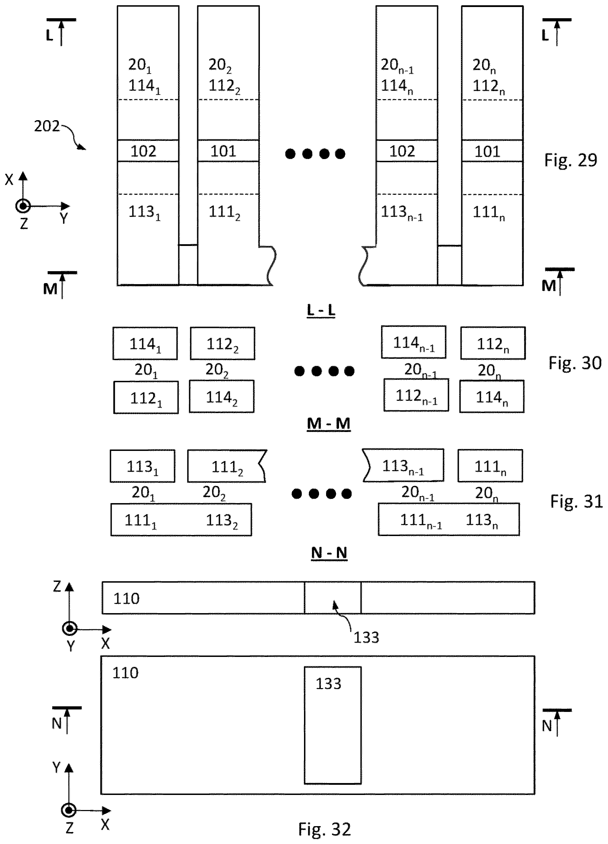

The electrical connection of any thermoelectric element 20 except the first and the last ones in the series is defined as follows: a thermoelectric element 20 has a first metal foil electrode 111 electrically connected to a third metal foil electrode 113 of another thermoelectric element 10 being in series immediately after said thermoelectric element, and a third metal foil electrode 113 electrically connected to a first metal foil electrode 111 of yet another thermoelectric element 20 being in series immediately before said thermoelectric element 20, wherein the electrical connections between the first and the third metal foil electrodes 111 and 113 of the adjacent in series thermoelectric elements 20 is implemented using only metallic conductors. A voltage generated by the thermoelectric module, when the first and/or the third metal foil electrodes are coupled to a heat sink and the second and/or the fourth metal foil electrodes are coupled to a heat source, is be tapped from a third metal foil electrode 113 of the thermoelectric element 20 being the first one in series and a first metal foil electrode 111 of the thermoelectric element 20 being the last one in series. The first metal foil electrode 111 and the third metal foil electrode 113 used for voltage tapping do not have direct electrical connections with any other metal foil electrodes 111 or 113 in the thermoelectric module. This thermoelectric module is manufactured by electrically connecting the first metal foil electrodes 111 with the third metal foil electrodes 113 of the thermoelectric elements 20 such that an alternating series of the first and the second thermoelectric films 101 and 102 is formed. As mentioned above direct electrical connections between pairs of metal foil electrodes can be implemented by manufacturing these pairs of metal foil electrodes out of single pieces of a metal foil as depicted in Figs. 29 - 31, which are elaborated further in greater detail.

The electrical connections can be also manufactured by soldering or brazing of the metal foil electrodes together or to interconnect elements. An interconnect element can be a metal wire, a metal bar, a metal stripe, or a combination thereof. The interconnect element may be or further comprise a dielectric substrate with a least one metallisation pad. The interconnect elements may be made of the same materials as used in the thermoelectric elements 10 or 20. Utilisation of the same materials in the interconnect elements and the thermoelectric elements 10 or 20 may be of advantage, because these elements exhibit substantially similar expansion at elevated temperature, when the thermoelectric module is in operation. The interconnect elements may provide electrical connections between the metal foil electrodes 111- 114 of the thermoelectric elements 10 or 20. The interconnect elements may be adapted for thermal coupling of the thermoelectric elements 10 or 20 to a heat source or a heat sink. The interconnect elements may be further adapted for affixing together the thermoelectric elements 10 or 20.

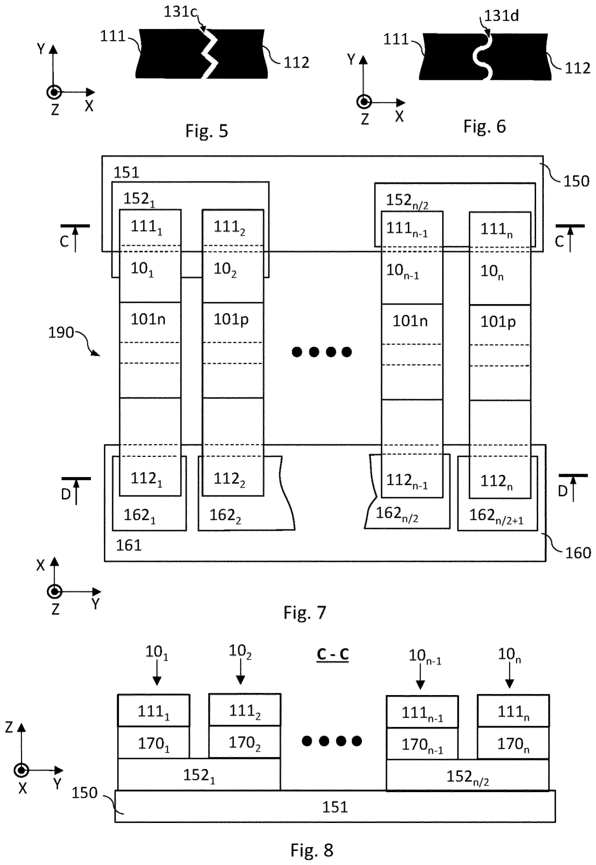

For ease of reference, reference numerals with subscript numerals are used for description of thermoelectric modules 190 and 200 depicted in Figs. 7 - 12. Reference numerals differing only by their subscript numerals refer to different thermoelectric elements (e.g., 10, 20) in a thermoelectric module (e.g., 190 and 200) or to the same structural components (e.g., 101, 102, 111-114, 152, 162, 170, 180, 212, 220, 230, 242, 252, 260, 270, 282) of or related to different thermoelectric elements (e.g., 10, 20) in a thermoelectric module (e.g., 190, 200). Subscript numerals indicate a sequence number in electrical connection and/or topological arrangement. Subscript numeral of a reference numeral specifying a thermoelectric element indicate a position of this thermoelectric element in a series of such thermoelectrical elements. The series of the thermoelectric elements encompasses topological (e.g., placement in a row-arrangement) and/or electrical arrangement (e.g., serial electrical connection) of these thermoelectric elements in a thermoelectric module. Subscript numeral of a reference numeral specifying a structural component indicate a position of this structural element in a series of such structural components. The series of the structural components encompasses topological (placement in a row-arrangement) and/or electrical arrangement of these structural components in a thermoelectric module.

Fig. 7 illustrates a thermoelectric module 190 being an example implementation of the thermoelectric module employing the p-type and the n-type thermoelectric elements 10, whereas Figs. 8 and 9 illustrate cross-sections of the thermoelectric module 190. The thermoelectric module 190 comprises a first interconnect element 150, a second interconnect element 160, p-type thermoelectric elements 10₂, 10₄, ...10ₙ₋₂, 10ₙ, and n-type thermoelectric elements 10₁, 10₃, ...10ₙ₋₃, 10ₙ₋₁, wherein n is an overall even number of the first and the second thermoelectric elements 10. The p-type thermoelectric elements 10 have even numbers 2, 4, ... n-2, n in the series of the thermoelectric elements 10. The n-type thermoelectric elements 10 have odd numbers 1, 3, ...n-3, n-1 in the series of the thermoelectric elements 10. The p-type and the n-type thermoelectric elements are arranged in a row 10₁ ... 10ₙ of alternating p-type and n-type thermoelectric elements 10 according to the numbering of the thermoelectric elements 10₁, 10₂, ...10ₙ₋₁, 10ₙ. Merely for illustrative purposes only the first two 10₁ and 10₂ and the last two 10ₙ₋₁ and 10ₙ thermoelectric elements are depicted in Figs. 7 - 9.

The first interconnect element 150 comprises a dielectric substrate 151 with a row of metallisation pads 152₁, ...152_{n/2}, wherein n/2 is an overall number of the metallisation pads on the dielectric substrate 151. Merely for illustrative purposes only the first 152₁ and the last 152_{n/2} metallisation pads are depicted in Figs. 7-9. The metallisation pads 152₁, ...152_{n/2} provide direct electrical connections (e.g., by soldering or brazing) of pairs of the first metal foil electrodes 111₁ and 111z, ... 111ₙ₋₁ and 111ₙ of adjacent thermoelectric elements 10₁ and 10₂, ... 10ₙ₋₁ and 10ₙ. Each of the first metal foil electrodes 111₁, 111₂, ... 111ₙ₋₁, 111ₙ has direct electrical connection with only one respective metallisation pad 152₁, ... 152_{n/2}. For instance, the first in the row metallisation pad 152₁ is directly electrically connected with a first metal foil electrode 111₁ of an n-type thermoelectric element 10₁ with a first thermoelectric film 101n having n-type conductivity and a first metal foil electrode 111₂ of a p-type thermoelectric element 10₂ with a first thermoelectric film 101p having p-type conductivity. The n-type thermoelectric element 10₁ is the first one in the row of the thermoelectric elements 10₁...10ₙ and the p-type thermoelectric element 10₂ is the second one in the row of the thermoelectric elements 10₁....10ₙ. The last in the row metallisation pad 152_{n/2} is directly electrically connected with a first metal foil electrode 111ₙ₋₁ of an n-type thermoelectric element 10ₙ₋₁ with a first thermoelectric film 101n having n-type conductivity and a first metal foil electrode 111ₙ of a p-type thermoelectric element 10ₙ with a first thermoelectric film 101p having p-type conductivity. The n-type thermoelectric element 10ₙ₋₁ is the penultimate one in the row of the thermoelectric elements 10₁....10ₙ and the p-type thermoelectric element 10ₙ is the last one in the row of the thermoelectric elements 10₁....10ₙ.

The thermoelectric module 190 may further comprise another first interconnect element for connecting optional third metal foil electrodes 113 of the thermoelectric elements 10₁, 10₂, ... 10ₙ₋₁, 10ₙ. The other fist interconnect element can be implemented and electrically connected to the third metal foil electrodes of the thermoelectric elements 10₁, 10₂, ... 10ₙ₋₁, 10ₙ in the same way as the first interconnect element 150 is electrically connected to the first metal foil electrodes of the thermoelectric elements 10₁, 10z, ... 10ₙ₋₁, 10ₙ.

The second interconnect element 160 comprises a dielectric substrate 161 with a row of metallisation pads 162₁, 162₂, ... 162_{n/2}, 162_{n/2+1}, wherein n/2+1 is an overall number of the metallisation pads on the dielectric substrate 161. Merely for illustrative purposes only the first metallisation pad 162₁, a fragment of the second metallisation pad 162₂, a fragment of the penultimate metallisation pad 162_{n/2}, and the last metallisation pad 162_{n/2+1} are depicted in Figs. 7-9. The metallisation pads, except the first and the last ones in the row, 162₂, 162₃, ... 162_{n/2-1}, 162_{n/2} provide direct electrical connections (e.g., by soldering or brazing) of pairs of the second metal foil electrodes 112₂ and 112₃, ... 112ₙ₋₂, 112ₙ₋₁ of adjacent thermoelectric elements, except the first and the last one in the row of the thermoelectric elements, 10₂ and 10₃, ... 10ₙ₋₂ and 10ₙ₋₁. Each of the second metal foil electrodes 112₁, 112₂, ... 112ₙ₋₁, 112ₙ has direct electrical connection with only one respective first metallisation pad 162₁, 162₂, ... 162_{n/2}, 162_{n/2+1}.

For instance, the first in the row metallisation pad 162₁ is directly electrically connected with a second metal foil electrode 112₁ of an n-type thermoelectric element 10₁ with a first thermoelectric film 101n having n-type conductivity. The second in the row metallisation pad 162₂ is directly electrically connected with a second metal foil electrode 112₂ of a p-type thermoelectric element 10₂ and a second metal foil electrode 112₃ of an n-type thermoelectric element 10₃ with a first thermoelectric film 101n having n-type conductivity. The n-type thermoelectric element 10₃ (not depicted in Figs. 7 - 9) is the third one in the row of the thermoelectric elements 10₁...10ₙ. The penultimate in the row metallisation pad 162_{n/2} is directly electrically connected with a second metal foil electrode 112ₙ₋₂ of a p-type thermoelectric element 10ₙ₋₂ with a first thermoelectric film 101p having p-type conductivity and a second metal foil electrode 112ₙ₋₁ of an n-type thermoelectric element 10ₙ₋₁ with a first thermoelectric film 101n having n-type conductivity. The p-type thermoelectric element 10ₙ₋₂ (not depicted in Figs. 7 - 9) is the third one from the end in the row of the thermoelectric elements 10₁....10ₙ and adjacent to the n-type thermoelectric element 10ₙ₋₁ being penultimate thermoelectric element in the row of the thermoelectric elements 10₁....10ₙ. The last in the row metallisation pad 162_{n/2+1} is directly electrically connected with a second metal foil electrode 112ₙ of a p-type thermoelectric element 10ₙ with a first thermoelectric film 101p having p-type conductivity.

The thermoelectric module 190 may further comprise another second interconnect element for connecting optional fourth metal foil electrodes 114 of the thermoelectric elements 10₁, 10₂, ... 10ₙ₋₁, 10ₙ. The other second interconnect element can be implemented and electrically connected to the fourth metal foil electrodes of the thermoelectric elements 10₁, 10₂, ... 10ₙ₋₁, 10ₙ in the same way as the second interconnect element 160 is electrically connected to the second metal foil electrodes of the thermoelectric elements 10₁, 10z, ... 10ₙ₋₁, 10ₙ.

The first and the second interconnect elements 150 and 160 provide for electrical chain of the series of thermoelectric elements 10₁, 10z, ... 10ₙ₋₁, 10ₙ such that the series of the first thermoelectric films 101n, 101p, ... 101n, 101p, which alternate in conductivity type, is formed. The components of electrical chain are serially connected as follows: the first metallisation pad 162₁, the second metal foil electrode 112₁, the first thermoelectric film 101n of the n-type thermoelectric element 10₁, the first metal foil electrode 111₁, the first metallisation pad 152₁, the first metal foil electrode 111z, the first thermoelectric film 101p of the p-type thermoelectric element 10₂, the second metal foil electrode 112₂, the second metallisation pad 162₂, ... the penultimate metallisation pad 162_{n/2}, the second metal foil electrode 112ₙ₋₁, the first thermoelectric film 101n of the n-type thermoelectric element 10ₙ₋₁, the first metal foil electrode 111ₙ₋₁, the last metallisation pad 152_{n/2}, the first metal foil electrode 111ₙ, the first thermoelectric film 101p of the p-type thermoelectric element 10ₙ, the second metal foil electrode 112ₙ, the last metallisation pad 162_{n/2+1}. A voltage generated by the thermoelectric module 190, when the first and/or the third metal foil electrodes are coupled to a heat sink and the second and/or the fourth metal foil electrodes are coupled to a heat source, is tapped from the metallisation pads 162₁ and 162_{n/2+1}.

The thermoelectric module 190 can be used for heat transfer (e.g., as Peltier coolers) from a heat source (e.g., an object to be cooled) to a heat sink. In this case metallisation pads 162₁ and 162_{n/2+1} used for tapping the generated thermoelectric voltage are used for connecting a current source to pass a current through the thermoelectric module 190. The first and/or the third metal foil electrodes 111 and/or 113 of the p-type and the n-type thermoelectric elements 10 are arranged for thermal coupling to a heat sink and the second and/or fourth metal foil electrodes 112 and/or 114 of the p-type and the n-type thermoelectric elements are arranged for thermal coupling to a heat source (e.g., an object to be cooled).

The first interconnect element 150 may also provide for a thermal coupling of the first metal foil electrodes 111₁ .... 111ₙ to a heat sink. The other optional first interconnect element may also provide for a thermal coupling of the optional third metal foil electrodes 113 of the thermoelectric elements 10₁, 10₂, ... 10ₙ₋₁, 10ₙ to a heat sink. One or both of these interconnect elements may also affix the thermoelectric elements 10₁, 10z, ... 10ₙ₋₁, 10ₙ in the thermoelectric module 190 thereby providing a modular structure.

The second interconnect element 160 may also provide for a thermal coupling of the second metal foil electrodes 112₁ .... 112ₙ to a heat source. The other optional second interconnect element may also provide for a thermal coupling of the optional fourth metal foil electrodes 113 of the thermoelectric elements 10₁, 10z, ... 10ₙ₋₁, 10ₙ to a heat source. One or both of these interconnect elements may also affix the thermoelectric elements 10₁, 10₂, ... 10ₙ₋₁, 10ₙ in the thermoelectric module 190 thereby providing a modular structure.

The thermoelectric module 190 can be manufactured using a soldering process or a brazing process. For instance, a surface mount soldering process can be employed for the manufacturing. A solder paste is applied to the metallisation pads 152₁, ... 152_{n/2} and 162₁, 162₂, ... 162_{n/2}, 162_{n/2+1} of the first and the second interconnect elements 150 and 160 using a stencil printing or a jet printing. In addition, the solder paste is applied to the metallisation pads of the other optional first and/or second interconnect elements when either any one or both of them are used in the thermoelectric module 190. The first and the second interconnect elements 150 and 160 are aligned relative to each other in accordance with their arrangement in the thermoelectric module 190, afterwards the thermoelectric elements 10₁, 10z, ... 10ₙ₋₁, 10ₙ are placed over the first and the second interconnect elements 150 and 160 such that the first metal foil electrodes 111₁, 111₂, ... 111ₙ₋₁, 111ₙ of the thermoelectric elements 10₁, 10z, ... 10ₙ₋₁, 10ₙ to be soldered with the metallisation pads 152₁, ... 152_{n/2} of the first interconnect element 150 are in contact with the solder paste lumps on the respective metallisation pads 152₁, ... 152_{n/2} of the first interconnect element 150 and the second metal foil electrodes 112₁, 112₂, ... 112ₙ₋₁, 112ₙ of the thermoelectric elements 10₁, 10z, ... 10ₙ₋₁, 10ₙ to be soldered with the metallisation pads 162₁, 162₂, ... 162_{n/2}, 162_{n/2+1} of the second interconnect element 160 are in contact with the solder paste lumps on the respective metallisation pads 162₁, 162₂, ... 162_{n/2}, 162_{n/2+1} of the second interconnect element 160. In the next optional step the other optional first interconnect element is placed over a stack of the first interconnect element 150 and the thermoelectric elements 10₁, 10₂, ... 10ₙ₋₁, 10ₙ such that the third metal foil electrodes of the thermoelectric elements 10₁, 10z, ... 10ₙ₋₁, 10ₙ to be soldered with the metallisation pads of the other optional first interconnect element are in contact with solder paste lumps on the respective metallisation pads of the other optional first interconnect element. When the other optional second interconnect element is used, this step further comprises placing the other optional second interconnect element over the stack of the second interconnect element and the thermoelectric elements 10₁, 10₂, ... 10ₙ₋₁, 10ₙ such that the fourth metal foil electrodes of the thermoelectric elements 10₁, 10z, ... 10ₙ₋₁, 10ₙ to be soldered with the metallisation pads of the other optional second interconnect element are in contact with the solder paste lumps on the respective metallisation pads of the other optional second interconnect element. In the last step the entire arrangement of at least the first interconnect element 150, the thermoelectric elements 10₁, 10z, ... 10ₙ₋₁, 10ₙ, and the second interconnect element 160 is processed in a solder oven at elevated temperature to produce solder connections 170₁, 170₂, ... 170ₙ₋₁, 170ₙ between the metallisation pads 152₁, ... 152_{n/2} and the metal foil electrodes 111₁, 111₂, ... 111ₙ₋₁, 111ₙ, solder connections 180₁, 180₂, ... 180ₙ₋₁, 180ₙ between the metallisation pads 162₁, 162₂, ... 162_{n/2}, 162_{n/2+1} and the second metal foil electrodes 112₁, 112₂, ... 112ₙ₋₁, 112ₙ. In addition: solder connections are made between the third metal foil electrodes and the metallisation pads of the other optional fist interconnect element, when the latter is used; and solder connections are made between the fourth metal foil electrodes and the metallisation pads of the other optional second interconnect element, when the latter is used.

The thermoelectric module 190 depicted in Figs. 7-9 comprises the even number n of the thermoelectric elements 10₁, 10z, ... 10ₙ₋₁, 10ₙ. The even number is selected merely for illustrative purposes. Those skilled in the art will readily understand that only minor modifications of the thermoelectric module 190 are required to adapt it such that it employs an odd number of the thermoelectric elements 10. For instance, such an adaptation can be performed by removing the last thermoelectric element 10ₙ and the last metallization pad 162_{n/2+1} in the thermoelectric module 190. As a result, the first metallization pad 162₁ and the last metallization pad 152_{n/2} are used for tapping a voltage generated by the modified thermoelectric module, when used for electricity generation, or passing an electrical current, when used for heat transfer.

Fig. 10 illustrates a thermoelectric module 200 being an example implementation of the thermoelectric module employing thermoelectric elements 20 having p-n or p-i-n junctions, whereas Figs. 11 and 12 illustrate cross-sections of the thermoelectric module 200. The thermoelectric module 200 comprises a first interconnect element 280, a second interconnect element 250, thermoelectric elements 20₁, 20₂,...20ₙ₋₁, 20ₙ each employing p-n or p-i-n junction, wherein n is an overall even number of the thermoelectric elements 20 used in the thermoelectric module 200. The thermoelectric elements 20₁, 20₂, ... 20ₙ₋₁, 20ₙ are arranged in a row according to their numbering. Merely for illustrative purposes only the first two 20₁ and 20₂ and the last two 20ₙ₋₁ and 20ₙ thermoelectric elements are depicted in Figs. 10 - 12.

The first interconnect element 280 comprises a dielectric substrate 281 with a row of metallisation pads 282₁, ...282_{n/2}, wherein n/2 is an overall number of the metallisation pads on the dielectric substrate 281. Merely for illustrative purposes only the first 282₁ and the last 282_{n/2} metallisation pads are depicted in Figs. 11 and 12. The metallisation pads 282₁, ...282_{n/2} provide direct electrical connections (e.g., by soldering or brazing) of pairs of the first and the third metal foil electrodes 111₁ and 113₂, ... 111ₙ₋₁ and 113ₙ of adjacent thermoelectric elements 20₁ and 20₂, ... 20ₙ₋₁ and 20ₙ. Each of the first metal foil electrodes 111₁, 111₃, ... 111ₙ₋₁ of the thermoelectric elements 20₁, 20₃, ... 20ₙ₋₁ having odd numbers in the row has direct electrical connection with only one respective metallisation pad 282₁, ... 282_{n/2}. Each of the third metal foil electrodes 113₂, 113₄, ... 113ₙ of the thermoelectric elements 20₂, 20₄, ... 20ₙ having even numbers in the row has direct electrical connection with only one respective metallisation pad 282₁, ... 282_{n/2}. For instance, the first in the row metallisation pad 282₁ is directly electrically connected with a first metal foil electrode 111₁ being in direct contact with a first thermoelectric film 101 of a thermoelectric element 20₁, and a third metal foil electrode 113₂ being in direct contact with a second thermoelectric film 102 of a thermoelectric element 20₂. The thermoelectric element 20₁ is the first one in the row of the thermoelectric elements 20₁...20ₙ and the thermoelectric element 20₂ is the second one in the row of the thermoelectric elements 20₁....20ₙ. The last in the row metallisation pad 282_{n/2} is directly electrically connected with a first metal foil electrode 111ₙ₋₁ being in direct contact with a first thermoelectric film 101 of a thermoelectric element 20ₙ₋₁, and a third metal foil electrode 111ₙ being in direct contact with a second thermoelectric film 102 of a thermoelectric element 20ₙ. The thermoelectric element 20ₙ₋₁ is the penultimate one in the row of the thermoelectric elements 20₁....20ₙ and the thermoelectric element 20ₙ is the last one in the row of the thermoelectric elements 20₁ ... 20ₙ.

The second interconnect element 250 comprises a dielectric substrate 251 with a row of metallisation pads 252₁, 252₂, ... 252_{n/2}, 252_{n/2+1}, wherein n/2+1 is an overall number of the second metallisation pads on the dielectric substrate 251. Merely for illustrative purposes only the first metallisation pad 252₁, a fragment of the second metallisation pad 252₂, a fragment of the penultimate metallisation pad 252_{n/2}, and the last metallisation pad 252_{n/2+1} are depicted in Figs. 11 and 12. The metallisation pads, except the first and the last ones in the row, 252₂, 252₃, ... 252_{n/2-1}, 252_{n/2} provide direct electrical connections (e.g., by soldering or brazing) of pairs of the first and the third metal foil electrodes 111₂ and 111₃, ... 111ₙ₋₂ and 113ₙ₋₁ of adjacent thermoelectric elements, except the first and the last one in the row of the thermoelectric elements, 20z and 20₃, ... 20ₙ₋₂ and 20ₙ₋₁. Each of the first metal foil electrodes 111₂, 111₄, ... 111ₙ of the thermoelectric elements 20₂, 20₄, ... 20ₙ having even numbers in the row has direct electrical connection with only one respective metallisation pad 252₂, ... 252_{n/2+1} of the row of the metallisation pads 252₁, 252₂, ... 252_{n/2}, 252_{n/2+1} except the first one in the row. Each of the third metal foil electrodes 113₁, 113₃, ... 113ₙ₋₃, 113ₙ₋₁ of the thermoelectric elements 20₁, 20₃, ... 20ₙ₋₃, 20ₙ₋₁ having odd numbers in the row has direct electrical connection with only one respective metallisation pad 252₁, ... 252_{n/2} of the row of the metallisation pads 252₁, 252₂, ... 252_{n/2}, 252_{n/2+1} except the last one in the row. The metallisation pad 252₁ being the first in the row of the metallisation pads 252₁, 252₂, ... 252_{n/2}, 252_{n/2+1} is directly electrically connected only with the third metal foil electrode 113₁ of the thermoelectric element 20₁ being the first in the row of the thermoelectric elements 20₁ ... 20ₙ. The metallisation pad 252_{n/2-1} being the last in the row of the metallisation pads 252₁, 252₂, ... 252_{n/2}, 252_{n/2+1} is directly electrically connected only with the first metal foil electrode 111₁ of the thermoelectric element 20ₙ being the first in the row of the thermoelectric elements 20₁ ... 20ₙ.

The thermoelectric module 200 may further comprise a third interconnect element 240 and/or a fourth interconnect element 210. These interconnect elements do not provide electrical connections between metal foil electrodes of different thermoelectric elements. They may be arranged for thermal coupling of the second and the fourth metal foil electrodes of the thermoelectric elements 20₁ ... 20ₙ to a heat source and/or for affixing the thermoelectric elements 20₁ ... 20ₙ in the thermoelectric module 200 thereby providing a modular structure. The first interconnect element 280 may be arranged for a thermal coupling of the first metal foil electrodes 111₁, 111₃, ... 111ₙ₋₁ and the third metal foil electrodes 113₂, 113₄, ... 113ₙ to a heat sink and/or for affixing the thermoelectric elements 20₁ ... 20ₙ in the thermoelectric module 200 thereby providing a modular structure. The second interconnect element 250 may be arranged for a thermal coupling of the first metal foil electrodes 111₂, 111₄, ... 111ₙ and the third metal foil electrodes 113₁, 113₃, ... 113ₙ₋₃, 113ₙ₋₁ to a heat sink and/or for affixing the thermoelectric elements 20₁ ... 20ₙ in the thermoelectric module 200 thereby providing a modular structure.

For instance, the third interconnect element 240 can be implemented as follows. A row of metallisation pads 242₁, 242₂, ... 242ₙ₋₁, 242ₙ is arranged on a dielectric substrate 241 of the third interconnect element 240, wherein n is the overall number of the metallisation pads 242₁, 242₂, ... 242ₙ₋₁, 242ₙ. Merely for illustrative purposes only the first metallisation pad 242₁, the second metallisation pad 242₂, the penultimate metallisation pad 242ₙ₋₁, and the last metallisation pad 242ₙ are depicted in Figs. 11 and 12. A metallisation pad 242ₖ having any odd number k is directly electrically connected (e.g., by soldering or brazing) only with a second metal foil electrode 112ₖ of a thermoelectric element 20ₖ having the same odd number k. A metallisation pad 242ₘ having any even number m is directly electrically connected (e.g., by soldering or brazing) only with a fourth metal foil electrode 114ₘ of a thermoelectric element 20ₘ having the same even number m.

For instance, the fourth interconnect element 210 can be implemented as follows. A row of metallisation pads 212₁, 212₂, ... 212ₙ₋₁, 212ₙ is arranged on a dielectric substrate 211 of the fourth interconnect element 210, wherein n is the overall number of the metallisation pads 242₁, 242₂, ... 242ₙ₋₁, 242ₙ. Merely for illustrative purposes only the first metallisation pad 212₁, the second metallisation pad 212₂, the penultimate metallisation pad 212ₙ₋₁, and the last metallisation pad 212ₙ are depicted in Figs. 11 and 12. A metallisation pad 212ₖ having any odd number k is directly electrically connected (e.g., by soldering or brazing) only with a fourth metal foil electrode 114ₖ of a thermoelectric element 20ₖ having the same odd number k. A metallisation pad 212ₘ having any even number m is directly electrically connected (e.g., by soldering or brazing) only with a second metal foil electrode 112ₘ of a thermoelectric element 20ₘ having the same even number m.

The first and the second interconnect elements 280 and 250 provide for electrical chain of the series of thermoelectric elements 20₁, 20₂, ... 20ₙ₋₁, 20ₙ such that the series of p-n or p-i-n diodes are formed, wherein thermoelectric films 101 and 102 alternate in this series. In other words, a p-portion of a diode is connected to an n-portion of another diode being the next one in the series. The components of electrical chain are serially connected as follows: the first metallisation pad 252₁, the third metal foil electrode 113₁, the second thermoelectric film 102 of the first thermoelectric element 20₁, the first thermoelectric film 101 of the first thermoelectric element 20₁, the first metal foil electrode 111₁, the first metallisation pad 282₁, the third metal foil electrode 113₂, the second thermoelectric film 102 of the second thermoelectric element 20₂, the first thermoelectric film 101 of the second thermoelectric element 20₂, the first metal foil electrode 111₂, the second metallisation pad 252₂, ... the penultimate metallisation pad 252_{n/2}, the third metal foil electrode 113ₙ₋₁, the second thermoelectric film 102 of the penultimate thermoelectric element 20ₙ₋₁, the first thermoelectric film 101 of the penultimate thermoelectric element 20ₙ₋₁, the first metal foil electrode 111ₙ₋₁, the last metallisation pad 282_{n/2}, the third metal foil electrode 113ₙ, the second thermoelectric film 102 of the last thermoelectric element 20ₙ, the first thermoelectric film 101 of the last thermoelectric element 20ₙ, the first metal foil electrode 111ₙ, the last metallisation pad 252_{n/2+1}. A voltage generated by the thermoelectric module 200, when the first and/or the third metal foil electrodes are coupled to a heat sink and the second and/or the fourth metal foil electrodes are coupled to a heat source, is tapped from the metallisation pads 252₁ and 252_{n/2+1}.

The thermoelectric module 200 can be manufactured using a soldering process or a brazing process. For instance, a surface mount soldering process can be employed for the manufacturing. A solder paste is applied to the metallisation pads 282₁, ... 282_{n/2} and 252₁, ... 252_{n/2+1} of the first and the second interconnect elements 280 and 250 using a stencil printing or a jet printing. In addition, the solder paste is applied to the metallisation pads 242₁, ... 242ₙ and 212₁, ... 212ₙ of the other optional third and/or fourth interconnect elements when either any one or both of them are used in the thermoelectric module 200. In the next step the thermoelectric elements 20₁, 20₂, ... 20ₙ₋₁, 20ₙ are placed over the first interconnect element 280 such that the first and the third metal foil electrodes 111₁, 111₃, ... 111ₙ₋₁ and 113₂, 113₄, ...113ₙ to be soldered with the metallisation pads 282₁, ... 282_{n/2} of the first interconnect element 280 are in contact with the solder paste lumps on the respective metallisation pads 282₁, ... 282_{n/2} of the first interconnect element 280. In case the thermoelectric module 200 comprises the third interconnect element 240, this step is performed in a different way. The first and the third interconnect elements 280 and 240 are aligned relative to each other in accordance with their arrangement in the thermoelectric module 200, afterwards the thermoelectric elements 20₁, 20₂, ... 20ₙ₋₁, 20ₙ are placed over the first and the third interconnect elements 280 and 240 such that the first and the third metal foil electrodes 111₁, 111₃, ... 111ₙ₋₁ and 113₂, 113₄, ...113ₙ to be soldered with the metallisation pads 282₁, ... 282_{n/2} of the first interconnect element 280 are in contact with the solder paste lumps on the respective metallisation pads 282₁, ... 282_{n/2} of the first interconnect element 280 and the second and the fourth metal foil electrodes 112₁, 112₃, ... 112ₙ₋₁ and 114₂, 114₄, ...114ₙ to be soldered with the metallisation pads 242₁, ... 242ₙ of the third interconnect element 240 are in contact with the solder paste lumps on the respective metallisation pads 242₁, ... 242ₙ of the third interconnect element 240. In the next step the second interconnect element 250 is placed over a stack of the first interconnect element 280 and the thermoelectric elements 20₁, 20₂, ... 20ₙ₋₁, 20ₙ such that the first and the third metal foil electrodes 111₂, 111₄, ... 111ₙ and 113₁, 113₃, ...113ₙ₋₁ to be soldered with the metallisation pads 252₁, ... 252_{n/2+1} of the second interconnect element 250 are in contact with solder paste lumps on the respective metallisation pads 252₁, ... 252_{n/2+1} of the second interconnect element 250. When the fourth interconnect element 210 is used, this step further comprises placing the fourth interconnect element 210 over the stack of the third interconnect 240 element and the thermoelectric elements 20₁, 20₂, ... 20ₙ₋₁, 20ₙ such that the second and the fourth metal foil electrodes 112₂, 112₄, ... 112ₙ and 114₁, 114₃, ...114ₙ₋₁ to be soldered with the metallisation pads 212₁, 212₂, ... 212ₙ₋₁, 212ₙ of the fourth interconnect element 210 are in contact with the solder paste lumps on the respective metallisation pads 212₁, 212₂, ... 212ₙ₋₁, 212ₙ of the fourth interconnect element 210. In the last step the entire arrangement of at least the first interconnect element 280, the thermoelectric elements 20₁, 20₂, ... 20ₙ₋₁, 20ₙ, and the second interconnect element 250 is processed in a solder oven at elevated temperature to produce solder connections 270₁, 270₂, ... 270ₙ₋₁, 270ₙ between the metallisation pads 282₁, ... 282_{n/2} and the first and the third metal foil electrodes 111₁, 111₃, ... 111ₙ₋₁ and 113₂, 113₄, ...113ₙ, solder connections 260₁, 260₂, ... 260ₙ₋₁, 260ₙ between the metallisation pads 252₁, 252₂, ... 252_{n/2}, 252_{n/2+1} and the first and the third metal foil electrodes 111₂, 111₄, ... 111ₙ and 113₁, 113₃, ...113ₙ₋₁. In addition: solder connections 230₁, 230₂, ... 230ₙ₋₁, 230ₙ are made between the second and the fourth metal foil electrodes 112₁, 112₃, ... 112ₙ₋₁ and 114₂, 114₄, ... 114ₙ and the metallisation pads 242₁, 242₂, ... 242ₙ₋₁, 242ₙ of the third interconnect element 240, when the latter is used; and solder connections 220₁, 220₂, ... 220ₙ₋₁, 220ₙ are made between the second and the fourth metal foil electrodes 112₂, 112₄, ... 112ₙ and 114₁, 114₃, ... 114ₙ₋₁ and the metallisation pads 212₁, 212₂, ... 212ₙ₋₁, 212ₙ of the fourth interconnect element 210, when the latter is used.

The thermoelectric module 200 depicted in Figs. 10 - 12 comprises the even number of the thermoelectric elements 20₁, 20₂, ... 20ₙ₋₁, 20ₙ. The even number is selected merely for illustrative purposes. Those skilled in the art will readily understand that only minor modifications of the thermoelectric module 200 are required to adapt it such that it employs an odd number of the thermoelectric elements 10. For instance, such an adaptation can be performed by removing the thermoelectric element 20ₙ and the last metallization pad 252_{n/2+1} in the thermoelectric module 200. As a result, the first metallization pad 252₁ and the last metallization pad 282_{n/2} are used for tapping a voltage generated by the modified thermoelectric module, when used for electricity generation, or passing an electrical current, when used for heat transfer.

Brazing process may be used instead of the soldering process in the manufacturing processes of the thermoelectric modules (e.g., 190, 200). In this case a filler material is used instead of the solder paste and a furnace for brazing process is used instead of the oven. In contrast to the oven, the furnace performs the brazing process at higher temperature than the temperature of the soldering process and may provide as an option an inert atmosphere.

Fig. 29 illustrates a thermoelectric module 202 being an example implementation of the thermoelectric module employing thermoelectric elements 20 having p-n or p-i-n junctions, whereas Figs. 30 and 31 illustrate cross-sections of the thermoelectric module 202. The thermoelectric elements 20 of the thermoelectric module 202 are electrically connected in the same way as the thermoelectric elements 20 in the thermoelectric module 200 depicted in Fig. 10. However, the electrical connections between thermoelectric elements 20 are implemented by manufacturing pairs of the adjacent in series first and second metal foil electrodes out of single pieces of metal foil. This eliminates the need to use interconnect elements and soldering or brazing. As can be seen from Figs. 29 - 31 the first metal foil electrode 111₁ of the first in series thermoelectric element 20₁ and the third metal foil electrode 113₂ of the second in series thermoelectric element 20₂ are made from a single metal foil piece. The first metal foil electrode 111ₙ₋₁ of the penultimate in series thermoelectric element 20ₙ₋₁ and the third metal foil electrode 113ₙ of the last in series thermoelectric element 20ₙ are made from a single metal foil piece. The same applies for the other pairs of the first and the third metal foil electrodes which are not depicted in Figs. 29 - 31: 111₂ and 113₃,...111ₙ₋₂ and 113ₙ₋₁.

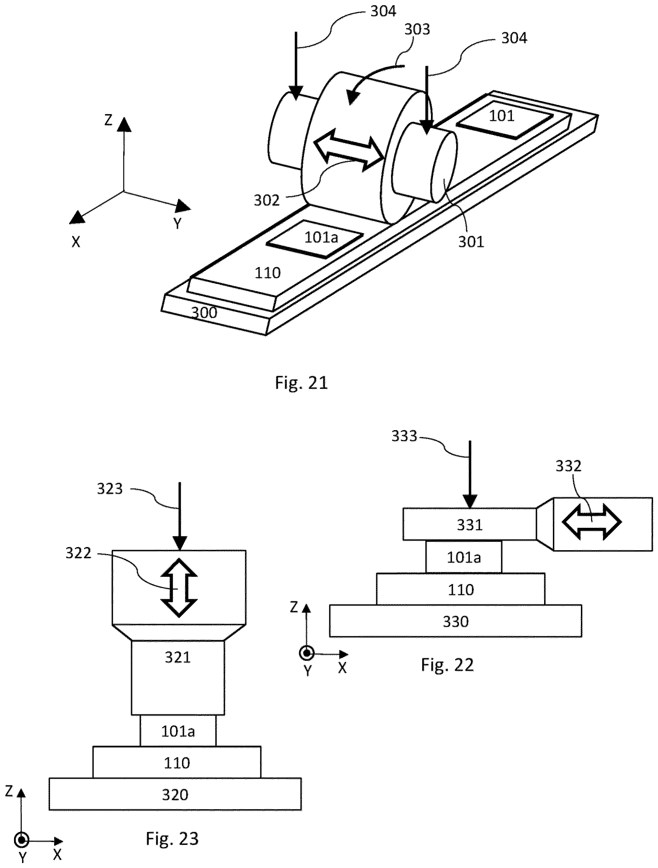

Forming of a layer of the first or the second thermoelectric film 101 or 102 or the entire first or second thermoelectric film 101 or 102 can be performed by one of the following processes:
a) **PVD** As option, a surface can be cleaned and/or activated, e.g. by plasma or ion beam, prior to the deposition of a layer or film to improve an interface between the surface and the deposited layer or film. Such an improvement may include improvement of an adhesion and/or producing a contamination-free interface. Another option is annealing of the deposited film. The annealing may provide for an improved crystal structure, e.g. reduction of vacancies, dislocations, improvement of short- or long-range order. For instance, PVD can be used for depositing of Bi₂Te₃ based thermoelectric layers.
b) **CVD** As option, surface can be cleaned and/or activated, e.g. by plasma, ion beam, or forming gas, prior to the deposition of a layer or film to improve an interface between the surface and the deposited layer or film. Such an improvement may include improvement of an adhesion and/or producing a contamination-free interface. Another option is annealing of the deposited film. The annealing may provide for an improved crystal structure, e.g. reduction of vacancies, dislocations, improvement of short- or long-range order. For instance, CVD can be used for depositing SiGe based thermoelectric layers.
c) **PRINTING** Inks can be printed using techniques such as inkjet, screen printing, aerosol jet printing, or drop printing, etc. Pastes can be printed by screen printing or drop printing. A thickness of a printed layer can be determined by a doctor blade. As option, a surface can be cleaned and/or activated and/or functionalised, e.g. by plasma, ion beam, or forming gas, poly(dimethylsiloxane) (PDMS) treatment, to improve an interface between the surface and the printed layer or film. Such an improvement may include improvement of an adhesion and/or producing a contamination-free interface. The printed film of layer can be dried, and the dried film can be annealed. Pressure can be applied to a surface to the printed film at a certain point of time during the drying process to improve properties of the layer or film. The point in time may be a point of time after 30% of a time interval of the drying process is elapsed and/or before 50% of this time interval is elapsed or a point of time after 40 % of a solvent in the ink or paste is evaporated and/or before 60% of solvent in the ink or paste is evaporated. In addition, or as alternative, the drying may be performed at an elevated temperature and/or with ultrasonic assistance. Application of pressure with optional heating and/or optional ultrasonic assistance can be performed using tools depicted in in Figs. 21 - 23, which are further elaborated in greater detail. Printing may be employed for organic, metal-organic, hybrid organic-inorganic, and organic-inorganic mixture thermoelectric materials. Printing, and/or drying, and/or annealing may be performed in an inert gas atmosphere.
d) **POWDER PRESSURE-COMPACTING** A powder of a thermoelectric material can be provided on a surface in a dry form. Alternatively, an ink containing a powder of a thermoelectric material can be printed on a surface, wherein the ink is dried prior to the pressure-compacting of the powder, e.g. by evaporating binder and/or solvent of the ink. After providing the powder in a dry form or after drying the ink the powder is pressure compacted. The pressure-compacting can be performed by cold- or hot-pressing, or roll-pressing. These processes may be performed with ultrasonic assistance and/or in an inert gas atmosphere. The tools depicted in Figs. 21- 23 can be employed for the pressure-compacting. The pressure-compacting of powders of inorganic thermoelectric materials are performed preferably on flat surfaces, whereas the pressure-compacting of powders of organic, metal-organic, hybrid organic-inorganic, and organic-inorganic mixture thermoelectric materials can per performed on flat surfaces and structured surfaces having height variation in vertical direction, i.e. Z-direction in the Figures. As option, the surface can be cleaned and/or activated and/or functionalised, e.g. by plasma, ion beam, or forming gas, poly(dimethylsiloxane) (PDMS) treatment, to improve an interface between the surface and the pressure-compacted powder. Prior to the pressure-compaction the powder can be degassed in an inert gas atmosphere or deoxidised, e.g. in a forming gas. The pressure-compacted powder can be annealed, preferably in an inert gas atmosphere.
e) **SPIN COATING** Layers, films, stacks of layers and/or films of thermoelectric materials, e.g. organic, metal-organic, hybrid organic-inorganic, and organic-inorganic mixture thermoelectric materials, can be spin coated on dummy wafers or metal foils used for manufacturing of metal foil electrodes. The layers, films, stacks of layers and/or films of thermoelectric materials formed a dummy wafer can be delaminated from the dummy wafer and laminated to other layers, films or metal foils or metal foil electrodes. Organic, metal-organic, hybrid organic-inorganic, and organic-inorganic mixture thermoelectric materials can be spin coated. As option, a surface of dummy wafer can be pretreated to avoid contamination and/or facilitate delamination. As option, a surface of a metal foil or a metal foil electrode can be cleaned and/or activated and/or functionalised, e.g. by plasma, ion beam, or forming gas, poly(dimethylsiloxane) (PDMS) treatment, to improve adhesion and/or avoid contamination. The spin coating may be performed in an inert gas atmosphere.
f) **LMINATION OF FILMS OR LAYERS** Premanufactured layers, films, stacks of layers and/or films of thermoelectric materials, or such stacks on metal foils or metal foil electrodes can be laminated to surfaces of other films, layers, metal foils, or metal foil electrodes. The lamination can be performed by pressing or roll-pressing. These processes may be performed with ultrasonic assistance and/or in an inert gas atmosphere and/or at elevated temperatures, e.g. using the tools depicted in Figs. 21 - 23. As option, the surfaces to be laminated together can be cleaned and/or activated and/or functionalised, e.g. by plasma, ion beam, or forming gas, poly(dimethylsiloxane) (PDMS) treatment prior to the lamination, to improve an interface between the surface and the laminated layer, film, or a stack of one or more layers and/or one or more films. Such an improvement may include improvement of an adhesion and/or producing a contamination-free interface. After lamination an optional annealing process can be performed preferably in an inert gas atmosphere. The process of lamination can be combined with processes of layer or film formation. For instance, a powder of a thermoelectric material can be provided as a powder layer between two surfaces of thermoelectric element components. Afterwards it can be pressure-compacted as described process d), wherein powder particles are not only compacted as a film or a layer but adhered to these surfaces. As a result, the formed layer or film is bonded to these surfaces. The lamination of a printed layer or film to a surface of another component can also be combined with its drying process, which is described above in point c). In this case the not yet fully dried printed layer or film is covered by the other component and the lamination process is performed. For instance, a printed layer or film can be laminated to the surface of the component, e.g. at a point in time after 30% of a time interval of the drying process is elapsed and/or before 50% of this time interval is elapsed or at a point of time after 40 % of a solvent in the ink or paste is evaporated and/or before 60% of solvent in the ink or paste is evaporated.
g) **AEROSOL DEPOSITION METHOD (ADM)** A powder of a thermoelectric material can be deposited on a surface in a dry form using ADM. ADM are tools operable for depositing layers of materials out of dry particles may employ a fluidized bed aerosol generator or blush generator for aerosol generation, wherein aerosol may be delivered via a nozzle (e.g. a convergent nozzle or de Laval nozzle), which accelerates particles to final velocity on to the surface. Prior to the deposition the powder can be degassed in an inert gas atmosphere or deoxidised, e.g. in a forming gas. ADM deposition can be performed in an inert gas atmosphere, wherein the inert gas is used for the aerosol generation. As option, the surface can be cleaned and/or activated and/or functionalised, e.g. by plasma, ion beam, or forming gas, poly(dimethylsiloxane) (PDMS) treatment, to improve an interface between the surface and the pressure-compacted powder. A deposited film or layer can be annealed, preferably in an inert gas atmosphere.

Selection of the aforementioned processes for forming specific layers or films complies with process integration rules. In particular, materials aspects must be considered for process integration. For instance, pressure compaction of powders, in particular powders of inorganic materials, in process d) may require high pressures and/or high temperatures, thus metal foils and optional layers and/or coatings thereon must be compatible with the pressure-compaction process. In this case layers produced by CVD or PVD may be preferred as metal electrode coating layers, contact interface layers of thermoelectric films, and/or junction interface layers of thermoelectric films. In general, previously formed layers and/or films must be compatible with a process of forming a layer or a film on the previously formed layers. It is important to notice, that the same thermoelectric materials can be formed using different processes. Some processes advantageous for forming hight quality interface layers, e.g. depositing SiGe thermoelectric layers by CVD or depositing Bi₂T₃-based thermoelectric layers by magnetron sputtering. On the other hand, pressure compacting of powders may be advantageous for forming thick bulk layers. PEDTO:PSS-based thermoelectric layers or films of p- or n-type can be deposited by inkjet, aerosol jet printing, or spin coating. Selection of an appropriate deposition process can target specific objective, i.e. optimization of one or more of the following: layer of film interface quality, electrical conductivity, thermal conductivity, or Seebeck voltage.

Figs. 13 - 19 illustrate methods of manufacturing of the thermoelectric element 10 employing single thermoelectric films and methods of manufacturing of the thermoelectric element 20 employing p-n or p-i-n junction. These figures illustrate cross-sections of the thermoelectric element 10 or 20 at different stages of its manufacturing. The method comprises forming the first thermoelectric film 101 on a first metal foil 110 (Fig. 13). The first metal foil and the first thermoelectric film 101 have planar interface. The thermoelectric film 101 may be formed directly on the first metal foil 110 or its first coating 120. The first coating 120 comprises one or more of the following layers: an adhesion layer, a diffusion barrier layer, a work function setting layer, or an interface layer for reduction of a thermal and/or an electrical resistance between a metal foil electrode and a thermoelectric film. In case the first coating 120 comprises more than one layer, the layers of the first coating 120 are stacked on top of each other. Specific examples of the layers of the first coating 120 are provided above. The layer or layers of the first coating 120 may be formed using CVD and/or PVD. The first thermoelectric film 101 may be formed using any one of the processes a) - g).

The first thermoelectric film 101 may be annealed. The annealing may be performed in vacuum and/or inert gas atmosphere. The annealing may be used for improving crystal structure of the first thermoelectric film 101. For instance, Bi₂Te₃-based thermoelectric materials can be annealed at a temperature in a range of 220 - 240 degrees Celsius for at least 10 hours. The annealing may be used to drive dopants from a dopant source layer of the first coating 120 into the first thermoelectric film 101 to form the first contact interface layer 106 or to change its properties, if formed prior to the annealing. For instance, a copper metal foil 110 with a nickel coating 120 functions as a drive-in source of p-type nickel dopant for a Bi₂Te₃-based thermoelectric layer when a stack of the metal foil 110 and the adjoining first thermoelectric film 101 is heated above 200 degrees Celsius. In case of a SiGe-based thermoelectric film 101 a coating comprising one or more of the following elements Li, Sb, P, or As can be used for drive-in n-doping and a coating comprising one or more of the following elements B, Al, or Ga can be used for drive-in p-doping.

The forming of the first thermoelectric film 101 may comprise forming its contact interface layer 106 and its bulk layer using the same or different processes. For instance, the forming of the first thermoelectric film 101 may comprise pressure-compacting of a first powder of a first thermoelectric material on the first metal foil 110 to form the entire first thermoelectric layer 101 or its bulk layer. In the latter case the forming of the first thermoelectric layer further comprises forming a first contact interface layer 106 directly on the first metal foil 110 or its first coating 120, when the latter is used. In turn, the bulk layer of the first thermoelectric film 101 is formed directly on the first contact interface layer 106. Employing of the powder pressure-compacting for forming the first thermoelectric film 101 or its bulk layer results in the planar first thermoelectric film 101 or its planar bulk layer respectively, which have their opposite sides parallel to each other. The planar first thermoelectric film 101 or its planar bulk layer may be structured at later manufacturing steps. The first contact interface layer 106 may be formed using PVD and/or CVD. As mentioned above a stack of layers may be used instead of the first contact interface layer 106, wherein the layers of the stack are deposited using dedicated PVD and/or CVD processes and/or have different chemical compositions. As alternative any of these processes can be used form forming the bulk layer. This option may be less preferred, because forming thick bulk layers (e.g., more than 10 µm) by PVD or CVD may have a long duration. As another alternative the contact interface layer 106 and the bulk layer may be formed by any one of the processes c), e), f), or g) using different precursors, e.g. inks, for each layer.

The pressure-compacted first thermoelectric film 101 is directly attached to the first metal foil 110 or its pressure-compacted bulk layer is directly attached to the first contact interface layer 106. In other words, the pressure-compacting of the first powder not only binds the particles of the first powder together, but also binds these particles to the surface of the first metal foil 110 or the surface of a top layer on the first metal foil 110. The first coating 120 may comprise an adhesion layer for facilitating the binding of the pressure-compacted powder to it. A material of the adhesion layer and a material of the first thermoelectric film or of the powder used for its forming may comprise at least one common chemical element and the atomic concentrations of this common element in these materials differ by less than 10%, preferably by less than 5%. Preferably the adhesion layer and the powder to be compacted thereon are made using the same source material. In this case, the adhesion layer and the compacted powder layer or film are made of the same chemical elements, the atomic concentrations of which differ by less than 10% in the adhesion layer and the compacted powder layer or film. For instance, the same powder can be used for the pressure-compacting on the adhesion layer and for the sputtering target used to deposit the adhesion layer. The first contact interface layer 106 may facilitate the binding of the pressure-compacted powder of the bulk layer of the first thermoelectric film 101 in a similar way. However, in contrast to the materials of the pair of the adhesion layer of the first coating 120 and the first thermoelectric film 101 the materials of the bulk and first contact interface layer may have more structural and chemical similarity, because in contrast to the adhesion layer the first contact interface layer 106 not only facilitates the adhesion of the powder of the first thermoelectric material but also has thermoelectric properties. In particular, the bulk layer and first contact interface layer 106 of the first thermoelectric film 101 may have the same crystallographic phase and/or consist of the same chemical elements, wherein the atomic concentrations of the chemical elements in these layers differ by less than 2 %, preferably by less than 1 %.

As mentioned above the stack of layers may be used instead of the single bulk layer. In this case each layer of the stack is formed in a separate pressure-compacting process using the first powder. Alternatively different powders of different thermoelectric materials can be used for respective layers of the stack. The latter approach can be used when the first thermoelectric film 101 or at least its bulk layer is formed using thermoelectric materials having different charge carrier concentrations. The stack of the layers may also be formed by any one of the processes c), e), f) or g) using different precursors, e.g. inks, for each layer

The pressure-compacting may be performed by at least one of the following processes: hot pressing, hot pressing with ultrasonic assistance, roll-compacting, or roll-compacting with ultrasonic assistance and/or at elevated temperature. The powder or powders used for the pressure-compacting may be deoxidized and/or degassed prior to the pressure-compacting, which in turn may be performed in vacuum and/or inert gas atmosphere to prevent oxidation and/or contamination of the powder during the pressure-compacting. Degassing and/or deoxidation of the powder may be performed at an elevated temperature in vacuum and/or inert gas. Alternatively, or as an additional process step degassing and/or deoxidation may be performed at elevated temperature in a forming gas being a mixture hydrogen and nitrogen.

The powder for the pressure-compacting process of the first thermoelectric film 101, or its bulk layer, or a layer of the stack of layers used instead of the single bulk layer may be provided in dry form on the surface of the first metal foil 110 or the surface of a top layer of the first coating 120 or the first contact interface layer 106 on the first metal foil 110. The powder for the pressure-compacting process may be provided as a layer of uniform thickness, which in turn is achieved by employing a doctor blade for removal of excess powder. Alternatively, a layer of ink can be printed onto the surface of first metal foil 110 or the surface of the top layer on first metal foil 110 or the first contact interface layer 106 on the first metal foil 110. The layer of ink can be printed by inkjet or screen printing. A doctor blade may be employed for achieving uniform thickness for screen printing. The ink contains powder to be pressure-compacted in the pressure-compacting process. The first metal foil 110 with the printed ink layer thereon is annealed to remove a solvent of the ink and/or a binder of the ink from the printed ink layer. The annealing is carried out prior to the pressure-compacting as a separate process step or during the deoxidizing and/or degassing of the powder to be pressure-compacted. For instance, the deoxidizing and/or degassing of the annealed printed ink layer may be performed at elevated temperature in a forming gas.

An example ink suitable for screen printing comprises particles of Bi_{0.5}Sb_{1.5}Te₃ for p-type thermoelectric film or Bi₂Te_{2.7}Se_{0.3} for n-type thermoelectric film. The particles are mixed with binder solvent which consists of methyl cellulose as the binder, in a mixture of ethanol 60wt.% and water 40wt.%. The concentration of the methyl cellulose in the solvent is between 1.5 and 2.0wt.%. The mass ratio between the particles and the solvent is 7:3, so methyl cellulose is 0.45- 0.6wt.% in the ink. The printed layer is annealed at 250-300 °C for 30 min to solidify the printed layer and burn of the polymeric binders. The layer is pressure-compacted with a uniaxial pressure in a range of 80 -100 MPa at a temperature above 400 degrees Celsius for at least 5 min. The pressure-compacting is carried out in an inert gas atmosphere, e.g., an argon environment at atmospheric pressure with an oxygen concentration less than 100 ppm, to prevent the oxidation of the thermoelectric film.

If necessary, the surface of the first metal foil 110 or a top layer on the first metal foil 110 is cleaned prior to a formation of a layer thereon. The surface cleaning can be made for instance by inert gas plasma cleaning or by ion beam cleaning, wherein ions or atoms of an inert gas (e.g., argon) bombard the surface. Another option for cleaning the surface which can be used separately or in combination with the previous one is annealing the first metal foil 110 in a forming gas. When the specific formation method of the layer is compatible with vacuum technology, the cleaning step and the subsequent formation step can be made without breaking the vacuum and/or exposing the surface to a contaminating environment, e.g. oxygen and/or water vapour containing atmosphere. In other words, the inert environment is maintained between the surface cleaning and the layer formation. The inert environment may have partial pressures of oxygen or water vapour below 1 Pa, preferably below 0.1 Pa, more preferably below 0.01 Pa. In case the processes c), e), f), or g) are used for the forming of the first thermoelectric film 101, an inert gas atmosphere may be maintained between the cleaning process and the film forming process.

For instance, the first metal foil 110 can be cleaned and the first thermoelectric film 101 can be formed in an inert atmosphere on the first metal foil 110 without breaking vacuum and/or exposing the cleaned surface to a contaminating environment. This process may include forming the first coating 120 on the first metal foil 110 after its cleaning and prior to the formation of the first thermoelectric film 101 while the vacuum and/or inert atmosphere is maintained. Such an approach may be implemented by employing PVD and/or CVD processes for deposition of a layer or layers of the first coating 120 and/or the first interface layer 106, when any of these are used. In turn the first thermoelectric film 101 or its bulk layer may be formed using the first powder provided in dry form, wherein the first powder has been deoxidised and/or degassed prior to being provided on the surface of the first metal foil 110 or a layer (e.g., a layer of the first coating 120 or the first contact interface layer 106) on the first metal foil 110. Such an approach may be particularly advantageous where a low-defect density and/or contamination free interface is required not only between the first thermoelectric film 101 and the first and the second metal foil electrodes 111 and 112, but also between their individual layers.

In the above example the entire first thermoelectric film 101 and the first coating 120, if the latter is used, are formed in a vacuum and/or inert environment. This may be advantageous when the manufacturing method is implemented using a dedicated cluster tool. On the other hand, the industrialisation of the manufacturing method may be implemented using multiple independent/stand-alone tools. Maintaining the vacuum and/or inert environment throughout entire formation of the first thermoelectric film 101 and the first coating 110, when the latter is used, is certainly possible to implement, but might require additional resources. In this case it might be more practical to identify critical interfaces between layers which must be formed without breaking vacuum and/or exposure to a contaminating environment. For instance, a layer of the first coating 120 and the first contact interface layer 106 may be deposited without breaking the vacuum and/or inert gas atmosphere between these deposition processes, whereas other layers may be formed without restriction to maintain vacuum and/or to protect against a contaminating environment. The above-mentioned layer of the first coating 120 may be the only one layer of the first coating 120, one of layers in a stack of layers of the fist coating 120, a top or a bottom layer in this stack. Selection of layers of the first coating 120 which are deposited without breaking the vacuum and/or inert gas atmosphere may depend on specific materials of these layers and/or tool park available for the deposition of these layers. Such an approach may be advantageous because it provides for a good quality of an interface between the first thermoelectric film 101 and the first and the second metal foil electrodes 111 and 112 and, on the other hand, it is compatible with the printing of the bulk layer of the first thermoelectric film 101.

The forming the first thermoelectric film 101 of p-type may comprise forming a film of a pristine PEDOT:PSS film as p-type thermoelectric film on the first metal foil 110 coated with a FTO layer. The forming of the pristine PEDOT:PSS film can be performed using PEDOT:PSS blended with isopropanol alcohol (ISO) in the process c) or e). The printed layer is annealed and cured for 10 min at 120 degrees Celsius in vacuum and/or inert gas atmosphere.

The forming the first thermoelectric film 101 of n-type may comprise forming a PEDOT:PSS-Coated Ag2Se NW/PEDOT:PSS composite film on the first metal foil 110 coated with a copper layer. A solution for forming the film according to the process c) or e) can be prepared as follows. First, an dimethyl sulfoxide (DMSO) is mixed with the PEDOT:PSS solution and sonicated for 1 h to form a 5 vol.% DMSO/PEDOT:PSS mixture. After that, an amount of PEDOT:PSS-coated Ag₂Se NWs (10 - 30 wt.%) are dispersed in the DMSO-treated PEDOT:PSS solution, and the mixtures were ultrasonicated for 3 h. The printed or spin-coated solution is then dried in a vacuum oven at 333 K for 24 h.

The PEDOT:PSS-Coated Ag₂Se nanowires (NWs) can be prepared as follows. A first solution is produced by adding SeOz (0.5 g), β-cyclodextrin (5 g), and PEDOT:PSS (2 mL) to deionized (DI) water (100 mL) in a round-bottomed flask under stirring. A second solution is produced by adding ascorbic acid (2.5 g) to DI water (100 mL) in another beaker. After each solution was completely dissolved, the second solution is poured into the first solution and the reaction maintained for 4 h. The composite is then centrifuged and washed separately with DI water and ethanol. The synthesized product is stored in ethanol (100 mL). Subsequently, ammonium hydroxide (10 µL) is added to the solution, which is then left to stand for 48 h at room temperature, allowing time for a flocculant precipitate of PEDOT:PSS-coated Se NWs to form. The precipitate was collected using centrifugation and redispersed in ethylene glycol (200 mL). An Ag precursor solution is produced with a certain amount of AgNO₃ and ascorbic acid in DI water (5 mL). The molar ratio of the ascorbic acid and AgNOs was 1:3. This Ag precursor solution is then poured into the as-prepared Se NW solution. After vigorous stirring for 4 h at room temperature to allow complete reaction, the product is centrifuged and washed with DI water and ethanol several times. Finally, the synthesized PEDOT:PSS-coated Ag₂Se NWs are dried in a vacuum oven at 333 K for 24 h.

After the forming of the first thermoelectric film 101 the first gap 131 is made to form the first and the second metal foil electrodes 111 and 112 from the first metal foil 110 (Fig. 14). The first and the second metal foil electrodes 111 and 112 have respective coatings 121 and 122 being fragments of the first coating 120, when the latter is used. The resulting structure is a thermoelectric element 10 comprising the first thermoelectric film 101 and the first and the second metal foil electrodes 111 and 112. The first gap 131 can be made after or prior to the annealing of the pressure-compacted first thermoelectric film 101. When the first gap 131 is formed after the annealing of the first thermoelectric film 101 another annealing process can be performed afterwards.

A first optional dielectric film can be formed after the forming of the first thermoelectric film 101 and prior or after to the manufacturing of the first gap 131. The first dielectric film has interfaces with a portion of the first metal foil 110 used for the first metal foil electrode 111, a portion of the first metal foil 110 used for the second metal foil electrode 112, and the first thermoelectric film 101. The first optional dielectric film may be arranged for mechanical reinforcement of the thermoelectric element and/or passivation of the first thermoelectric film. Referring to Fig. 14, the first optional dielectric film may be formed atop the first thermoelectric film 101. Example of such a configuration is depicted in Fig. 27, wherein the first thermoelectric film comprises element **E** and the first optional dielectric film comprises element **I.** As can be clearly seen from Figs. 1 and 2, the first optional dielectric film cannot be used in the thermoelectric element 10 having four metal foil electrodes 111- 114 and the thermoelectric element 20, because the first optional dielectric film would block interfaces of the first thermoelectric film 101 with the third and the fourth metal foil electrodes 113 and 114 in the thermoelectric element 10 or it would block an interface between the first and the second thermoelectric films 101 and 102 in the thermoelectric element 20.

A second optional dielectric film can be formed after the manufacturing of the fist gap 131. The second optional dielectric film has interfaces with the first thermoelectric film 101 and the sidewalls of the metal foil electrodes 111 and 112 constituting the first gap 131 and the first thermoelectric film 101. The second optional dielectric film can at least partially fill the first gap 131. Example of such a configuration is depicted in Fig. 27, wherein the first thermoelectric film comprises element **E** and the second optional dielectric film comprises element **A.** The second optional dielectric film may have further an interface with a side of the first metal foil electrode 111 being opposite to a side of the first metal foil electrode 111 at the interface with the first thermoelectric film 101. The second optional dielectric film may have further an interface with a side of the second metal foil electrode 112 being opposite to a side of the second metal foil electrode 112 at the interface with the first thermoelectric film 101. Example of such a configuration is depicted in Fig. 27, wherein the first thermoelectric film comprises element **E** or elements **E** and **A** and the second optional dielectric film comprises elements **A. B,** and **G** or elements **B** and **G.** The second optional dielectric film may be arranged for mechanical reinforcement of the thermoelectric element and/or passivation of the first thermoelectric film. As can be seen from the Figs. 1 and 2 the second optional dielectric film can be used in the thermoelectric element 20 and in the thermoelectric element 10 having only two metal foil electrodes 111 and 112 or four metal foil electrodes 111 - 114.

The first gap 131 can be produced by micromachining, which makes it possible to produce gaps, in particular slits, in metals, in particular, in metal foils, preferably less than 1 mm wide. The micromachining includes physical machining like laser ablation (preferably photoablation), focused ion beam etching, or ion beam etching via a resist mask, when necessary. The micro-machining further includes chemical machining such as reactive ion etching via a resist or photoresist mask. The micromachining also includes mechanical machining such as cutting with a semiconductor wafer dicing tool or a micro-milling tool. The first gap can be produced using a combination of these techniques. For instance, a trench in the metal foil can be made by laser ablation, semiconductor wafer dicing tool, or a micro-milling tool, whereas the first gap 131 is completed by deepening the trench by ion beam etching. The trench may have a depth of at least 90% of the metal foil thickness.

The forming of the first thermoelectric film 101 using processes c), d), f) or g) may be performed such that a portion of the first metal foil electrode 111 and/or a portion of the second metal foil electrode 112 are devoid of the first thermoelectric film 101. For instance, utilisation of the pressure-compaction of the powder or several powders for the forming of the entire first thermoelectric film 101 or its bulk layer allows additive manufacturing of the first thermoelectric film 101 such that the distal end portions of the first and the second metal foil electrodes 111 and 112 are completely devoid of the first thermoelectric film 101 or covered only by the first contact interface layer 106, when the latter is used. The powder or several powders can be provided only on a portion of the fist metal foil 110 for pressure-compaction, wherein the first gap 131 is made in this portion of the first metal foil 110 after the pressure-compaction is completed. When required, the portions of the first contact interface layer 106 on the distal end portions of the first and the second metal foil electrodes 111 and 112 can be removed, e.g., by laser ablation. In case the first thermoelectric film 101 is formed on the distal end portions of the first and the second metal foil electrodes 111 and 112, portions of the first thermoelectric film 101 on these distal end portions can be removed, e.g., by laser ablation, when the distal end portions devoid of the first thermoelectric film 101 are required.

In case the thermoelectric element 10 comprises the third and the fourth metal foil electrodes 113 and 114 in addition to the first and the second metal foil electrodes 111 and 112, the first powder sandwiched between the first metal foil 110 and a second metal foil 115 is pressure-compacted in the process step of the pressure-compacting of the first powder of the first thermoelectric material on the first metal foil 100, wherein the second side of the first thermoelectric film 101 is in direct contact with the second metal foil 115. This process step may be an extension of the process step of the pressure-compaction for the manufacturing of the thermoelectric element 10, which does not have the third and the fourth metal foil electrodes 113 and 114. Utilisation of the additional second metal foil 115 provided atop the first powder in the process of the pressure-compaction of the first powder on the first metal foil 110 enables manufacturing of the thermoelectric element having four metal foil electrodes 111- 114. The process step results in a stack of the first metal foil 110, the first thermoelectric film 101, and the second metal foil 115, wherein the first metal foil 110 is directly attached to the first side of the first thermoelectric film and the second metal foil 115 is directly attached to the second side of the first thermoelectric film 101 (Fig. 15). The pressure-compacted first thermoelectric film 101 or its bulk layer are planar and have their opposite sides parallel to each other. The planar first thermoelectric film 101 or its planar bulk layer may be structured at later manufacturing steps. At this stage the first thermoelectric film 101 has planar interfaces with the first and the second metal foils 110 and 115, wherein these planar interfaces are disposed in parallel flat planes. The second metal foil 115 may have a second coating 125, which is in direct contact with the first thermoelectric film 101. The second coating 125 may have the same composition as the first coating 120 and/or the second coating 125 may be formed on the second metal foil 115 in the same way as the first coating 120 is formed on the first metal foil 110. The first and the second metal foils 120 and 115 may be the same. In case the first thermoelectric layer is formed using process c), the second metal foil 115 is laminated to the printed first thermoelectric layer 101, e.g. using process f).

The first thermoelectric film 101 may comprise another first contact interface layer 107. One side of the other first contact interface layer 107 is in direct contact with the second metal foil 115 or its coating 125, when the latter is used. An opposite side of the other first contact interface layer 107 is in direct contact with the bulk layer of the first thermoelectric layer 101. The other first contact interface layer 107 may have the same composition as the first contact interface layer 106. The other first contact interface layer 107 may be formed in the same way on the second metal foil 115 or its coating 125 as the contact interface layer 106 is formed on the first metal foil 110 or its coating 120. In case one or both first contact interface layers 106 and 107 are used, the first powder is pressure-compacted to form the bulk layer of the first thermoelectric film 101 or the bulk layer printed using process c) is laminated to the second metal foil 115 using process f).

The formed first thermoelectric film 101, e.g. printed or pressure-compacted first thermoelectric film 101 is directly attached to the first and second metal foils 110 and 115 or their coatings 120 and 125, if any of them or both are used. In case the first contact interface layer 106 is used on the first metal foil 110 the printed or pressure-compacted bulk layer of the first thermoelectric film 101 is directly attached to the first contact interface layer 106 on the first metal foil 110 or its coating 120, if the latter is used. In case the other first contact interface layer 107 is used on the second metal foil 115 the printed or pressure-compacted bulk layer of the first thermoelectric film 101 is directly attached to the other first contact interface layer 107 on the second metal foil 115 or its coating 125, if the latter is used. If both first contact interface layers 106 and 107 are used on the first and the second metal foils 110 and 115 the printed or pressure-compacted bulk layer of the first thermoelectric film 101 is directly attached to these first contact interface layers 106 and 107. The pressure-compacting of the first powder not only binds the particles of the first powder together, but also binds these particles to the surface of the first metal foil 110 or a top layer (e.g., 120 or 106) on the first metal foil 110, if this top layer (e.g., 120, 106) is used, and to the surface of the second metal foil 115 or a top layer (e.g. 125 or 107) on the second metal foil 115, if this top layer (e.g., 125 or 107) is used. In case a layer stack is used instead of the bulk layer of the first thermoelectric film 101 and the layers of the stack are formed in separate printing or pressure-compaction processes, the second metal foil 115 is used in the last process as specified in point f) to form the stack of the first metal foil 110, the first thermoelectric film 101, and the second metal foil 115. The process or processes of the powder pressure-compaction for manufacturing of the thermoelectric element 10 comprising four metal foil electrodes 111-114 may be performed by at least one of the following processes: hot pressing, hot pressing with ultrasonic assistance, roll-compacting, or roll-compacting with ultrasonic assistance and/or at elevated temperature. These processes may be performed in vacuum and/or inert gas atmosphere. The powder or the powders may be prepared and provided for the pressure-compacting in the same way for the manufacturing the thermoelectric element 10 having only the first and the second metal foil electrodes 111 and 112 and for the manufacturing the thermoelectric element 10 having four metal foil electrodes 111- 114. The layers 120, 106, 107, 125 on the first and the second metal foils 110 and 115 may be formed using surface cleaning and layer deposition processes without breaking vacuum and/or exposing the surfaces the metal foils or layers thereon to oxidizing and/or contaminating environment as described above. The exposure of the cleaned surfaces of the metal foils or the surfaces of the layers deposited thereon to oxidizing and/or contaminating environment may be avoided prior to pressure-compacting of the first powder provided between these processes. This process integration may be implemented by performing the pressure-compacting in the inert atmosphere and using deoxidized and/or degassed powder.

After the forming of the stack of the first metal foil 110, the first thermoelectric film 101, and the second metal foil 115 (Fig. 15), the first and the second gaps 131 and 132 (Fig. 1) are made to form the first and the second metal foil electrodes from the first metal foil 110 and the third and the fourth metal foil electrodes 113 and 114 from the second metal foil 115. The first and the second gaps 131 and 132 of the thermoelectric element 10 with four metal foil electrodes 111-114 can be made in the same way as described above for the first gap 131 of the thermoelectric element 10 with only the first and the second metal foil electrodes 111 and 112. The first and the second metal foil electrodes 111 and 112 have respective coatings 121 and 122 being fragments of the first coating 120, when the latter is used. The third and the fourth metal foil electrodes 113 and 114 have respective coatings 123 and 124 being fragments of the second coating 125, when the latter is used. The stack may be annealed before or after the first and the second gaps 131 and 132 are made. As described above, the annealing may be performed for improvement of crystal structure of the first thermoelectric film and/or dopant drive-in from dopant source layers of the first and the second coatings 120 and 125.

A third optional dielectric film can be formed after the manufacturing of the second gap 132. The third optional dielectric film can be configured relative to the first thermoelectric film 101 and the third and the fourth metal foil electrodes 113 and 114 in the same way as the second optional dielectric film is configured relative to the first thermoelectric film 101 and the first and the second metal foil electrodes 111 and 112. The third optional dielectric film has interfaces with the first thermoelectric film 101 and the sidewalls of the metal foil electrodes 113 and 114 constituting the second gap 132. The third optional dielectric film can at least partially fill the second gap 132. The third optional dielectric film may have further an interface with a side of the third metal foil electrode 113 being opposite to a side of the third metal foil electrode 113 at the interface with the first thermoelectric film 101. The third optional dielectric film may have further an interface with a side of the fourth metal foil electrode 114 being opposite to a side of the fourth metal foil electrode 114 at the interface with the first thermoelectric film 101. The third optional dielectric film may be arranged for mechanical reinforcement of the thermoelectric element and/or passivation of the first thermoelectric film 101. As can be seen from the Figs. 1 and 2 the third optional dielectric film can be used in the thermoelectric element 20 and in the thermoelectric element 10 having four metal foil electrodes 111-114.

The thermoelectric element 10 with four metal foil electrodes 111-114 may be manufactured such that distal end portions of the metal foil electrodes are devoid of the first thermoelectric film 101 or thickness of its portions on the distal end portions is reduced in comparison to the central portion of the first thermoelectric film 101 bridging the first and the second gaps 131 and 132. This may be implemented by additive forming the first thermoelectric film 101. For example, the first powder for forming the first thermoelectric film 101 or its bulk layer may be provided on a predefined area on the first metal foil 110. In case the first thermoelectric film 101 is formed on the distal end portions of the metal foil electrodes 111- 114, the portions of the first thermoelectric film 101 on the distal end portions may be removed by laser ablation, preferably by photoablation. In this case the laser beam is oriented in Y direction to remove portions of the first thermoelectric film 101 sandwiched between the pairs of the distal end portions of the metal foil electrodes 111 - 114.

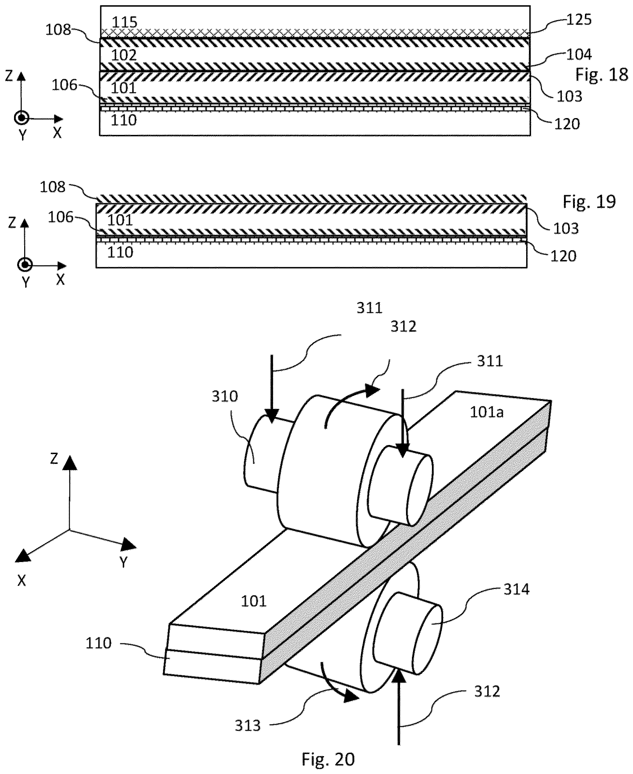

A method of manufacturing of the thermoelectric element 20 employing p-n or p-i-n junction is based on the method of manufacturing of the thermoelectric element 10 comprising the four metal foil electrodes 111 - 114. The first thermoelectric film 101 can be formed on the first metal foil 110 in the same way as in the method for manufacturing the thermoelectric element having only two metal foil electrodes 111 and 112 (Fig. 17). In contrast to the method of the manufacturing the thermoelectric element 10 comprising four metal foil electrodes 111- 114, the first metal foil 110 with the first thermoelectric film 101 formed thereon is laminated to the second metal foil 115 in a course of the formation of the second thermoelectric film 102 using process f). In case the first thermoelectric film 101 is formed using process c) or e), the second thermoelectric film 102 is printed atop or spin coated on the first thermoelectric film 101 in the same way as the first thermoelectric film 101 is printed or spin-coated on the first metal foil 110, and the lamination process f) is performed preferably before the second thermoelectric film is dried. In case the second thermoelectric film 102 is formed using process d), a second powder of a second thermoelectric material is sandwiched between the first thermoelectric film 101 and a second metal foil 115. Put another way, the second powder is provided atop the first thermoelectric 101 film and the second metal foil is provided atop the second powder. The second powder may be provided on the first thermoelectric film 101 in the same way as the first powder is provided on the first metal foil 110. In particular, the second powder may be provided in a dry form on the first thermoelectric film 101 or an ink containing the second powder may be printed on the first thermoelectric film 101. The forming of the second thermoelectric film 102 comprises pressure-compacting the second powder sandwiched between the first thermoelectric film 101 and the second metal foil 115. The process-step of the pressure compacting of the second powder or the process of film drying result in a stack of the first metal foil 110, the first thermoelectric film 101, the second thermoelectric film 102, and the second metal foil 115 (Fig. 18). The first side of the first thermoelectric film 101 is in direct contact with the first metal foil 110. The second side of the first thermoelectric film 101 is in direct contact with a first side of the second thermoelectric film 102. The second side of the second thermoelectric film 102 is in direct contact with the second metal foil 115.

The second metal foil 115 may have a second coating 125, which is in direct contact with the second thermoelectric film 102. The second coating 125 may have a different composition as the first coating 120 because these coatings 120 and 125 are in direct contact with thermoelectric films 101 and 102 having different conductivity types. The layer or layers of the second coating 125 are selected in accordance with the criteria mentioned above. The second coating 125 may comprise one or more of the following layers: an adhesion layer, a diffusion barrier layer, a work function setting layer, or an interface layer for reduction of a thermal and/or an electrical resistance between a metal foil electrode and a thermoelectric film. Specific examples of these layers are provided above. In case the second coating 125 comprise more than one layer, these layers are stacked on top of each other. The layer or layers of the second coating 125 may be formed using CVD and/or PVD.

The second thermoelectric film 102 may comprise the second contact interface layer 108. One side of the second contact interface layer 108 is in direct contact with the second metal foil 115 or its coating 125, when the latter is used. An opposite side of the second contact interface layer 108 is in direct contact with the bulk layer of the second thermoelectric layer 102. The second contact interface layer 108 may have the same composition as the first contact interface layer 106 of the thermoelectric element 10 having the second thermoelectric film 102 instead of the first thermoelectric film 101. The second contact interface layer 108 may be formed in the same way on the second metal foil 115 or its coating 125 as the contact interface layer 106 is formed on the first metal foil 110 or its coating 120 in the method of manufacturing of the thermoelectric element 10 having the second thermoelectric film 102 instead of the first thermoelectric film 102. In case the second contact interface layer 108 is used, the second powder is pressure-compacted to form the bulk layer of the second thermoelectric film 102.

As mentioned above, the first thermoelectric film 101 may comprise the first junction interface layer 103 and/or and the second thermoelectric film 102 may comprise the second junction interface layer 104. Any one or both of these layers may be formed in a corresponding deposition process, e.g. CVD, PVD. The surface for deposition of any of these layers may be cleaned, e.g., by plasma cleaning or ion beam cleaning. Moreover, all these cleaning and deposition processes may be performed without breaking vacuum and/or exposing the cleaned surface or the surface of the deposited layer to an oxidizing and/or contaminating environment. It is preferred that the second junction interface layer 104 is deposited immediately after the first junction interface layer 103 without breaking vacuum and/or exposing the surface of the first junction interface layer 103 to oxidizing and/or contaminating environment (Fig. 19).

The pressure-compacted second thermoelectric film 102 is directly attached to the first thermoelectric film 101 and the second metal foil 115 or its coating 125, if the latter is used. In case the second contact interface layer 108 is used on the second metal foil 115 the pressure-compacted bulk layer of the second thermoelectric film 101 is directly attached to the second contact interface layer 108 on the second metal foil 115 or its coating 125, if the latter is used. In case a second junction interface layer 104 of the second thermoelectric film 102 is used on the first thermoelectric film 101 the pressure-compacted bulk layer of the second thermoelectric film 102 is directly attached to the second junction interface layer 104. If the second contact interface layer 108 and the second junction interface layer 104 are used, the pressure-compacted bulk layer of the second thermoelectric film 102 is directly attached to these interface layers 108 and 104. The pressure-compacting of the second powder not only binds the particles of the second powder together, but also binds these particles to the surface of the second metal foil 115 or a top layer (e.g., 108 or 125) on the second metal foil 115, if this top layer (e.g., 108, 125) is used, and to the surface of the first thermoelectric film 101 or the second junction interface layer 104, if the latter is used. In case a layer stack is used instead of the bulk layer of the second thermoelectric film 102 and the layers of the stack are formed in separate pressure-compaction processes, the second metal foil 115 is used in the last pressure-compaction process to form the stack of the first metal foil 110, the first thermoelectric film 101, the second thermoelectric film 102, and the second metal foil 115. The pressure-compacted first thermoelectric film 102 or its bulk layer are planar. The planar second thermoelectric film 102 or its planar bulk layer may be structured at later manufacturing steps. At this stage of manufacturing the first metal foil 110 and the first side of the first thermoelectric film 101 have a planar interface, the second side of the first thermoelectric film 101 and the first side of the second thermoelectric film 102 have a planar interface, and the second side of the second thermoelectric film 102 and second meta foil 115 have a planar interface. All these planar interfaces are disposed in respective parallel flat planes and the interface between the first and the second thermoelectric films 101 and 102 is disposed between the interfaces between the metal foils 110 and 115 and the respective thermoelectric films 101 and 102.

The process or processes of the powder pressure-compaction for manufacturing of the thermoelectric element 20 may be performed by at least one of the following processes: hot pressing, hot pressing with ultrasonic assistance, roll-compacting, or roll-compacting with ultrasonic assistance and/or at elevated temperature. These processes may be performed in vacuum and/or inert gas atmosphere. The powder or the powders may be prepared and provided for the pressure-compacting in the same way for the manufacturing the thermoelectric element 10 having two or four metal foil electrodes 111 and 112 or 111 - 114 and for the manufacturing the thermoelectric element 20 employing a p-n or p-i-n junction. The surfaces of the first thermoelectric film 101 and the second metal foil 115 may be cleaned, e.g. by plasma or ion beam cleaning. Afterwards, the second powder may be provided for pressure-compacting between the cleaned surfaces such that they are not exposed to oxidizing and/or contaminating environment, wherein the powder for pressure-compacting may be deoxidized and/or degassed prior to its pressure-compacting. As a next step the second powder is pressure-compacted between the cleaned surfaces in vacuum and/or inert gas atmosphere. The second contact interface layer 125 and a layer or layers of the second coating 125 on the second metal foil 115 may be formed using a sequence of deposition processes, which are performed without breaking vacuum and/or exposing layer surface to oxidizing and/or contaminating environment prior to a deposition of a next one. The first layer in this sequence may be deposited on a cleaned surface, preferably by plasma or ion beam cleaning, without exposing the cleaned surface to oxidizing and/or contaminating environment prior to the layer deposition. It is preferred that the adjoining layers of the second contact interface layer 107 and the second coating 125 are deposited without breaking vacuum and/or exposing said layer of the second coating 125 to oxidizing and/or contaminating environment. The process integration may be implemented by performing the pressure-compacting in the inert atmosphere and using deoxidized and/or degassed powder, wherein the powder is pressure-compacted between surfaces which were not exposed to oxidizing and/or contaminating environment.

In case process c) or e) is used for the forming the first thermoelectric film 101 and process c) or e) is used for the forming of the second thermoelectric film 101102 the entire stack of the films 101 and 102 can be formed on the first metal foil using respective processes c) or e) for films of the stack. In case the thermoelectric film 101 or 102 comprises several layers, each of these layers can be produces using respective process c) or e). Afterwards, the second metal foil 115 is laminated to the stack formed on the first metal foil 110, e.g. using process f). The forming of the stack can be performed in an inert gas atmosphere. The lamination of the second metal foil 115 onto the stack can be performed in an inert gas atmosphere and/or at elevated temperature and/or with ultrasonic assistance. The forming of the stack and the lamination can also be performed without breaking the inert gas atmosphere. The lamination of the second metal foil 115 can be performed in a course of drying of the last printed layer or film of the stack as specified in process f). Alternatively, the first thermoelectric film 101 can be formed on the first metal foil 110 using process c) or e) and the second thermoelectric film 102 can be formed on the second metal foil 115 using process c) or e). Afterwards the first thermoelectric film 101 on the first metal foil 110 is laminated to the second thermoelectric film 102 on the second metal foil 115, e.g. using process f). The lamination can be performed when the first thermoelectric film 101 or its junction interface layer are not completely dried as specified in process f) and/or when the second thermoelectric film 102 or its junction interface layer are not completely dried as specified in process f). The forming of the first and the second thermoelectric layers 101 and 102 and the lamination can be performed without breaking an inert gas atmosphere. In case the first and/or the second thermoelectric films 101 and 102 are formed on a dummy wafer in process e), the stack of the first and the second thermoelectric films 101 and 102 is sandwiched between the first and the second metal foils 110 and 115 for lamination. The delamination and lamination may be performed in an inert gas atmosphere. The lamination may be performed at elevated temperatures, and/or with pressure and/or ultrasonic assistance, e.g. using the tools depicted in Figs. 20 - 23.

After the forming of the stack of the first metal foil 110, the first thermoelectric film 101, the second thermoelectric film 102, and the second metal foil 115 (Fig. 18), the first and the second gaps 131 and 132 (Fig. 2) are made to form the first and the second metal foil electrodes from the first metal foil 110 and the third and the fourth metal foil electrodes 113 and 114 from the second metal foil 115. The first and the second gaps 131 and 132 of the thermoelectric element 20 can be made in the same way as described above for the thermoelectric element 10 with four metal foil electrodes 111 -114. The first and the second metal foil electrodes 111 and 112 have respective coatings 121 and 122 being fragments of the first coating 120, when the latter is used. The third and the fourth metal foil electrodes 113 and 114 have respective coatings 123 and 124 being fragments of the second coating 125, when the latter is used. The stack may be annealed before or after the first and the second gaps 131 and 132 are made. As described above, the annealing may be performed for improvement of crystal structure of the first thermoelectric film 101 and/or for dopant drive-in from dopant source layers of the first and the second coatings 120 and 125.

The thermoelectric element 20 with four metal foil electrodes 111-114 may be manufactured such that distal end portions of the metal foil electrodes are devoid of the first and the second thermoelectric films 101 and 102 or thickness of their portions on the distal end portions is reduced in comparison to the central portions of the first and the second thermoelectric films 101 and 102 bridging the first and the second gaps 131 and 132, respectively. This may be implemented by additive forming the first and the second thermoelectric films 101 and 102 using the processes c) or d). For example, the first powder for forming the first thermoelectric film 101 or its bulk layer may be provided on a predefined area on the first metal foil 110 and the second powder for forming thermoelectric film 102 or its bulk layer may be provided atop the pressure-compacted first powder. In case the first thermoelectric film 101 is formed on the distal end portions of the first and the second metal foil electrodes 111 and 112 and/or the second thermoelectric film 102 is formed on the distal end portions of the third and fourth metal foil electrodes 113 and 114, the portions of the first and/or the second thermoelectric films 101 and 102 on the distal end portions may be removed by laser ablation, preferably by photoablation. In this case the laser beam is oriented in Y direction to remove portions of the first and/or second thermoelectric films 101 and 102 between the pairs of the distal end portions of the metal foil electrodes 111 - 114.

The stack of the first metal foil 111, the first thermoelectric film 101, the second thermoelectric film 102, and the second metal foil 115 (Fig. 18), used for the manufacturing of the thermoelectric element 20 employing a p-n or p-i-n junction, may be manufactured in other ways. In one alternative method for stack manufacturing, a stack of the first metal foil 110 and the first thermoelectric film 101 is manufactured as described above for the thermoelectric element 10. When required, the manufacturing of this stack may comprise deposition of the first junction interface layer 103 on the bulk layer of the first thermoelectric film 101 (Fig. 17) preferably without breaking vacuum after forming the bulk layer and/or exposing the surface of the bulk layer to oxidizing and/or contaminating environment. Another stack of the second metal foil 115 and the second thermoelectric film 102 is manufactured as well. When required, the manufacturing of the other stack may comprise deposition of the second junction interface layer 104 on the bulk layer of the second thermoelectric film 102 (Fig. 16), preferably, without breaking vacuum after forming the bulk layer and/or exposing the surface of the bulk layer to oxidizing and/or contaminating environment. The first and the second thermoelectric films 101 and 102 are thermoelectric films of different conductivity type. The film-foil stacks are laminated together such that the second side of the first thermoelectric film 101 is attached to the first side of the second thermoelectric film 102. The lamination is performed using at least one of the following processes: hot pressing, hot pressing with ultrasonic assistance, roll-pressing, or roll-pressing with ultrasonic assistance and/or elevated temperature. As a result, the stack of stack of the first metal foil 111, the first thermoelectric film 101, the second thermoelectric film 102, and the second metal foil 115 is formed (Fig. 18). This method may be implemented in a slightly different way. The first and the second junction interface layers 103 and 104 may be deposited on the bulk layer of the first thermoelectric layer 101 and this stack may be laminated to the bulk layer of the second thermoelectric film 102 formed on the second metal foil 115.

In another alternative method for stack manufacturing the first powder is provided on the first metal foil 110 and the second powder is provided on the first powder. Afterwards the second metal foil 115 is placed atop the first powder. The first and the second powders sandwiched between the first and the second metal foils 110 and 115 are pressure-compacted by at least one of the following processes: hot pressing, hot pressing with ultrasonic assistance, roll-compacting, or roll-compacting with ultrasonic assistance and/or at elevated temperature. As a result, the stack of the first metal foil 110, the first thermoelectric film 101, the second thermoelectric film 102 the second metal foil 115 is formed. Preferably the first powder is provided by printing the first ink containing the first powder and the second powder is provided by printing the second ink containing the second powder on the annealed printed layer of the first ink, wherein the printed layer of the first ink is annealed to remove a solvent and/or a binder from the printed layer of the first ink. The printed layer of the second ink is also annealed to remove a solvent and/or a binder from it prior to the powder-compacting of the first and the second powders provided as the annealed layers of the respective first and second inks sandwiched between the first and the second metal foils 110 and 115. This method for stack manufacturing also includes optional steps for forming one or more of the following layers: the first coating 120, the second coating 125, the first contact interface layer 106, or the second contact interface layer 108, which are described above in more detail. In addition, the bulk layer of the first thermoelectric layer 101 may be formed as a stack of layers, wherein layers of the stack constituting the bulk layer of the first thermoelectric film 101 are formed by providing respective layers of annealed printed ink layers containing powders, which are stacked on top of each other. The same applies mutatis mutandis to the bulk layer of the second thermoelectric film 102 when it is implemented as a stack of layers. In both cases all annealed printed ink layers for forming the first and the second thermoelectric layers 101 and 102 are pressure-compacted in one process of pressure-compacting to form the entire stack of the fist metal foil 110, the first thermoelectric film 101, the second thermoelectric film 102, and the second metal foil 115. Preferably each printed ink layer is annealed to remove a solvent and/or a binder from it prior to printing the next one.

A fourth optional dielectric film can be formed after the manufacturing of the first gap in 131 of the thermoelectric element 20. The fourth optional dielectric film can be formed in the same way as the second optional dielectric film in the thermoelectric element 10. The fourth optional dielectric film may be arranged for passivation of the first thermoelectric film 101 and/or mechanical reinforcement of the thermoelectric element 20.

A fifth optional dielectric film can be formed after the manufacturing of the second gap in 132 of the thermoelectric element 20. The fifth optional dielectric film can be configured relative to the second thermoelectric film 102 and the third and the fourth metal foil electrodes 113 and 114 in the same way as the second optional dielectric film is configured relative to the first thermoelectric film 101 and the first and the second metal foil electrodes 111 and 112. The fifth optional dielectric film has interfaces with the second thermoelectric film 102 and the sidewalls of the metal foil electrodes 113 and 114 constituting the second gap 132. The fifth optional dielectric film can at least partially fill the second gap 132. The fifth optional dielectric film may have further an interface with a side of the third metal foil electrode 113 being opposite to a side of the third metal foil electrode 113 at the interface with the second thermoelectric film 102. The fifth optional dielectric film may have further an interface with a side of the fourth metal foil electrode 114 being opposite to a side of the fourth metal foil electrode 114 at the interface with the first thermoelectric film 101. The fifth optional dielectric film may be arranged for mechanical reinforcement of the thermoelectric element and/or passivation of the second thermoelectric film 102.

The thermoelectric elements 10 and 20 may comprise further optinal dielectric films having interfaces with surfaces of the thermoelectric films, e.g. their sidewalls, are not in contact with any of the metal foil electrodes. Such a configuration of the dielectric films provides for complete coverage of surfaces of the thermoelectric films 101 and 102, which are not covered by the metal toil electrodes. The optional dielectric films can be formed by printing, e.g. inkjet, screen printing, aerosol jet printing, or drop printing, etc. Materials having low thermal conductivity such as UV curable liquid silicon rubber or UV or thermal curable resins can be used for manufacturing of the optional dielectric layers.

Figs. 20 - 23 illustrate examples of tools for pressure-compacting of powders of thermoelectric materials, pressing of printed layers, or for laminating the aforementioned film-foil stacks together by means of pressing, hot pressing, hot pressing with ultrasonic assistance, roll-pressing, roll-compacting, or roll-compacting with ultrasonic assistance and/or at elevated temperature. These processes may be performed in an inert gas atmosphere and/or vacuum by placing these tools in an appropriate enclosed environment, e.g., an argon filled glove box or a vacuum chamber. The powders used in these tools may be degassed and/or deoxidised before the pressure-compacting. The tools depicted in Figs. 20 and 21 employ roll-compacting, whereas the tools depicted in Figs. 22 and 23 employ uniaxial pressure-compacting. The compacting of the powders, pressing of printed layers, and the laminating of the film-foil stacks together in these tools may be assisted by ultrasonic vibration and/or heating the powder during compacting.

The tool depicted in Fig. 20 comprises two rolling mill rolls 310 and 314 arranged vertically (Z direction in Fig. 20). A metal foil 110 (e.g., the first or the second metal foil with optional coatings) having a powder 101a of a thermoelectric material (e.g., the first or the second powder) on its upper surface is entrained by the rotating rolling mill rolls exerting compressing force. The rolling mill roll 310 exerts the force 311 in the negative Z direction and rotates counterclockwise when viewed along X direction. The rolling mill roll 314 exerts the force 312 in the positive Z direction and rotates clockwise when viewed along X direction. The forces exerted by the rolling mill rolls 310 and 314 can be set in a range from 100 Newton to at least 10000 Newton. A width (i.e., a dimension in Y direction in Fig. 20) of the rolling mill rolls 310 and 314 exerting the forces is preferably at least 1 cm. A diameter of the rolling mill rolls 310 and 314 is preferably at least 25 cm. The roll 310 and/or the roll 314 may be coupled to respective ultrasonic transducers which cause the roll to vibrate at an ultrasonic frequency in a direction orthogonal to the direction of rolling, Y direction in Fig. 20. The metal foil moves in X direction, driven by the rotating rolling mill rolls 320 and 314, which pressure-compact the powder 101a on the metal foil 110, and thereby form a film 101 or a layer of the thermoelectric material attached to the metal foil 110. When necessary, this process may be performed at elevated temperature, e.g. above 100 degrees Celsius, or above 200 degrees Celsius. The process of the pressure-compacting may be performed in several iterations, wherein the metal foil with the pressure-compacted powder thereon is processed again to continue the pressure-compacting of the powder. Several powder layers of different powders may be provided on top of each other for pressure-compacting on the metal foil. The powder may be provided also on predefined areas on the metal foil to implement the additive manufacturing. The result of this process are "islands" of the pressure-compacted powder on the metal foil. This tool may also perform the pressure-compacting of the powder provided between two metal foils or several powder layers of different powders provided between two metal foils. In this case the metal foils with the powder or powder layers therebetween are pressure-rolled between the rolling mill rolls 310 and 314. This tool may also be used for the laminating of the film-foil stacks together. In this case the foils with thermoelectric films or their layers to be attached to each other or to other foils are bought into direct contact and pressure-laminated by the rotating rolling mill rolls 310 and 314. The pressure-lamination may be performed at elevated temperature and/or ultrasonic assistance.

The tool depicted in Fig. 20 may also be used for pressing of printed or spin coated films or layers. In this case a metal foil with a printed film or layer thereon is pressure-rolled between the rolling mill rolls 310 and 314. These processes may be performed while drying these films or layers as described above (process c)). The rolling mill rolls 310 and 314 may have a polytetrafluoroethylene coating to hinder adhesion to them. The pressing may be performed with ultrasonic assistance and/or at elevated temperatures preferably below 100 degrees Celsius. The pressing may be performed in several iterations, wherein the layer(s) or film(s) are pressed several times. This tool may be also used for laminating a layer or a film to another layer, film or metal foil. Preferably the lamination process is performed when the printed layer is not fully dried as described above in point f). In this case surfaces to be laminated together are aligned and brought in contact with each other, afterwards a stack formed thereby is entrained and pressed by the rotating rolls 314 and 310. The lamination may be performed with ultrasonic assistance and/or at elevated temperatures preferably below 100 degrees Celsius. Analogously to the previously described processes the lamination may be performed in several iterations, wherein the stack is passed between the rolls 310 and 314 several times.

Fig. 21 illustrates another tool for roll-compacting. In contrast to the tool depicted in Fig. 20, this tool has only one rotating roll 301. The tool comprises a horizontal (X-Y plane in Fig. 21) rigid flat platform 300 for placing a metal foil 110 (e.g., the first or the second metal foil) with a powder of a thermoelectric material 101a (e.g., the first or the second powder). The tool comprises further a roll 301. The roll 301 is arranged to exert a force 304 in a vertical direction (negative Z direction) against the horizontal rigid platform 300 while rolling over it. The force exerted by the rolling mill roll 301 can be set in a range from 100 Newton to at least 10000 Newton. A width (i.e., a dimension in Y direction in Fig. 20) of the rolling mill roll 301 exerting the forces is preferably at least 1 cm. A diameter of the rolling mill roll 301 is preferably at least 25 cm. The roll 301 rolls in X direction and thereby forms a film 101 or a layer of the thermoelectric material attached to the metal foil 110 by pressure-compacting the powder 101a. When necessary, this process may be performed at elevated temperature, e.g. above 100 degrees Celsius, or above 200 degrees Celsius. The roll 301 may be coupled to an ultrasonic transducer which causes the roll 301 to vibrate at an ultrasonic frequency in a direction orthogonal to the direction of rolling. The vibration direction corresponds to direction Y in Fig. 21. This means that the roll 301 acts as a sonotrode which facilitates the pressure-compacting of the powder by ultrasonic consolidation. The process of the pressure-compacting may be performed in several iterations, wherein the metal foil with the pressure-compacted powder thereon is processed again to continue the pressure-compacting of the powder. Several powder layers of different powders may be provided on top of each other for pressure-compacting on the metal foil. The powder may be provided also on predefined areas on the metal foil to implement the additive manufacturing as depicted in Fig. 21. The result of this process are "islands" of the pressure-compacted powder on the metal foil. This tool may also perform the pressure-compacting of the powder provided between two metal foils or several powder layers of different powders provided between two metal foils. In this case the metal foils with the powder therebetween are pressure-rolled between the roll 301 and the rigid flat platform 300. This tool may also be used for the laminating of the film-foil stacks together in a similar way as the tool in depicted in Fig. 21. In this case the foils with thermoelectric films or their layers are provided on the horizontal rigid platform 300, wherein the layers or films to be attached to each other are bought into direct contact. Afterwards they are pressure-laminated together by rolling the roll 301 over the film-foil stacks placed on the horizontal rigid platform. The pressure-lamination may be performed at elevated temperature and/or with ultrasonic assistance.

The tool depicted in Fig. 21 may also be used for pressing of printed or spin coated films or layers. In this case a metal foil with a printed film or layer thereon is pressure-rolled between the rolling mill roll 301 and the rigid flat platform 300. These processes may be performed while drying these films or layers as described above (process c)). The rolling mill roll 301 may have a polytetrafluoroethylene coating to hinder adhesion to them. The pressing may be performed with ultrasonic assistance and/or at elevated temperatures preferably below 100 degrees Celsius. The pressing may be performed in several iterations, wherein the layer(s) or film(s) are pressed several times. This tool may be also used for laminating a layer or a film to another layer, film or metal foil. Preferably the lamination process is performed when the printed layer is not fully dried as described above in point f). In this case surfaces to be laminated together are aligned and brought in contact with each other, afterwards the rolling mill roll 310 is rolled over a stack of components to be laminated together. The lamination may be performed with ultrasonic assistance and/or at elevated temperatures preferably below 100 degrees Celsius. Analogously to the previously described processes the lamination may be performed in several iterations, wherein the rolling mill roll 310 is rolled over the stack of components to be laminated together several times.

Fig. 22 illustrates a tool for uniaxial pressure-compacting of a powder 101a of a thermoelectric material provided on a metal foil 110. This tool comprises two rigid flat plates 330 and 331 which are used for exerting a uniaxial pressure 333 pressure on the powder on the metal foil for forming a layer or a film of a pressure-compacted powder. The uniaxial pressure can be set in an interval preferably from 1 KPa to at least 10 MPa, more preferably at least 50 MPa. When necessary, this process may be performed at elevated temperature, e.g. above 100 degrees Celsius, or above 200 degrees Celsius. One of the rigid flat plates may be coupled to an ultrasonic transducer which causes this plate to vibrate an ultrasonic frequency in a direction orthogonal to the direction of pressing. The tool depicted in Fig. 22 has the rigid flat pate 332 coupled to an ultrasonic transducer 332. The rigid flat plate coupled to the ultrasonic transducer acts as a sonotrode which facilitates the pressure-compacting of the powder by ultrasonic consolidation. Several powder layers of different powders may be provided on top of each other for pressure-compacting on the metal foil. This tool may also perform the pressure-compacting of the powder provided between two metal foils or several powder layers of different powders provided between two metal foils. In this case the metal foils with the powder therebetween are pressure-compacted between the rigid flat plates 330 and 331. The uniaxial pressure and/or a power of the ultrasonic assistance can be increased during the pressure-compacting process.

Fig. 23 illustrates another tool for uniaxial pressure-compacting of a powder 101a of a thermoelectric material provided on a metal foil 110. This tool also comprises two rigid flat plates 320 and 321 which are used for exerting a uniaxial pressure 323 pressure on the powder on the metal foil for forming a layer or a film of a pressure-compacted powder. The uniaxial pressure can be set in an interval preferably from 1 KPa to at least 10 MPa, more preferably at least 50 MPa. When necessary, this process may be performed at elevated temperature, e.g. above 100 degrees Celsius, or above 200 degrees Celsius. One of the rigid flat plates may be coupled to an ultrasonic transducer which causes this plate to vibrate an ultrasonic frequency in the same direction as the direction of pressing. The tool depicted in Fig. 23 has the rigid flat pate 321 coupled to an ultrasonic transducer 322. The rigid flat plate coupled to the ultrasonic transducer acts as a sonotrode which facilitates the pressure-compacting of the powder by ultrasonic consolidation. Several powder layers of different powders may be provided on top of each other for pressure-compacting on the metal foil. This tool may also perform the pressure-compacting of the powder provided between two metal foils or several powder layers of different powders provided between two metal foils. In this case the metal foils with the powder therebetween are pressure-compacted between the rigid flat plates 320 and 321. The uniaxial pressure and/or a power of the ultrasonic assistance can be increased during the pressure-compacting process.

The tools depicted in Figs. 21 and 22 may also be used for pressing of printed or spin coated films or layers. In this case two rigid flat plates 330 and 331 of the tool depicted in Fig. 22 or two rigid flat plates 321 and 320 of the tool depicted in Fig. 23 exert a uniaxial pressure on a metal foil with a printed film or layer thereon. These processes may be performed while drying these films or layers as described above (process c)). The plates 321 and 331 may have a polytetrafluoroethylene coating to hinder adhesion to them. The pressing may be performed with ultrasonic assistance and/or at elevated temperatures preferably below 100 degrees Celsius. The pressing may be performed while increasing the uniaxial pressure and/or a power of ultrasonic assistance during pressing. These tools may be also used for laminating a layer or a film to another layer, film or metal foil. Preferably the lamination process is performed when the printed layer is not fully dried as described above in point f). In this case surfaces to be laminated together are aligned and brought in contact with each other, afterwards the uniaxial pressure is applied to a stack of components to be laminated together. The lamination may be performed with ultrasonic assistance and/or at elevated temperatures preferably below 100 degrees Celsius. Analogously to the previously described processes the uniaxial pressure and/or power of the ultrasonic assistance can be increased during the lamination process.

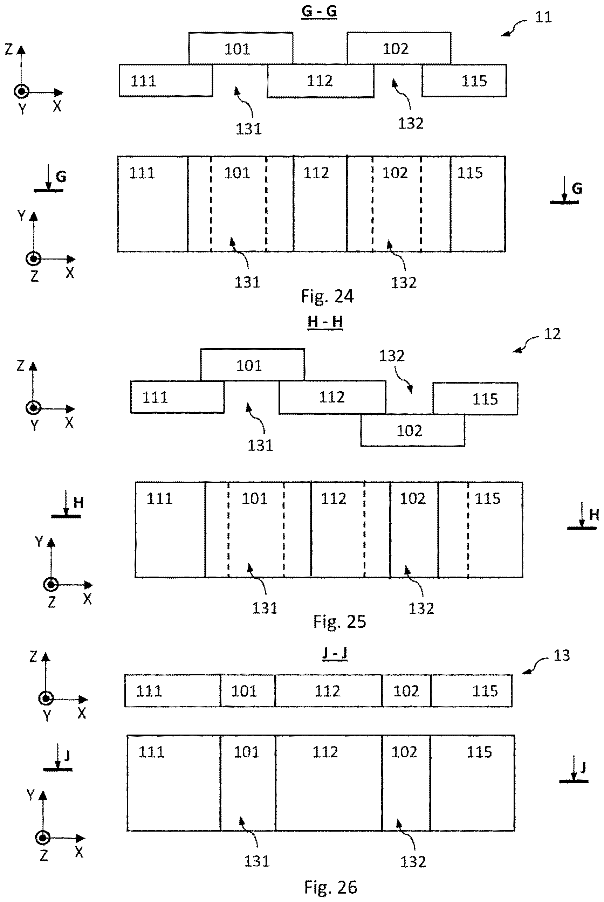

Fig. 24 illustrates a thermoelectric element 11 and its cross-section. The thermoelectric element 11 comprises two thermoelectric elements employing single thermoelectric films and sharing the same second metal foil electrode 112. The thermoelectric element 11 is an example of integration of two thermoelectric elements 10 having different types. The first thermoelectric element has a first metal foil electrode 111 and a second shared metal foil electrode 112. The thermoelectric film 101 of the first thermoelectric element has an interface with a first side of the first metal foil electrode 111 and another interface with a first side of the shared second metal foil electrode 112. The thermoelectric film 102 of the second thermoelectric element has an interface with a first side of the third metal foil electrode 115 and another interface with a first side of the shared second metal foil electrode 112. The first and the second thermoelectric films have different conductivity types. The first and the second thermoelectric elements may have other configurations of the thermoelectric element 10 described herein.

Fig. 25 illustrates a thermoelectric element 12 and its cross-section. The thermoelectric element 12 comprises two thermoelectric elements employing single thermoelectric films and sharing the same second metal foil electrode 112. The thermoelectric element 12 is an example of integration of two thermoelectric elements 10 having different types. The first thermoelectric element has a first metal foil electrode 111 and a second shared metal foil electrode 112. The thermoelectric film 101 of the first thermoelectric element has an interface with a first side of the first metal foil electrode 111 and another interface with a first side of the second shared metal foil electrode 112. The thermoelectric film 102 of the second thermoelectric element has an interface with a first side of the third metal foil electrode 115 and another interface with a second side of the shared second metal foil electrode 112. The first and the second thermoelectric films have different conductivity types. The first and the second sides of the shared second metal foil electrode are its opposite sides. The first and the second thermoelectric elements may have other configurations of the thermoelectric element 10 described herein.

Fig. 26 illustrates a thermoelectric element 13 and its cross-section. The thermoelectric element 13 comprises two thermoelectric elements employing single thermoelectric films and sharing the same second metal foil electrode 112. The thermoelectric element 12 is an example of integration of two thermoelectric elements 10 having different types. The first thermoelectric element has a first metal foil electrode 111 and a shared second metal foil electrode 112. The thermoelectric film 101 of the first thermoelectric element has interfaces with sidewalls of the first metal foil electrode 111 and the shared second metal foil electrode 112, wherein these sidewalls constituted the first gap 131. The first thermoelectric film at least partially or completely fills the gap 131. The thermoelectric film 102 of the second thermoelectric element has interfaces with sidewalls of the third metal foil electrode 115 and the shared second metal foil electrode 112, wherein these sidewalls constituted the second gap 132. The second thermoelectric film at least partially or completely fills the gap 132. The first and the second thermoelectric elements may have other configurations of the thermoelectric element 10 described herein.

Fig. 27 illustrates a thermoelectric element 14 and its cross-section. The thermoelectric element 13 comprises two thermoelectric elements employing single thermoelectric films 10 and sharing the same second metal foil electrode 112. The first thermoelectric element has the first thermoelectric film, the first metal foil electrode 111, shares the second metal foil electrode 112 with the second thermoelectric element. The second thermoelectric element has the second thermoelectric film, the third metal foil electrode 115 and shares the second metal foil electrode 112 with the first thermoelectric element.

The first thermoelectric film can be comprised of one of more of elements **A, B, E,** or **G** on condition that these elements constitute a single piece. The element **A** is arranged in the first gap 131 constituted by sidewalls of the first metal foil electrode 111 and the shared second metal foil electrode 112. The element **A** has interfaces with these sidewalls and fills a portion of the first gap 131. The element **B** is arranged in the first gap 131. The element **B** has interfaces with these sidewalls and fills a portion of the first gap 131. The elements A and B together completely fill the first gap 131. The element E has a planar interface with a first side of the first metal foil electrode 111, another planar interface with a fist side of the shared second metal foil electrode 112, and yet another planar interface with the element A, wherein these planar interfaces are in a first flat plane. The element G has a planar interface with a second side of the first metal foil electrode 111, another planar interface with a second side of the shared second metal foil electrode 112, and yet another planar interface with the element B, wherein these planar interfaces are in a second first flat plane. The elements E and G are depicted as rectangular shapes merely for illustrative purposes. Depending on fabrication methods portions of perimeters of these shapes, which are distant from the metal foil electrodes, may be include convex or concave. Dielectric films used for passivation of the first thermoelectric film and/or for mechanical reinforcement of the first thermoelectric film may comprise any of the following elements A, when this element is not comprised in the first thermoelectric film; B, when this element is not comprised in the first thermoelectric film; E, when this element is not comprised in the first thermoelectric film; G, when this element is not comprised in the first thermoelectric film; **I**; or K, on condition that no void spaces are built. For instance, when the thermoelectric film is comprised of the elements A and B, a dielectric film cannot consist of the element **I**, because in this case a void E is built. To avoid such situation the thermoelectric film must comprise the element E. The element **I** has an interface with the first metal foil electrode 111 in the first plane, wherein this interface is located further away from the first gap 131, then the interface of the element E with the first metal foil electrode 111. The element **I** has an interface with the shared second metal foil electrode 112 in the first plane, wherein this interface is located further away from the first gap 131, then the interface of the element E with the shared second metal foil electrode 112. The element **I** has further an interface with the element E, which circumvents a portion of the perimeter of the element E such that no void between these elements is built. The element K has an interface with the first metal foil electrode 111 in the second plane, wherein this interface is located further away from the first gap 131, then the interface of the element G with the first metal foil electrode 111. The element K has an interface with the shared second metal foil electrode 112 in the second plane, wherein this interface is located further away from the first gap 131, then the interface of the element G with the shared second metal foil electrode 112. The element K has further an interface with the element G, which circumvents a portion of the perimeter of the element G such that no void between these elements is built. The first and the second sides of the fist metal foil electrode 111 are its opposite sides. The first and the second sides of the shared second metal foil electrode 112 are its opposite sides.

The second thermoelectric film can be comprised of one of more of elements F, C, D, or H on condition that these elements constitute a single piece. The element C is arranged in the second gap 132 constituted by sidewalls of the third metal foil electrode 115 and the shared second metal foil electrode 112. The element C has interfaces with these sidewalls and fills a portion of the second gap 132. The element D is arranged in the second gap 132. The element D has interfaces with these sidewalls and fills a portion of the second gap 132. The elements **C** and **D** together completely fill the second gap 132. The element **F** has a planar interface with a first side of the third metal foil electrode 115, another planar interface with the fist side of the shared second metal foil electrode 112, and yet another planar interface with the element **C,** wherein these planar interfaces are in the first flat plane. The element **H** has a planar interface with a second side of the third metal foil electrode 115, another planar interface with the second side of the shared second metal foil electrode 112, and yet another planar interface with the element **D,** wherein these planar interfaces are in the second first flat plane. The elements **F** and **H** are depicted as rectangular shapes merely for illustrative purposes. Depending on fabrication methods portions of perimeters of these shapes, which are distant from the metal foil electrodes, may be include convex or concave. Dielectric films used for passivation of the first thermoelectric film and/or for mechanical reinforcement of the first thermoelectric film may comprise any of the following elements **F,** when this element is not comprised in the first thermoelectric film; **C,** when this element is not comprised in the first thermoelectric film; **D,** when this element is not comprised in the first thermoelectric film; **H,** when this element is not comprised in the first thermoelectric film; **J;** or **L,** on condition that no void spaces are built. For instance, when the thermoelectric film is comprised of the elements **C** and **D,** a dielectric film cannot consist of the element **J,** because in this case a void **F** is built. To avoid such situation the thermoelectric film must comprise the element **F.** The element **J** has an interface with the third metal foil electrode 115 in the first plane, wherein this interface is located further away from the second gap 132, then the interface of the element **F** with the third metal foil electrode 115. The element **J** has an interface with the shared second metal foil electrode 112 in the first plane, wherein this interface is located further away from the second gap 132, then the interface of the element **F** with the shared second metal foil electrode 112. The element **J** has further an interface with the element **F,** which circumvents a portion of the perimeter of the element **F** such that no void between these elements is built. The element **L** has an interface with the third metal foil electrode 115 in the second plane, wherein this interface is located further away from the second gap 132, then the interface of the element **H** with the third metal foil electrode 115. The element **L** has an interface with the shared second metal foil electrode 112 in the second plane, wherein this interface is located further away from the second gap 132, then the interface of the element **H** with the shared second metal foil electrode 112. The element **L** has further an interface with the element **H,** which circumvents a portion of the perimeter of the element **H** such that no void between these elements is built. The first and the second sides of the third metal foil electrode 115 are its opposite sides.

Fig. 28 depicts a thermoelectric module 201 comprising thermoelectric elements each employing single thermoelectric films. The thermoelectric module 201 can be built using thermoelectric elements 10, or thermoelectric elements 11, or thermoelectric elements 12, or thermoelectric elements 13, or thermoelectric elements 14. The thermoelectric module 201 has thermoelectric films electrically connected in series, such that a series of thermoelectric films of alternating types is built. Thermoelectric elements share common electrodes 112₁....112_{N} and 111₂ ... 111_{N} each having interfaces with two thermoelectric films 101₁ and 102₁, 101₂ and 102₂, .... 101_{N} and 102_{N} having different conductivity types. Metal foil electrodes having odd numbers in series 111₁, 111₂, 111₃, .... 111_{N}, 115 are arranged for coupling to a heat sink. Metal foil electrodes having even numbers in series 112₁, 112₂, 112₃, .... 112_{N} are arranged for coupling to a heat source. The first and the last in series metal foil electrodes are used for tapping a voltage, when the module 201 is used for current generation. The same electrodes are used for sending an electrical current, when the module 201 is used for heat transfer, e.g. cooling.

Figs. 32, 33, 34 depict other methods for manufacturing of thermoelectric elements 10 - 14 and 20. The method begins with making a hole 133 in the first metal foil 110 (Fig. 32). The hole can be made using the same technologies as used for the forming of the first gap 131. The first coating (e.g. 120 in Fig. 13) of the metal foil may be deposited before or after the forming the hole. In the latter case the coating is formed not only on a surface of the first metal foil, but the sidewalls of the hole are coated with the first coating as well. The first coating can be deposited via a shadow mask, which prevents deposition of the first coating on the areas distal from the hole. Such an approach may be beneficial when the first metal foil is used for manufacturing of thermoelectric elements comprising thermoelectric films of different types, i.e. different coatings specific for different conductivity types of thermoelectric layers are required on the first metal foil 110.

After forming the hole and, as option the first coating, the first thermoelectric film 101 is formed. The initial configuration of the first metal foil 110 with the hole 133 enables implementation of various configurations of the thermoelectric element depicted in Fig. 27.

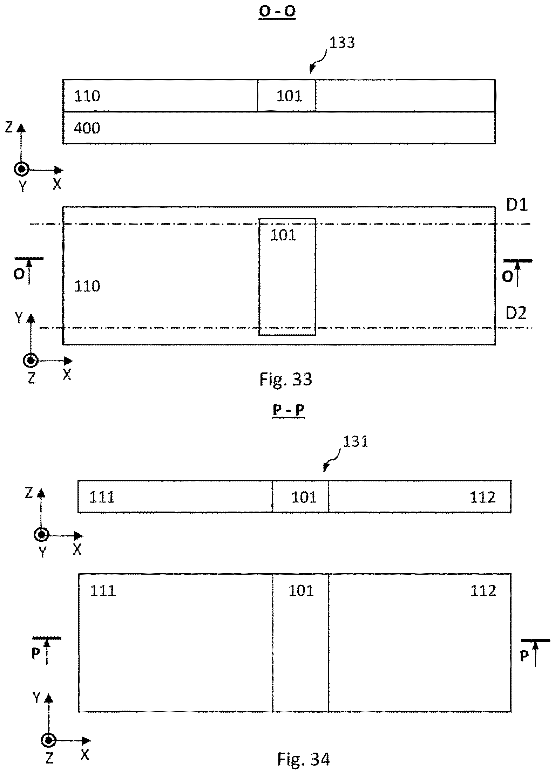

In one variant, the first thermoelectric film 101 is formed in the hole 133 (Fig. 33), preferably having its sidewalls coated by the first coating. The forming may be made using process c). To form a cavity for the forming (e.g. printing) of the first thermoelectric film 101, the first metal foil with the hole 133 can be clamped to a vacuum or electrostatic chuck 400 which acts as a provisional bottom for the cavity defined by a permitter of the hole. The chuck may have a polytetrafluoroethylene coating to hinder adhesion to it. Alternatively, the cavity for printing can be formed by laminating a dielectric film (e.g. resin or silicon rubber film) onto the first metal foil 110 to cover an opening of the hole on one of the sides of the metal. The element **G** in Fig. 27 may by such a laminated dielectric film. The formed thermoelectric film 101 may be comprised of the elements **A** and **B,** or of the elements **A, B,** and **E** (Fig. 27). In case when a dielectric film is printed into the hole prior to the forming of the first thermoelectric film 101, i.e. a dielectric film (e.g., element **B** in Fig. 27) is formed on the bottom of the cavity, the formed thermoelectric film 101 fills the hole 133 only partially, i.e. it may be comprised of the element **A** or of the elements **A** and **E.** In yet another variant the cavity may be completely filled with the dielectric film, in this case the first thermoelectric film is formed on a flat surface and may be a planar film. The first thermoelectric film 101 may also be comprised of elements **E, A, B,** and **G.** Such a configuration can be obtained when a first portion of the thermoelectric film comprised of elements **E, A,** and **B** is formed using the chuck as the provisional bottom for the cavity, and after the chuck removal the element **G** of the first thermoelectric film 101 is formed. The first thermoelectric film 101 can be formed by printing, e.g. process c). The dielectric film can be also formed by printing dielectric materials with low thermal conductivity and preferably thermally of UV curable or thermally curable materials, e.g. UV curable liquid silicon rubber or UV or thermal curable resins. Filling the hole 133 completely with a dielectric material may be implemented in yet another way. The first metal foil 110 with the laminated dielectric material covering the opening of the hole 133 is pressed by rolling or by applying a uniaxial pressure, e.g. using one of the tools depicted in Figs. 20 - 23, such that the material of the dielectric film is forced into the hole thereby building dielectric elements **A** and **B** therein (Fig. 27). This process may be performed at elevated temperature preferably below 100 degrees Celsius and/or with ultrasonic assistance.

After the forming of the first thermoelectric film portions of the first metal foil are removed, e.g. by cutting along lines D1 and D2 in Fig. 33, such that the first and the second metal foil electrodes 111 and 112 are formed. The formed metal foil electrodes 111 and 112 are separated by the first gap 131 which contours are determined by the shape of the hole 133. The potions of the first metal foil can be removed using the same technologies as used for the forming of the first gap 131.

The method may further comprise forming one or more additional dielectric films depicted as elements **I**, **E, A, B, G, K** in Fig. 27 on condition that the element is not implemented as the first thermoelectric film 101 or a portion thereof and the formed additional dielectric film does not build any voids. The method may further comprise forming one or more other additional dielectric films which cover naked surfaces (e.g., sidewalls) of the first thermoelectric film. The forming of the additional dielectric films is preferably performed before the removing of the portions of the first metal foil. It may provide extra mechanical reinforcement while the first metal foil is treated. Whereas the forming of the other additional dielectric films is preferably performed after removing the portions of the first metal foil, because this operation may result in new naked surfaces of the first thermoelectric film.

The method may further comprise forming another hole in a portion of the first metal foil 110. The portion of the first metal foil 110 is selected such that neither first thermoelectric film 101 nor any of the dielectric films will be formed on this portion. The other hole can be made using the same technologies as used for the forming of the first gap 131. The method may further comprise depositing another first coating (e.g., 120 in Fig. 13) on the portion of the first metal foil 110 or on the portion of the. The other first coating of the metal foil 110 may be deposited before or after the forming of the other hole. In the latter case the other first coating is formed not only on a surface of the first metal foil, but the sidewalls of the other hole are coated with the other first coating as well. The first coating can be deposited via a shadow mask, which prevents deposition of the other first coating on the areas distal from the other hole. The first coating and the other first coating may be deposited on the same side of the first metal foil 110 or on its opposite sides. The other first coating is optimized for the second thermoelectric film 102 having different conductivity type as the first thermoelectric film 101. The other first coating may be configured in the same way as the second coating 125.

Afterwards the second thermoelectric film 102 is formed using the other hole in the same way as the first thermoelectric film 101, wherein another first dielectric film is laminated to a side of the first metal foil 110 being opposite to a side on which the other first coating is deposited, or wherein the side of the first metal foil, being opposite to the side on which the other first metal coating is deposited, is clamped to the chuck.

The removing of the portions of the first metal foil comprises removing further portions of the first metal foil, such that a shared metal second foil electrode and the third metal foil electrode are formed (e.g., as depicted in Figs. 24 - 27). As a result, the first thermoelectric element has the first thermoelectric film 101, the first metal foil electrode 111 and the shared second metal foil electrode 112 and the second thermoelectric element has the shared second metal foil electrode 112 and the third metal foil electrode.

The method may further comprise forming one or more additional dielectric films depicted as elements **J, F, C, D, H, L** in Fig. 27 on condition that the element is not implemented as the second thermoelectric film 102 or a portion thereof and the formed additional dielectric film does not build any voids. The method may further comprise forming one or more other additional dielectric films which cover naked surfaces (e.g., sidewalls) of the second thermoelectric film. The forming of the one or more additional dielectric films is preferably performed before the removing of the portions of the first metal foil. The one or more additional dielectric films may provide extra mechanical reinforcement while the first metal foil is treated. Whereas the forming of the other additional dielectric films is preferably performed after removing the portions of the first metal foil, because this operation may result in new naked surfaces of the second thermoelectric film.

The steps of the methods described with reference to Figs. 32 - 34 can be used for manufacturing of the thermoelectric element 20 employing p-n or p-i-n junction. The first metal foil 110 with the hole completely filled with a dielectric film and the first thermoelectric formed thereon is manufactured as described above. The first thermoelectric film is a planar film. The first metal foil having its hole filled by the dielectric film has integral planar surfaces because surfaces of the dielectric film are coplanar with respective surfaces of the first metal foil. Afterwards the second thermoelectric film is formed on the first thermoelectric film, e.g. using process c), and a second metal foil with a hole filled with another dielectric film is laminated onto the formed second thermoelectric film, e.g. using process f). The second metal foil having its hole filled by the other dielectric film has integral planar surfaces because surfaces of the other dielectric film are coplanar with respective surfaces of the second metal foil. Alternatively, the second thermoelectric film can be formed on the second metal foil, e.g. using process c), and afterwards laminated to the first thermoelectric film, e.g. using process f). The first and the second metal foils may have coatings, e.g. coatings 120 and 125 depicted in Fig. 18. Afterwards portions of the first and the second metal foils are removed as described above to form the first, second, third, and fourth metal foil electrodes 111- 114, e.g. as depicted in Fig. 2. The gaps 131 and 132 between pairs of respective electrodes are determined by contours of respective holes. The relative alignment of the holes in the lamination process are determined according to the alignment of the first and the second gaps 131 and 132 in the thermoelectric element 20. Afterwards the dielectric films can be formed as described above, to passivate the first and the second thermoelectric films and/or to reinforce the thermoelectric element mechanically. The thermoelectric element 10 with four metal foil electrodes 111 - 114 can be manufactured in a similar way, wherein no second thermoelectric film is formed, i.e. the second metal foil with the hole filled with a dielectric film is laminated directly on the first thermoelectric film.

Although the present invention has been described with reference to preferred embodiments, workers skilled in the art will recognize that changes may be made in form and detail without departing from the scope of the invention.

**In summary, the invention may be described by the following clauses:**
Clause 1. A thermoelectric element (e.g., 10-14), comprising:
   a first metal foil electrode (e.g., 111) and a second metal foil electrode (e.g., 112) separated by a first gap (e.g., 131) constituted by facing each other first sidewalls of the first and second metal foil electrodes; and
   a first thermoelectric film (e.g., 101), wherein the first thermoelectric film has a first interface with a first side of the first metal foil electrode and a second interface with a first side of the second metal foil electrode and/or a third interface with the first sidewall of the first metal foil electrode and a fourth interface with the first sidewall of the second metal foil electrode, wherein the first and the second interfaces are planar interfaces disposed in a first flat plane.
Clause 2. The thermoelectric element of clause 1, wherein the thermoelectric element is a substrate-free and/or film-based thermoelectric element.
Clause 3. The thermoelectric element of clause 1 or 2, wherein the first gap has one of the following shapes: a rectangular slit (e.g., 131a), a meander-shaped slit (e.g., 131b), a sawtooth-shaped slit (e.g., 131c), or a wave-shaped slit (e.g., 131d).
Clause 4. The thermoelectric element of any one of clauses 1 through 3, wherein a distal portion of the first thermoelectric film in contact with a distal end portion of the first metal foil electrode at the first planar interface is at least 10 times thinner than a central portion of the first thermoelectric film bridging the first gap or the distal end portion of the first metal foil electrode is devoid of the first thermoelectric film; and/or
   wherein the first metal foil electrode has a coating (e.g., 113) in direct contact with the first thermoelectric film at the first and/or third interfaces and wherein the coating comprises at least one of the following layers: an adhesion layer, a diffusion barrier layer, a work function setting layer, or an interface layer for reduction of a thermal and/or an electrical resistance between a metal foil;
   wherein the second metal foil electrode has another coating (e.g., 114) in direct contact with the first thermoelectric film at the second and/or fourth interfaces and wherein the other coating comprises at least one of the following layers: an adhesion layer, a diffusion barrier layer, a work function setting layer, or an interface layer for reduction of a thermal and/or an electrical resistance between a metal foil electrode and a thermoelectric film; and/or
   wherein the coating and the other coating have the same structure and/or layer stacks; and/or
   electrode and a thermoelectric film; and/or
   wherein the first and/or the third interfaces are contamination-free interfaces.
Clause 5. The thermoelectric element of any one of cluses 1 through 4, comprising: a dielectric film having interfaces with the first and the second metal foil electrodes and the first thermoelectric film, wherein the dielectric film is arranged for mechanical reinforcement of the first thermoelectric element and/or passivation of the first thermoelectric film, wherein distal to the first gap (e.g., 131) end portions of the first and the second metal foil electrodes (111, 112) are preferably devoid of a material of the first thermoelectric film and a material of the dielectric film.
Clause 6. The thermoelectric element of any one of clauses 1 through 4, wherein the thermoelectric element consists of said first thermoelectric film, said first metal foil electrode, and said second metal foil electrode; and/or
   wherein the first metal foil electrode contacts the first thermoelectric film only at the first interface and the second metal foil electrode contacts the first thermoelectric film only at the second interface; and/or
   wherein the first thermoelectric film has a central portion bridging the first gap is planar or has a planar surface disposed in a second flat plane parallel to the first flat plane, wherein the first thermoelectric film has a second side comprising the planar surface, wherein the first and the second sides are opposite sides of the first thermoelectric film.
Clause 7. The thermoelectric element of any one of clauses 1 through 6, wherein the first metal foil electrode is arranged for thermal coupling to a heat sink and the second metal foil electrode is arranged for thermal coupling to a heat source; and/or wherein a voltage generated by the thermoelectric element, when the latter is in operation, is tapped from the first metal foil electrode and the second metal foil electrode.
Clause 8. The thermoelectric element (e.g., 11-14) of any one of clauses 1 through 5, comprising:
   a third metal foil electrode (e.g., 115), wherein the second and third metal foil electrodes are separated by a second gap (e.g., 132) constituted by a second sidewall of the second metal foil electrode and a first sidewall of the third metal foil electrode, wherein the second sidewall of the second metal foil electrode and the first side wall of the third metal foil electrode face each other; and
   a second thermoelectric film (e.g., 102), wherein the second thermoelectric film has a first interface with the first side or a second side of the second metal foil electrode and a second interface with a first side of the third metal foil electrode and/or a third interface with the second sidewall of the second metal foil electrode and a fourth interface with the first sidewall of the third metal foil electrode, wherein the first and the second interfaces of the second thermoelectric are planar interfaces disposed in a second flat plane, wherein the first and the second sides of the second metal foil electrode are its opposite sides,
   wherein the first and the third metal foil electrodes are arranged for thermal coupling to a heat sink, wherein the second metal foil electrode is arranged for thermal coupling to a heat source; and/or wherein a voltage generated by the thermoelectric element, when the latter is in operation, is tapped from the first metal foil electrode and the third metal foil electrode.
Clause 9. The thermoelectric element (e.g., 10) of any one of clauses 1 through 5, further comprising:
   a third metal foil electrode (e.g., 113) having a third interface with a second side of the first thermoelectric film; and
   a fourth metal foil electrode (e.g., 114) having a fourth interface with the second side of the first thermoelectric film,
   wherein the first and the second sides of the first thermoelectric film are its opposite sides, wherein the third and the fourth interfaces are planar interfaces disposed in a second flat plane being parallel to the first flat plane, wherein the third and the fourth metal foil electrodes are separated by a second gap (e.g., 132), wherein opposing sides of the second gap are constituted by facing each other sidewalls of the third and the fourth metal foil electrodes, wherein a first area of the first gap in the first flat plane and a second area of the second gap in the second flat plane comply with one of the following criteria: a projection of the first area in the second flat pane coincides with the second area or at least 80% of the projection is inside the second area, wherein the first and/or the third metal foil electrodes are arranged for thermal coupling to a heat sink, wherein the second and/or the fourth metal foil electrode are arranged for thermal coupling to a heat source, wherein a voltage generated by the substrate-free film-based thermoelectric element, when the latter is in operation, is tapped from at least one of the first and the third metal foil electrodes and at least one of the second and the fourth metal foil electrodes.
Clause 10. The thermoelectric element (e.g., 20) of any one of clauses 1 through 5, comprising:
   a third metal foil electrode (e.g., 113) and a fourth metal foil electrode (e.g., 114) separated by a second gap (e.g., 132) constituted by facing each other first sidewalls of the third and fourth metal foil electrodes; and
   a second thermoelectric film (e.g., 102), wherein the second thermoelectric film has a first interface with a first side of the third metal foil electrode and a second interface with a first side of the fourth metal foil electrode, wherein the first and the second interfaces are planar interfaces disposed in the same second flat plane, wherein the first and the second thermoelectric films have different conductivity types and constitute a p-n junction, wherein a planar interface of the p-n junction is disposed in a third plane between the first and the second planes, wherein a first area of the first gap in the first flat plane and a second area of the second gap in the second flat plane comply with one of the following criteria: a projection of the first area in the second flat pane coincides with the second area or at least 80% of the projection is inside the second area, wherein the first and/or the third metal foil electrodes are arranged for thermal coupling to a heat sink, wherein the second and/or the fourth metal foil electrode are arranged for thermal coupling to a heat source, wherein a voltage generated by the thermoelectric element, when the latter is in operation, is tapped from the first and the third metal foil electrodes.
Clause 11. The thermoelectric element of clause 10, wherein the first and the third metal foil electrodes face each other and a portion of the first thermoelectric film and a portion of the second thermoelectric film are between the first and the third metal foil electrodes, wherein the second and the fourth metal foil electrodes face each other and another portion of the first thermoelectric film and another portion of the second thermoelectric film are between the second and the fourth metal foil electrodes.
Clause 12. The thermoelectric element of the clause 10 or 11,
   wherein the first thermoelectric film has a central portion bridging the first gap and the second thermoelectric film has a central bridging the second gap, wherein the p-n junction is constituted by the central portions; and/or
   wherein the planar interface (e.g., 105) of the p-n junction is a contamination-free interface; and/or
   wherein the first thermoelectric film comprises a first bulk layer and a first junction interface layer (e.g., 103), wherein one side of the first junction interface layer is in direct contact with the second thermoelectric film and its opposite side is in direct contact with the first bulk layer, wherein a material of the first junction interface layer has lower charge carrier concentration than a material of the first bulk layer; and/or
   wherein the second thermoelectric film comprises a second bulk layer and a second junction interface layer (e.g., 104), wherein one side of the second junction interface layer is in direct contact with the first thermoelectric film and its opposite side is in direct contact with the second bulk layer, wherein a material of the second junction interface layer has lower charge carrier concentration than a material of the second bulk layer.
Clause 13. The thermoelectric element of any one of the clauses 10 through 12, wherein a material of the first thermoelectric film has a lower thermal and/or electrical conductivity than a material of the second thermoelectric film and a first portion of the first thermoelectric film bridging the first gap is thicker than a second portion of the second thermoelectric film bridging the second gap.
Clause 14. A thermoelectric module (e.g., 190, 201), comprising thermoelectric elements (e.g., 11-14) of clause 8 electrically connected in series such that an alternating series of the first thermoelectric films and the second thermoelectric films is formed.
Clause 15. A thermoelectric module (e.g., 200, 202), comprising thermoelectric elements (e.g., 20) of any one of clauses 10 through 13, wherein the first metal foil electrodes (e.g., 111) and the third metal foil electrodes (e.g., 113) are electrically connected in series such that an alternating series of the first and the second thermoelectric films is formed.
Clause 16. The thermoelectric module of clause 14 or 15, wherein the first and the third metal foil electrodes (e.g., 111, 115; 111, 113) of thermoelectric elements being adjacent in the series are made of a single piece of a metal foil.
Clause 17. A method for manufacturing a thermoelectric element (e.g., 10-14, 20), the method comprising:
   forming a first thermoelectric film (e.g., 101) on a first metal foil (e.g., 110), wherein the first metal foil has a planar interface with a first side of the first thermoelectric film; and
   forming a first gap (e.g., 131) in the first metal foil to form a first metal foil electrode (e.g., 111) and a second metal foil electrode (e.g., 112).
Clause 18. The method of clause 17, the method comprising:
   forming a second thermoelectric film (e.g., 102) on the first metal foil, wherein the second thermoelectric film has an interface with the first side or a second side of the first metal foil, wherein the first and the second thermoelectric films have different conductivity types, wherein the first and the second sides of the first metal foil are its opposite sides; and
   forming a second gap (e.g., 132) in the first metal foil to form the second metal foil electrode (e.g., 112) and a third metal foil electrode (115) such that the second and the third metal foil electrodes have an electrical connection only via the second thermoelectric film.
Clause 19. The method of clause 17, further comprising:
   forming a second thermoelectric film (e.g., 102) on a second metal foil (e.g., 115), wherein a second side of the second thermoelectric film has a planar interface with a first side of the second metal foil;
   laminating the first thermoelectric film to the second thermoelectric film using at least one of the following processes: hot pressing, hot pressing with ultrasonic assistance, roll-pressing, or roll-pressing with ultrasonic assistance and/or elevated temperature, wherein the first and the second thermoelectric films have different conductivity types and constitute a p-n junction, wherein a second side of the first thermoelectric film is in direct contact with a first side of the second thermoelectric film, wherein the first and the second sides of the first thermoelectric film are its opposite sides, wherein the first and the second sides of the second thermoelectric film are its opposite sides; and
   forming a second gap (e.g., 132) in the second metal foil to form a third metal foil electrode (e.g., 113) and a fourth metal foil electrode (e.g., 114).
Clause 20. The method of clause 19, wherein the first and the second gaps are formed such that the third and the fourth metal foil electrodes have an electrical connection only via the second thermoelectric film and both the first and the second thermoelectric films, wherein the first and the second gaps are formed after the laminating of the first thermoelectric film to the second thermoelectric film.
Clause 21. A method for manufacturing of a thermoelectric element (e.g., 10-14), the method comprising:
   forming a hole (133) in a metal foil (133);
   forming a first thermoelectric film (101) in the hole;
   removing portions of the metal foil to form a first metal foil electrode (111) and a second metal foil electrode (112) such that the first and second metal foil electrodes are electrically connected only via the first thermoelectric film.
Clause 22. The method of clause 20, further comprising:
   forming another hole in the metal foil;
   forming a second thermoelectric film (e.g., 102) in the other hole;
   removing portions of the metal foil to form the second metal foil electrode and a third metal foil electrode (e.g., 115) such that the second and third metal foil electrodes are electrically connected only via the second thermoelectric film.
Clause 23. The method of clause 21 or 22, further comprising:
   clamping the metal foil to a chuck (e.g., 400) such that an opening of the hole on one of the opposite sides of the metal foil is fully covered by the chuck,
   wherein the first thermoelectric film is formed in a cavity formed by the chuck and sidewalls of the hole.
Clause 24. The method of clause 21 or 22, further comprising:
   laminating a dielectric film to the metal foil such that it completely covers an opening of the hole on one of the opposite sides of the metal foil,
   wherein the first thermoelectric film is formed in a cavity formed by the dielectric film and sidewalls of the hole.
Clause 25. The method of any one of clauses 17 through 24, wherein the first thermoelectric film is formed in direct contact with a first coating (e.g., 120) of the first metal foil, wherein the first coating comprises one or more of the following layers: an adhesion layer, a diffusion barrier layer, a work function setting layer, or an interface layer for reduction of a thermal and/or an electrical resistance between a metal foil electrode and a thermoelectric film.
Clause 26. The method of clause 25, wherein the first thermoelectric film is formed in direct contact with the adhesion layer of the first coating, wherein a material of the adhesion layer and a material of the first thermoelectric film comprise at least one common chemical element and an atomic concentration of this common element in a material of the adhesion layer differs from an atomic concentration of this common element in the material of the first thermoelectric material less than 10%.
Clause 27. The method of clause 25 or 26, further comprising:
   depositing the top layer of the first coating, wherein an inert gas atmosphere and/or vacuum are maintained between the end of the depositing of the top layer of the first coating and the beginning of the first thermoelectric film.
Clause 28. The method of any one of clauses 25 or 26, wherein layers of the first coating are deposited in an inert gas atmosphere or vacuum which are maintained until the forming of the first thermoelectric film is started.
Clause 29. The method of clause 23 or 24, wherein the forming of the first thermoelectric film comprises pressure-compacting of a first powder of a first thermoelectric material in the cavity, preferably in an inert gas atmosphere or vacuum.
Clause 30. The method of any one of clauses 17 through 20, wherein the forming of the first thermoelectric film comprises pressure pressure-compacting of a first powder of a first thermoelectric material on the first metal foil, preferably in an inert gas atmosphere or vacuum.
Clause 31. The method of clause 29 or 30, wherein the pressure-compacting is performed by at least one of the following processes: hot pressing, hot pressing with ultrasonic assistance, roll-compacting, high-speed centrifugal compaction process, or roll-compacting with ultrasonic assistance and/or at elevated temperature.
Clause 32. The method of any one of clauses 29 through 31, further comprising: deoxidizing and/or degassing of the first powder before its pressure-compacting.
Clause 33. The method of any one of clauses 29 through 32, wherein the first powder layer (e.g., 101a) of the first powder is provided in dry from for its pressure-compacting.
Clause 34. The method of any one of clauses 29 though 32, further comprising:
   printing an ink layer (101a) of an ink containing the first powder on the first metal foil, when depending on clause 17, or in the cavity, when depending on clause 23 or 24; and
   annealing the first metal foil with the printed ink layer to remove a solvent and/or a binder from the printed ink layer before the pressure-compacting of the first powder.
Clause 35. The method of any of the clauses 17 through 27, wherein the forming of the first thermoelectric film comprises printing at least a portion of the first thermoelectric film.
Clause 36. A method for manufacturing of a thermoelectric module (e.g., 190) comprising first thermoelectric elements (e.g., 10) of any one of clauses 1 through 7 and second thermoelectric elements (e.g., 10) of any one of clauses 1 through 7, wherein the first thermoelectric elements have first thermoelectric films of p-type conductivity and the second thermoelectric elements have first thermoelectric films of n-type conductivity, the method comprising electrically connecting the first metal foil electrodes (e.g., 111) and the second metal foil electrodes (e.g., 112) such that an alternating series of the first thermoelectric films having n-type conductivity and the first thermoelectric films having p-type conductivity is formed.
Clause 37. A method of manufacturing of a thermoelectric module (e.g., 200) comprising thermoelectric elements (e.g.,20) of any one of clauses 10 through 13, the method comprising electrically connecting the first metal foil electrodes (e.g., 111) and the third metal foil electrodes (e.g., 113) such that an alternating series of the first and the second thermoelectric films is formed.
Clause 38. A substrate-free film-based thermoelectric element (e.g., 10), comprising:
   a first thermoelectric film (e.g., 101);
   a first metal foil electrode (e.g., 111) having a first planar interface with a first side of the thermoelectric film; and
   a second metal foil electrode (e.g., 112) having a second planar interface with the first side of the first thermoelectric film, wherein the first and the second planar interfaces are disposed in the same first flat plane.
Clause 39. The substrate-free film-based thermoelectric element of clause 38, wherein the first and the second metal foil electrodes are separated by a first gap (e.g., 131) having one of the following shapes: a rectangular slit, a meander-shaped slit, a sawtooth-shaped slit, or a wave-shaped slit, wherein opposing sides of the first gap are constituted by facing each other sidewalls of the first and the second metal foil electrodes.
Clause 40. The substrate-free film-based thermoelectric element of clause 38, wherein the first and the second metal foil electrodes are separated by a first gap (e.g., 131) and wherein a distal portion of the first thermoelectric film in contact with a distal end portion of the first metal foil electrode at the first planar interface is at least 10 times thinner than a central portion of the first thermoelectric film bridging the first gap or the distal end portion of the first metal foil electrode is devoid of the first thermoelectric film; and/or
   wherein the first metal foil electrode has a coating (e.g., 113) in direct contact with the first thermoelectric film at the first planar interface and wherein the coating comprises at least one of the following layers: an adhesion layer, a diffusion barrier layer, a work function setting layer, or an interface layer for reduction of a thermal and/or an electrical resistance between a metal foil electrode and a thermoelectric film; and/or
   wherein the first and the second planar interfaces are contamination-free interfaces.
Clause 41. The substrate-free film-based thermoelectric element (e.g., 10) of clause 38, wherein substrate-free film-based thermoelectric element consists of said first thermoelectric film (e.g., 101), said first metal foil electrode (e.g., 111), and said second metal foil electrode (e.g., 112); and/or
   wherein the first metal foil electrode contacts the first thermoelectric film only at the first planar interface and the second metal foil electrode contacts the first thermoelectric film only at the second planar interface; and/or
   wherein the first thermoelectric film has a central portion bridging a first gap (e.g., 131) separating the first and the second metal foil electrodes and the central portion is planar or has a planar surface disposed in a second flat plane parallel to the first plane, wherein the first thermoelectric film has a second side comprising the planar surface, wherein the first and the second sides are opposite sides of the first thermoelectric film.
Clause 42. The substrate-free film-based thermoelectric element of any one of the preceding clauses, wherein the first metal foil electrode is arranged for thermal coupling to a heat sink, wherein the second metal foil electrode is arranged for thermal coupling to a heat source; and/or wherein a voltage generated by the substrate-free film-based thermoelectric element, when the latter is in operation, is tapped from the first metal foil electrode and the second metal foil electrode.
Clause 43. The substrate-free film based thermoelectric element (e.g., 10) of clause 39 or clauses 39 and 40, further comprising:
   a third metal foil electrode (e.g., 113) having a third planar interface with a second side of the first thermoelectric film; and
   a fourth metal foil electrode (e.g., 114) having a fourth planar interface with the second side of the first thermoelectric film,
   wherein the first and the second sides of the first thermoelectric film are its opposite sides, wherein the third and the fourth planar interfaces are disposed in the same second flat plane being parallel to the first flat plane, wherein the third and the fourth metal foil electrodes are separated by a second gap (e.g., 132), wherein opposing sides of the second gap are constituted by facing each other sidewalls of the third and the fourth metal foil electrodes, wherein a first area of the first gap in the first flat plane and a second area of the second gap in the second flat plane comply with one of the following criteria: a projection of the first area in the second flat pane coincides with the second area or at least 80% of the projection is inside the second area, wherein the first and/or the third metal foil electrodes are arranged for thermal coupling to a heat sink, wherein the second and/or the fourth metal foil electrode are arranged for thermal coupling to a heat source, wherein a voltage generated by the substrate-free film-based thermoelectric element, when the latter is in operation, is tapped from at least one of the first and the third metal foil electrodes and at least one of the second and the fourth metal foil electrodes.
Clause 44. The substrate-free film-based thermoelectric element (e.g., 20) of any one of clauses 38 through 40, comprising:
   a second thermoelectric film (e.g., 102), the first and the second thermoelectric films having different conductivity types and constituting a p-n junction, a planar interface of the p-n junction being constituted by a at least a portion of a second side of the first thermoelectric film and at least a portion of a first side of the second thermoelectric film, the first and the second sides of the first thermoelectric film being its opposite sides;
   a third metal foil (e.g., 113) electrode having a third planar interface with a second side of the second thermoelectric film, the first and the second sides of the second thermoelectric film being its opposite sides; and
   a fourth metal foil (e.g., 114) electrode having a fourth planar interface with the second side of the second thermoelectric film, the third and the fourth planar interfaces being disposed in the same second flat plane, the planar interface of the p-n junction being parallel to and disposed between the first and the second flat planes.
Clause 45. The substrate-free film-based thermoelectric element of clauses 39 and 44, wherein the third and the fourth metal foil electrodes are separated by a second gap (e.g., 132), wherein opposing sides of the second gap are constituted by facing each other sidewalls of the third and the fourth metal foil electrodes, wherein a first area of the first gap in the first flat plane and a second area of the second gap in the second flat plane comply with one of the following criteria: a projection of the first area in the second flat plane coincides with the second area or at least 80% of the projection is inside the second area.
Clause 46. The substrate-free film-based thermoelectric element of clause 44 or 45, wherein the first and the third metal foil electrodes face each other and a portion of the first thermoelectric film and a portion of the second thermoelectric film are between the first and the third metal foil electrodes, wherein the second and the fourth metal foil electrodes face each other and another portion of the first thermoelectric film and another portion of the second thermoelectric film are between the second and the fourth metal foil electrodes, wherein the second metal foil electrode and the fourth metal foil electrode are arranged for thermal coupling to a heat source, wherein the first metal foil electrode and the third metal foil electrode are arranged for thermal coupling to a heat sink, wherein a voltage generated by the substrate-free film-based thermoelectric element, when the latter is in operation, is tapped from the first metal foil electrode and the third metal foil electrode.
Clause 47. The substrate-free film-based thermoelectric element of any one of clams 44 through 46,
   wherein the first thermoelectric film has a central portion bridging the first gap and the second thermoelectric film has a central bridging the second gap, wherein the p-n junction is constituted by the central portions; and/or
   wherein the planar interface (e.g., 105) of the p-n junction is a contamination-free interface; and/or
   wherein the first thermoelectric film comprises a first bulk layer and a first junction interface layer (e.g., 103), wherein one side of the first junction interface layer is in direct contact with the second thermoelectric film and its opposite side is in direct contact with the first bulk layer, wherein a material of the first junction interface layer has lower charge carrier concentration than a material of the first bulk layer; and/or
   wherein the second thermoelectric film comprises a second bulk layer and a second junction interface layer (e.g., 104), wherein one side of the second junction interface layer is in direct contact with the first thermoelectric film and its opposite side is in direct contact with the second bulk layer, wherein a material of the second junction interface layer has lower charge carrier concentration than a material of the second bulk layer.
Clause 48. The substrate-free film-based thermoelectric element of any one of clams 44 through 46 with reference to clause 8, wherein a material of the first thermoelectric film has a lower thermal and/or electrical conductivity than a material of the second thermoelectric film and a first portion of the first thermoelectric film bridging the first gap is thicker than a second portion of the second thermoelectric film bridging the second gap.
Clause 49. A thermoelectric module (e.g., 190), comprising first and second thermoelectric elements, wherein the first thermoelectric elements are the thermoelectric elements (e.g., 10) of any one of clauses 38 through 42 comprising the first thermoelectric films (e.g., 101) having p-type conductivity, wherein the second thermoelectric elements are the thermoelectric elements (e.g., 10) of any one of clauses 38 through 42 comprising the first thermoelectric films (e.g., 101) having n-type conductivity, wherein the first and the second metal foil electrodes (e.g., 111, 112) of the first and the second thermoelectric elements are electrically connected in series such that an alternating series of the first thermoelectric films (e.g., 101) having n-type conductivity and the first thermoelectric films (e.g., 101) having p-type conductivity is formed.
Clause 50. A thermoelectric module (e.g., 200), comprising thermoelectric elements (e.g., 20) of any one of clauses 44 through 48, wherein the first metal foil electrodes (e.g., 111) and the third metal foil electrodes (e.g., 113) are electrically connected in series such that an alternating series of the first and the second thermoelectric films is formed.
Clause 51. A method for manufacturing a substrate-free film-based thermoelectric element (e.g., 10), the method comprising:
   forming a first thermoelectric film (e.g., 101) on a first metal foil (e.g., 110), wherein the first metal foil has a planar interface with a first side of the first thermoelectric film; and
   forming a first gap (e.g., 131) in the first metal foil to form a first metal foil electrode (e.g., 111) and a second metal foil electrode (e.g., 112).
Clause 52. The method of clause 51, wherein the forming of the first thermoelectric film comprises pressure-compacting a first powder of a first thermoelectric material on the first metal foil (e.g., 110) to form a first bulk layer attached to the first metal foil, wherein the first thermoelectric film comprises the first bulk layer.
Clause 53. The method of clause 51, wherein the pressure-compacting is performed by at least one of the following processes: hot pressing, hot pressing with ultrasonic assistance, roll-compacting, high-speed centrifugal compaction process, or roll-compacting with ultrasonic assistance and/or at elevated temperature.
Clause 54. The method of clause 51 or 53, further comprising:
   deoxidizing and/or degassing of the first powder before its pressure-compacting, wherein the deoxidized and/or degassed first powder is pressure-compacted on the first metal foil in vacuum and/or inert gas atmosphere.
Clause 55. The method of any one of clauses 51 through 54, wherein the first thermoelectric film is formed on a first coating (e.g., 120) of the first metal foil, wherein the first coating comprises one or more of the following layers: an adhesion layer, a diffusion barrier layer, a work function setting layer, or an interface layer for reduction of a thermal and/or an electrical resistance between a metal foil electrode and a thermoelectric film.
Clause 56. The method of clause 55, wherein the first thermoelectric film or its first bulk layer is formed in direct contact with the adhesion layer of the first coating, wherein a material of the adhesion layer and the first thermoelectric material comprise at least one common chemical element and an atomic concentration of this common element in a material of the adhesion layer differs from an atomic concentration of this common element in the first thermoelectric material less than 10%.
Clause 57. The method of clause 55 or 56, further comprising:
   depositing the top layer of the first coating, wherein the forming of the first thermoelectric film comprises depositing a first contact interface layer (e.g., 106) of the first thermoelectric film on the top layer of the first coating, wherein the first contact interface layer is deposited after the deposition of the top layer of the first coating without breaking vacuum and/or inert gas atmosphere between these deposition processes.
Clause 58. The method of any one of clauses 55 through 57 with reference to clause 53, further comprising:
   depositing the bottom layer of the first coating on the first metal foil in vacuum and/or inert gas atmosphere which is/are maintained until the pressure-compacting of the first powder on the first metal foil is started.
Clause 59. The method of any one of clauses 51 through 58 with reference to clause 53, further comprising:
   providing a first powder layer (e.g., 101a) of the first powder on the first metal foil in dry from for its pressure-compacting.
Clause 60. The method of any one of clauses 51 through 57 with reference to clause 53, further comprising:
   printing an ink layer (e.g., 101a) of an ink containing the first powder on the first metal foil; and
   annealing the first metal foil with the printed ink layer to remove a solvent and/or a binder from the printed ink layer before the pressure-compacting of the first powder.
Clause 61. The method of any one of clauses 51 through 60 with reference to clause 53, wherein the first powder sandwiched between the first metal foil (e.g., 110) and a second metal foil (e.g., 115) is pressure-compacted in the pressure-compacting of the first powder of the first thermoelectric material on the first metal foil, wherein a second side of the first thermoelectric film has a planar interface with the second metal foil and the first bulk layer is attached to the second metal foil, wherein the first and the second sides are the opposite sides of the first thermoelectric film, wherein the method further comprises:
   forming a second gap (e.g., 132) in the second metal foil to form a third metal foil electrode (e.g., 113) and a fourth metal foil electrode (e.g., 114).
Clause 62. The method of any one of clauses 51 through 60, further comprising:
   providing a second powder of a second thermoelectric material sandwiched between the first thermoelectric film and a second metal foil (e.g., 115);
   forming a second thermoelectric (e.g., 102) film, the first and the second thermoelectric films having different conductivity types and constituting a p-n junction, a planar interface of the p-n junction being formed by a second side of the first thermoelectric film and a first side of the second thermoelectric film, the first and the second sides of the first thermoelectric film being its opposite sides, wherein the forming of the second thermoelectric film comprises pressure-compacting the second powder sandwiched between the first thermoelectric film and the second metal foil to form a second bulk layer having one side attached to the first thermoelectric film and an opposite side attached to the second metal foil, wherein the second thermoelectric film comprises the second bulk layer, wherein the second thermoelectric film and the second metal foil have a planar interface at a second side of the second thermoelectric film, the first and the second sides of the second thermoelectric film being its opposite sides; and
   forming a second gap (e.g., 132) in the second metal foil to form a third metal foil electrode (e.g., 113) and a fourth metal foil electrode (e.g., 114), wherein the first and the second gaps are formed after the pressure-compacting of the second powder.
Clause 63. The method of clauses 52 and 62, wherein the forming of the first thermoelectric film comprises depositing a first junction interface layer (e.g., 103) of the first thermoelectric film on the first bulk layer and the forming of the second thermoelectric film comprises depositing a second junction interface layer (e.g., 104) of the second thermoelectric film directly on the first junction interface layer, wherein the second powder is provided on the second junction interface layer, wherein the second junction interface layer is deposited after the deposition of the first junction interface layer without breaking vacuum and/or inert gas atmosphere between these deposition processes, wherein the second bulk layer is directly attached to the second junction interface layer.
Clause 64. The method of any one of clauses 51 through 60, further comprising:
   forming a second thermoelectric film (e.g., 102) on a second metal foil (e.g., 115), wherein a second side of the second thermoelectric film is in direct contact with and attached to the second metal foil;
   laminating the first thermoelectric film to the second thermoelectric film using at least one of the following processes: hot pressing, hot pressing with ultrasonic assistance, roll-pressing, or roll-pressing with ultrasonic assistance and/or elevated temperature, wherein the first and the second thermoelectric films have different conductivity types and constitute a p-n junction, wherein a second side of the first thermoelectric film is in direct contact with a first side of the second thermoelectric film; and
   forming a second gap (e.g., 132) in the second metal foil to form a third metal foil electrode (e.g., 113) and a fourth metal foil electrode (e.g., 114), wherein the first and the second gaps are formed after the laminating of the first thermoelectric film to the second thermoelectric film.
Clause 65. A method for manufacturing a substrate-free film-based thermoelectric element, comprising:
   providing a first powder layer (e.g., 101a) of a first powder of a first thermoelectric material on a first metal foil (e.g., 110);
   providing a second powder layer of a second powder of a second thermoelectric material on the first powder layer, wherein the first and the second thermoelectric materials have different conductivity types;
   providing a second metal foil (e.g., 115) on the second powder layer;
   forming a p-n junction by pressure-compacting of the first and the second powders of the first and the second powder layers sandwiched between the first and the second metal foils, wherein a first side of a first thermoelectric film (e.g., 101) comprising a first bulk layer of the pressure-compacted first powder is directly attached to the first metal foil and a second side of the first thermoelectric film is directly attached to a first side of a second thermoelectric film (e.g., 102) comprising a second bulk layer of the pressure-compacted second powder, wherein a second side of the second thermoelectric film is directly attached to the second metal foil; and
   after the pressure-compacting of the first and the second powders:
      forming a first gap (e.g., 131) in the first metal foil to form a first metal foil electrode (e.g., 111) and a second metal foil electrode (e.g., 112); and
      forming a second gap (e.g., 132) in the second metal foil to form a third metal foil electrode (e.g., 113) and a fourth metal foil electrode (e.g., 114).
Clause 66. A method for manufacturing of a thermoelectric module (e.g., 190) comprising first thermoelectric elements (e.g., 10) of any one of clauses 38 through 42 and second thermoelectric elements (e.g., 10) of any one of clauses 1 through 5, wherein the first thermoelectric elements have first thermoelectric films of p-type conductivity and the second thermoelectric elements have first thermoelectric films of n-type conductivity, the method comprising electrically connecting the first metal foil electrodes (e.g., 111) and the second metal foil electrodes (e.g., 112) such that an alternating series of the first thermoelectric films having n-type conductivity and the first thermoelectric films having p-type conductivity is formed.
Clause 67. A method of manufacturing of a thermoelectric module (e.g., 200) comprising thermoelectric elements (e.g., 20) of any one of clauses 44 through 48, the method comprising electrically connecting the first metal foil electrodes (e.g., 111) and the third metal foil electrodes (e.g., 113) such that an alternating series of the first and the second thermoelectric films is formed.

## Claims

1. A thermoelectric element (10-14), comprising:
a first metal foil electrode (111) and a second metal foil electrode (112) separated by a first gap (131) constituted by facing each other first sidewalls of the first and second metal foil electrodes; and
a first thermoelectric film (101), wherein the first thermoelectric film has a first interface with a first side of the first metal foil electrode and a second interface with a first side of the second metal foil electrode and/or a third interface with the first sidewall of the first metal foil electrode and a fourth interface with the first sidewall of the second metal foil electrode, wherein the first and the second interfaces are planar interfaces disposed in a first flat plane.

2. The thermoelectric element of claim 1, wherein the thermoelectric element is a substrate-free and/or film-based thermoelectric element; and/or
wherein the first gap has one of the following shapes: a rectangular slit (131a), a meander-shaped slit (131b), a sawtooth-shaped slit (131c), or a wave-shaped slit (131d).

3. The thermoelectric element of claim 1 or 2, comprising: a dielectric film having interfaces with the first and the second metal foil electrodes and the first thermoelectric film, wherein the dielectric film is arranged for mechanical reinforcement of the first thermoelectric element and/or passivation of the first thermoelectric film, wherein distal to the first gap (131) end portions of the first and the second metal foil electrodes (111, 112) are devoid of a material of the first thermoelectric film and a material of the dielectric film.

4. The thermoelectric element of any one of the preceding claims, wherein the first metal foil electrode has a coating (121) in direct contact with the first thermoelectric film at the first and/or third interfaces and wherein the coating comprises at least one of the following layers: an adhesion layer, a diffusion barrier layer, a work function setting layer, or an interface layer for reduction of a thermal and/or an electrical resistance between a metal foil electrode and a thermoelectric film; and/or
wherein the first and/or the third interfaces are contamination-free interfaces.

5. The thermoelectric element of any one of the preceding claims, wherein the first metal foil electrode is arranged for thermal coupling to a heat sink and the second metal foil electrode is arranged for thermal coupling to a heat source; and/or wherein a voltage generated by the thermoelectric element, when the latter is in operation, is tapped from the first metal foil electrode and the second metal foil electrode.

6. The thermoelectric element (11-14) of any one of claims 1 through 4, comprising:
a third metal foil electrode (115), wherein the second and third metal foil electrodes are separated by a second gap (132) constituted by a second sidewall of the second metal foil electrode and a first sidewall of the third metal foil electrode, wherein the second sidewall of the second metal foil electrode and the first side wall of the third metal foil electrode face each other; and
a second thermoelectric film (102), wherein the second thermoelectric film has a first interface with the first side or a second side of the second metal foil electrode and a second interface with a first side of the third metal foil electrode and/or a third interface with the second sidewall of the second metal foil electrode and a fourth interface with the first sidewall of the third metal foil electrode, wherein the first and the second interfaces of the second thermoelectric are planar interfaces disposed in the same second flat plane, wherein the first and the second sides of the second metal foil electrode are its opposite sides,
wherein the first and the third metal foil electrodes are arranged for thermal coupling to a heat sink, wherein the second metal foil electrode is arranged for thermal coupling to a heat source; and/or wherein a voltage generated by the thermoelectric element, when the latter is in operation, is tapped from the first metal foil electrode and the third metal foil electrode.

7. The thermoelectric element (20) of any one of claims 1 through 4, comprising:
a third metal foil electrode (113) and a fourth metal foil electrode (114) separated by a second gap (132) constituted by facing each other first sidewalls of the third and fourth metal foil electrodes; and
a second thermoelectric film (102), wherein the second thermoelectric film has a first interface with a first side of the third metal foil electrode and a second interface with a first side of the fourth metal foil electrode, wherein the first and the second interfaces of the second thermoelectric film are planar interfaces disposed in a second flat plane, wherein the first and the second thermoelectric films have different conductivity types and constitute a p-n junction, wherein a planar interface of the p-n junction is disposed in a third flat plane between the first and the second flat planes, wherein a first area of the first gap in the first flat plane and a second area of the second gap in the second flat plane comply with one of the following criteria: a projection of the first area in the second flat pane coincides with the second area or at least 80% of the projection is inside the second area, wherein the first and/or the third metal foil electrodes are arranged for thermal coupling to a heat sink, wherein the second and/or the fourth metal foil electrode are arranged for thermal coupling to a heat source, wherein a voltage generated by the thermoelectric element, when the latter is in operation, is tapped from the first and the third metal foil electrodes.

8. A thermoelectric module (190, 201), comprising thermoelectric elements (11-14) of claim 7 electrically connected in series such that an alternating series of the first thermoelectric films and the second thermoelectric films is formed.

9. A thermoelectric module (200, 202), comprising thermoelectric elements (20) of claim 8, wherein the first metal foil electrodes (111) and the third metal foil electrodes (113) are electrically connected in series such that an alternating series of the first and the second thermoelectric films is formed.

10. The thermoelectric module of claim 8 or 9, wherein the first and the third metal foil electrodes (111, 115; 111, 113) of thermoelectric elements being adjacent in the series are made of a single piece of a metal foil.

11. A method for manufacturing of a thermoelectric element (10-14, 20), the method comprising:
forming a first thermoelectric film (101) on a first metal foil (110), wherein the first thermoelectric film has a planar interface with a first side of the first metal foil; and
forming a first gap (131) in the first metal foil to form a first metal foil electrode (111) and a second metal foil electrode (112) such that the first and the second metal foil electrodes have an electrical connection only via the first thermoelectric film.

12. The method of claim 11, the method comprising:
forming a second thermoelectric film (102) on the first metal foil (110), wherein the second thermoelectric film has an interface with the first side or a second side of the first metal foil, wherein the first and the second thermoelectric films have different conductivity types, wherein the first and the second sides of the first metal foil are its opposite sides; and
forming a second gap (132) in the first metal foil to form the second metal foil electrode (112) and a third metal foil electrode (115) such that the second and the third metal foil electrodes have an electrical connection only via the second thermoelectric film.

13. The method of claim 11, further comprising:
forming a second thermoelectric film (102) on a second metal foil (115), wherein a second side of the second thermoelectric film has a planar interface with a first side of the second metal foil;
laminating the first thermoelectric film to the second thermoelectric film using at least one of the following processes: hot pressing, hot pressing with ultrasonic assistance, roll-pressing, or roll-pressing with ultrasonic assistance and/or elevated temperature, wherein the first and the second thermoelectric films have different conductivity types and constitute a p-n junction, wherein a second side of the first thermoelectric film is in direct contact with a first side of the second thermoelectric film, wherein the first and the second sides of the first thermoelectric film are its opposite sides, wherein the first and the second sides of the second thermoelectric film are its opposite sides; and
forming a second gap (132) in the second metal foil to form a third metal foil electrode (113) and a fourth metal foil electrode (114) such that the third and the fourth metal foil electrodes have an electrical connection only via the second thermoelectric film and both the first and the second thermoelectric films, wherein the first and the second gaps are formed after the laminating of the first thermoelectric film to the second thermoelectric film.

14. A method for manufacturing of a thermoelectric element (11-14), the method comprising:
forming a hole (133) in a metal foil (133);
forming a first thermoelectric film (101) in the hole;
removing portions of the metal foil to form a first metal foil electrode (111) and a second metal foil electrode (112) such that the first and second metal foil electrodes are electrically connected only via the first thermoelectric film.

15. The method of claim 14, further comprising:
laminating a dielectric film to the metal foil such that it completely covers an opening of the hole on one of the opposite sides of the metal foil,
wherein the first thermoelectric film is formed in a cavity formed by the dielectric film and sidewalls of the hole.
